(19) **Europäisches Patentamt / European Patent Office / Office européen des brevets**

(11) **EP 4 297 212 A1**

(12) # EUROPEAN PATENT APPLICATION
published in accordance with Art. 153(4) EPC

(43) Date of publication:
**27.12.2023 Bulletin 2023/52**

(21) Application number: **21932280.7**

(22) Date of filing: **26.03.2021**

(51) International Patent Classification (IPC):
**H02H 3/00** *(2006.01)*

(52) Cooperative Patent Classification (CPC):
**H02H 3/00**

(86) International application number:
**PCT/CN2021/083383**

(87) International publication number:
**WO 2022/198659 (29.09.2022 Gazette 2022/39)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Huawei Digital Power Technologies
Co., Ltd.
Shenzhen, Guangdong 518043 (CN)**

(72) Inventors:
• **CHEN, Dong**
  **Shenzhen, Guangdong 518129 (CN)**
• **GAO, Yongbing**
  **Shenzhen, Guangdong 518129 (CN)**
• **WANG, Xun**
  **Shenzhen, Guangdong 518129 (CN)**

(74) Representative: **Gill Jennings & Every LLP
The Broadgate Tower
20 Primrose Street
London EC2A 2ES (GB)**

(54) **POWER SUPPLY APPARATUS, AND METHOD FOR MEASURING INSULATION RESISTANCE OF INPUT END OF POWER SUPPLY APPARATUS**

(57) This application provides power sourcing equipment and a method for detecting insulation resistance at an input end of power sourcing equipment. The input end of the power sourcing equipment is coupled to an output end of a direct current power supply, and the power sourcing equipment includes a residual current detection unit, a voltage detection unit, and a controller. The controller determines an insulation resistance value at the input end of the power sourcing equipment based on a first preset voltage parameter value, a first residual current value, a second preset voltage parameter value, and a second residual current value. The first preset voltage parameter value and the second preset voltage parameter value are different from each other. The first residual current value is a residual current value of the power sourcing equipment when a voltage parameter of the power sourcing equipment includes the first preset voltage parameter value. The second residual current value is a residual current value of the power sourcing equipment when the voltage parameter of the power sourcing equipment includes the second preset voltage parameter value. In this application, an offset of an RCD may be compensated for or canceled, to improve accuracy of detecting insulation resistance-to-ground at the input end of the power sourcing equipment. Therefore, applicability is high.

FIG. 3a

**Description**

**TECHNICAL FIELD**

This application relates to the field of power supply technologies, and in particular, to power sourcing equipment and a method for detecting insulation resistance at an input end of power sourcing equipment.

**BACKGROUND**

When a power supply is connected to power sourcing equipment (namely, an electric device or a power conversion device), insulation resistance-to-ground at an input end of the power sourcing equipment needs to be detected, to ensure normal and reliable connection of the power supply, and ensure safety of the power supply, the power sourcing equipment, and onsite personnel. In addition, insulation resistance detection has been incorporated into various electrical equipment standards.

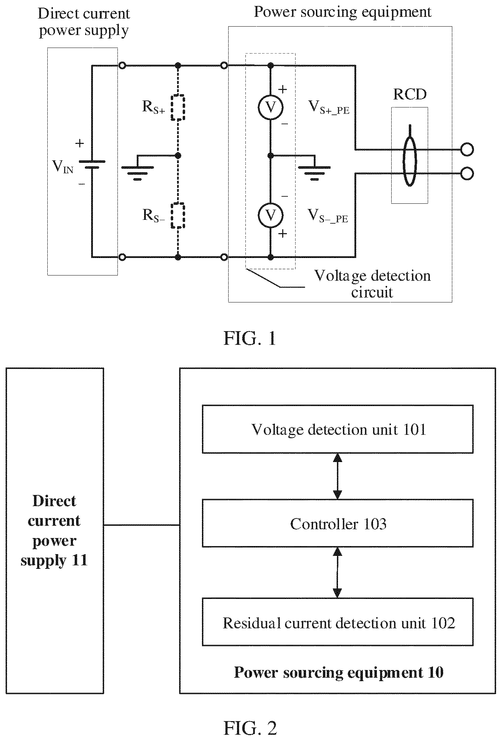

Currently, a method for detecting insulation resistance at an input end of power sourcing equipment in FIG. 1 is used in the conventional technology. During operation of power sourcing equipment, a residual current $I_{RCD}$ of the power sourcing equipment may be detected by using a residual current device (Residual Current Device, RCD), and a voltage-to-ground $V_{S+\_PE}$ at a positive input end of the power sourcing equipment and a voltage-to-ground $V_{S-\_PE}$ at a negative input end of the power sourcing equipment are detected by using a voltage detection circuit. In normal cases, insulation resistance-to-ground $R_{S+}$ at a positive input end of power sourcing equipment is equal to or approximately equal to insulation resistance-to-ground $R_{S-}$ at a negative input end of the same power sourcing equipment. Then an insulation resistance-to-ground value at the input end of the power sourcing equipment (to be specific, an insulation resistance-to-ground value of a direct current power supply, the power sourcing equipment, and a connection cable between the direct current power supply and the power sourcing equipment) may be obtained based on the following equation: $I_{RCD} = V_{S+\_PE}/R_{S+} + V_{S-\_PE}/R_{S-}$ . Because the RCD has an offset, accuracy of detecting insulation resistance-to-ground of a power supply is significantly reduced in the foregoing manner.

**SUMMARY**

This application provides power sourcing equipment and a method for detecting insulation resistance at an input end of power sourcing equipment. An offset of an RCD may be compensated for or canceled based on residual current values and voltage parameters of the power sourcing equipment that are obtained by the power sourcing equipment in two different operating statuses, to improve accuracy of detecting insulation resistance-to-ground at the input end of the power sourcing equipment. Therefore, applicability is high.

According to a first aspect, this application provides power sourcing equipment. An input end of the power sourcing equipment is coupled to an output end of a direct current power supply, and the power sourcing equipment includes a residual current detection unit, a voltage detection unit, and a controller. The controller determines an insulation resistance value of the direct current power supply based on a first preset voltage parameter value, a first residual current value, a second preset voltage parameter value, and a second residual current value. The first preset voltage parameter value and the second preset voltage parameter value are different from each other. The first residual current value is a residual current value of the power sourcing equipment that is detected by the residual current detection unit when a voltage parameter of the power sourcing equipment includes the first preset voltage parameter value. The second residual current value is a residual current value of the power sourcing equipment that is detected by the residual current detection unit when the voltage parameter of the power sourcing equipment includes the second preset voltage parameter value.

In this embodiment of this application, an offset of an RCD may be compensated for or canceled based on residual current values and voltage parameters of the power sourcing equipment that are obtained by the power sourcing equipment in two different operating statuses, to improve accuracy of detecting insulation resistance-to-ground at the input end of the power sourcing equipment. Therefore, applicability is high.

With reference to the first aspect, in a first possible implementation, the voltage parameter includes an input voltage and a voltage-to-ground of the power sourcing equipment, the voltage-to-ground is a voltage between a first input end of the power sourcing equipment and ground, the first preset voltage parameter value includes a first input voltage value, and the second preset voltage parameter value includes a second input voltage value. The controller determines the insulation resistance value at the input end of the power sourcing equipment based on the first input voltage value, a first voltage-to-ground value, the first residual current value, the second input voltage value, a second voltage-to-ground, and the second residual current value. The first voltage-to-ground value is a voltage that is between the first input end of the power sourcing equipment and the ground and that is detected by the voltage detection unit when the input voltage of the power sourcing equipment is the first input voltage value. The second voltage-to-ground is a voltage that is between the first input end of the power sourcing equipment and the ground and that is detected by the voltage detection unit when the input voltage of the power sourcing equipment is the second input voltage value.

In this embodiment of this application, the first residual current value is a residual current of the power sourcing equipment when the input voltage of the power sourcing equipment is the first input voltage value, and the second residual current value is a residual current of the power sourcing equipment when the input voltage of the power sourcing equipment is the second input voltage value.

With reference to the first aspect, in a second possible implementation, the voltage parameter includes an input voltage and a voltage-to-ground of the power sourcing equipment, the voltage-to-ground is a voltage between a first input end of the power sourcing equipment and ground, the first preset voltage parameter value includes a first voltage-to-ground value, and the second preset voltage parameter value includes a second voltage-to-ground value. The controller determines the insulation resistance value at the input end of the power sourcing equipment based on a first input voltage value, the first voltage-to-ground value, the first residual current value, a second input voltage value, the second voltage-to-ground, and the second residual current value. The first input voltage is an input voltage of the power sourcing equipment that is detected by the voltage detection unit when the voltage-to-ground is the first voltage-to-ground value. The second input voltage is an input voltage of the power sourcing equipment that is detected by the voltage detection unit when the voltage-to-ground is the second voltage-to-ground value.

In this embodiment of this application, the first residual current value is a residual current of the power sourcing equipment when the voltage-to-ground of the power sourcing equipment is the first voltage-to-ground value, and the second residual current value is a residual current of the power sourcing equipment when the voltage-to-ground of the power sourcing equipment is the second voltage-to-ground value.

With reference to the first aspect, in a third possible implementation, the voltage parameter includes an input voltage and a voltage-to-ground of the power sourcing equipment, the voltage-to-ground is a voltage between a first input end of the power sourcing equipment and ground, the first preset voltage parameter value includes a first input voltage value and a first voltage-to-ground value, and the second preset voltage parameter value includes a second input voltage value and a second voltage-to-ground value.

In this embodiment of this application, the first residual current value is a residual current of the power sourcing equipment when the input voltage and the voltage-to-ground of the power sourcing equipment are the first input voltage value and the first voltage-to-ground value respectively, and the second residual current value is a residual current of the power sourcing equipment when the input voltage and the voltage-to-ground of the power sourcing equipment are the second input voltage value and the second voltage-to-ground value respectively.

With reference to the first aspect, in a fourth possible implementation, when the first input end is a positive input end of the power sourcing equipment, the insulation resistance value at the input end of the power sourcing equipment is as follows: $K = [2(V_1 - V_2) - V_{in1} + V_{in2}]/[2(I_{RCD\_1} - I_{RCD\_2})]$ ; or when the first input end is a negative input end of the power sourcing equipment, the insulation resistance value at the input end of the power sourcing equipment is as follows: $K = [2(V_1 - V_2) + V_{in1} - V_{in2}]/[2(I_{RCD\_1} - I_{RCD\_2})]$ where K is the insulation resistance value, $V_1$ is the first voltage-to-ground value, $V_2$ is the second voltage-to-ground value, $V_{in1}$ is the first input voltage value, $V_{in2}$ is the second input voltage value, $I_{RCD\_1}$ is the first residual current value, and $I_{RCD\_2}$ is the second residual current value.

In this embodiment of this application, the offset of the RCD may be directly canceled based on residual current values and voltage parameters of the power sourcing equipment that are obtained by the power sourcing equipment in two different operating statuses, to improve accuracy of detecting insulation resistance-to-ground at the input end of the power sourcing equipment. Therefore, applicability is high.

With reference to the first aspect, in a fifth possible implementation, the controller determines a residual current compensation value based on an initial insulation resistance value at the input end of the power sourcing equipment, the first input voltage value, the first voltage-to-ground value, and the first residual current value; and determines the insulation resistance value at the input end of the power sourcing equipment based on the residual current compensation value, the second input voltage value, the second voltage-to-ground value, and the second residual current value.

In this embodiment of this application, the offset of the RCD may be compensated for based on the residual current compensation value, to improve accuracy of detecting insulation resistance-to-ground at the input end of the power sourcing equipment. Therefore, applicability is high.

With reference to the first aspect, in a sixth possible implementation, when the first input end is a positive input end of the power sourcing equipment, the residual current compensation value is as follows: $I_{RCD\_com} = (2V_1 - V_{in1})/(2K_0) - I_{RCD\_1}$; or when the first input end is a negative input end of the power sourcing equipment, the residual current compensation value is follows: $I_{RCD\_com} = (2V_1 + V_{in1})/(2K_0) - I_{RCD\_1}$, where $I_{RCD\_com}$ is the residual current compensation value, $V_1$ is the first voltage-to-ground value, $V_{in1}$ is the first input voltage value, $K_0$ is the initial insulation resistance value, and $I_{RCD\_1}$ is the first residual current value.

In this embodiment of this application, the residual current compensation value may be determined based on the initial insulation resistance value at the input end of the power sourcing equipment, and then the offset of the RCD may be compensated for based on the residual current compensation value, to improve accuracy of detecting insulation resistance-to-ground at the input end of the power sourcing equipment. Therefore, applicability is high.

With reference to the first aspect, in a seventh possible implementation, when the first input end is a positive input end of the power sourcing equipment, the insulation resistance value at the input end of the power sourcing equipment is as follows: $K = (2V_2 - V_{in2})/[2(I_{RCD\_2} + I_{RCD\_com})]$; or when the first input end is a negative input end of the power sourcing equipment, the insulation resistance value at the input end of the power sourcing equipment is as follows: $K = (2V_2 + V_{in2})/[2(I_{RCD\_2} + I_{RCD\_com})]$, where K is the insulation resistance value, $V_2$ is the second voltage-to-ground value, $V_{in2}$ is the second input voltage value, $I_{RCD\_2}$ is the second residual current value, and $I_{RCD\_com}$ is the residual current compensation value.

In this embodiment of this application, the offset of the RCD is compensated for based on the residual current compensation value, to improve accuracy of detecting insulation resistance-to-ground at the input end of the power sourcing equipment. Therefore, applicability is high.

With reference to the first aspect, in an eighth possible implementation, the power sourcing equipment further includes a positive direct current bus and a negative direct current bus. The positive direct current bus is coupled to the positive input end of the power sourcing equipment. The negative direct current bus is coupled to the negative input end of the power sourcing equipment. The positive direct current bus and the negative direct current bus are coupled to an output end of the power sourcing equipment through the residual current detection unit.

In this embodiment of this application, when the first input end of the power sourcing equipment is the positive input end, a voltage between the positive input end of the power sourcing equipment and the ground is a voltage between the positive direct current bus and the ground; or when the first input end of the power sourcing equipment is the negative input end, a voltage between the negative input end of the power sourcing equipment and the ground is a voltage between the negative direct current bus and the ground.

With reference to the first aspect, in a ninth possible implementation, the power sourcing equipment further includes an initial insulation resistance detection unit, a positive direct current bus, and a negative direct current bus. The initial insulation resistance detection unit is configured to detect an initial insulation resistance value at the input end of the power sourcing equipment. The positive direct current bus is coupled to the positive input end of the power sourcing equipment. The negative direct current bus is coupled to the negative input end of the power sourcing equipment. The initial insulation resistance detection unit is coupled between the positive direct current bus and the negative direct current bus.

In this embodiment of this application, the initial insulation resistance value at the input end of the power sourcing equipment may be detected by the initial insulation resistance detection unit, the residual current compensation value is determined based on the initial insulation resistance value at the input end of the power sourcing equipment, and then the offset of the RCD is compensated for based on the residual current compensation value, to improve accuracy of detecting insulation resistance-to-ground at the input end of the power sourcing equipment. In addition, the residual current detection unit, the voltage detection unit, and the initial insulation resistance detection unit are all existing circuits in the power sourcing equipment. Therefore, circuit or device costs do not need to be additionally increased, and applicability is high.

With reference to the first aspect, in a tenth possible implementation, the power sourcing equipment further includes a positive direct current bus, a negative direct current bus, and a boost unit. A positive input end of the boost unit is coupled to the positive input end of the power sourcing equipment, and a negative input end of the boost unit is coupled to the negative input end of the power sourcing equipment. A positive output end of the boost unit is coupled to the positive direct current bus, and a negative output end of the boost unit is coupled to the negative direct current bus. When the first input end of the power sourcing equipment is the negative input end, the negative input end of the boost unit and the negative output end of the boost unit are directly coupled or are coupled through low resistance, and the voltage-to-ground is a voltage between the negative direct current bus and the ground. When the first input end of the power sourcing equipment is the positive input end, the positive input end of the boost unit and the negative output end of the boost unit are directly coupled or are coupled through low resistance, and the voltage-to-ground is a voltage between the negative direct current bus and the ground. When the first input end of the power sourcing equipment is the positive input end, the positive input end of the boost unit and the positive output end of the boost unit are directly coupled or are coupled through low resistance, and the voltage-to-ground is a voltage between the positive direct current bus and the ground. When the first input end of the power sourcing equipment is the negative input end, the negative input end of the boost unit and the positive output end of the boost unit are directly coupled or are coupled through low resistance, and the voltage-to-ground is a voltage between the positive direct current bus and the ground.

A manner of determining an insulation resistance-to-ground value at the input end of the power sourcing equipment in this embodiment of this application is also applicable to the power sourcing equipment in which the boost unit is further introduced in this embodiment of this application.

With reference to the first aspect, in an eleventh possible implementation, the power sourcing equipment further includes a positive direct current bus and a negative direct current bus, the direct current power supply includes at least two direct current power supplies, and the input end of the power sourcing equipment includes at least two pairs of input ends. Each pair of input ends of the at least two pairs of input ends are correspondingly coupled to two output ends of each of the at least two direct current power supplies. A positive input end of each pair of input ends is coupled to the positive direct current bus, and a negative input end of each pair of input ends is coupled to the negative direct current bus. The input voltage of the power sourcing equipment includes a voltage of each pair of input ends.

In this embodiment of this application, when the direct current voltage includes at least two direct current power supplies, the input voltage of the power sourcing equipment includes a voltage of each pair of input ends of the power sourcing equipment.

With reference to the first aspect, in a twelfth possible implementation, the power sourcing equipment further includes a positive direct current bus, a negative direct current bus, a direct current neutral wire, a first group of boost units, and a second group of boost units. The first group of boost units and the second group of boost units each include at least one boost unit. The direct current power supply includes a first group of direct current power supplies and a second group of direct current power supplies. The first group of direct current power supplies and the second group of direct current power supplies each include at least one direct current power supply. The input end of the power sourcing equipment includes a first group of input ends and a second group of input ends. The first group of input ends and the second group of input ends each include at least one pair of input ends.

Each pair of input ends in the first group of input ends are correspondingly coupled to two output ends of each direct current power supply in the first group of direct current power supplies.

Each pair of input ends in the second group of input ends are correspondingly coupled to two output ends of each direct current power supply in the second group of direct current power supplies.

Two input ends of each boost unit in the first group of boost units are correspondingly coupled to each pair of input ends in the first group of input ends.

Two input ends of each boost unit in the second group of boost units are correspondingly coupled to each pair of input ends in the second group of input ends.

A positive output end of each boost unit in the first group of boost units is connected to the positive direct current bus, and a negative output end of each boost unit in the first group of boost units is connected to the direct current neutral wire.

A positive output end of each boost unit in the second group of boost units is connected to the direct current neutral wire, and a negative output end of each boost unit in the second group of boost units is connected to the negative direct current bus.

When the first input end is the negative input end, a negative input end and the negative output end of each boost unit in the first group of boost units are directly coupled or are coupled through low resistance, a negative input end and the positive output end of each boost unit in the second group of boost units are directly coupled or are coupled through low resistance, and the voltage-to-ground is a voltage between the direct current neutral wire and the ground.

When the first input end is the positive input end, a positive input end and the negative output end of each boost unit in the first group of boost units are directly coupled or are coupled through low resistance, a positive input end and the positive output end of each boost unit in the second group of boost units are directly coupled or are coupled through low resistance, and the voltage-to-ground is a voltage between the direct current neutral wire and the ground.

A manner of determining an insulation resistance-to-ground value at the input end of the power sourcing equipment in this embodiment of this application is also applicable to the power sourcing equipment in which the direct current neutral wire and a plurality of boost units are further introduced in this embodiment of this application.

With reference to the first aspect, in a thirteenth possible implementation, the power sourcing equipment further includes an initial insulation resistance detection unit. The initial insulation resistance detection unit is configured to detect an initial insulation resistance value at the input end of the power sourcing equipment. The initial insulation resistance detection unit is coupled between any two of the positive direct current bus, the negative direct current bus, and the direct current neutral wire.

In this embodiment of this application, the initial insulation resistance detection unit may be coupled to any two of the positive direct current bus, the negative direct current bus, and the direct current neutral wire. Therefore, applicability is high.

With reference to the first aspect, in a fourteenth possible implementation, the positive direct current bus, the negative direct current bus, and the direct current neutral wire are coupled to an output end of the power sourcing equipment through the residual current detection unit.

According to a second aspect, this application provides a method for detecting insulation resistance at an input end of power sourcing equipment. The input end of the power sourcing equipment is coupled to an output end of a direct current power supply. The power sourcing equipment determines an insulation resistance value at the input end of the power sourcing equipment based on a first preset voltage parameter value, a first residual current value, a second preset voltage parameter value, and a second residual current value. The first preset voltage parameter value and the second preset voltage parameter value are different from each other. The first residual current value is a residual current value of the power sourcing equipment that is detected when a voltage parameter of the power sourcing equipment includes the first preset voltage parameter value. The second residual current value is a residual current value of the power sourcing equipment that is detected when the voltage parameter of the power sourcing equipment includes the second preset voltage parameter value.

With reference to the second aspect, in a first possible implementation, the voltage parameter includes an input voltage and a voltage-to-ground of the power sourcing equipment. The voltage-to-ground is a voltage between a first input end of the power sourcing equipment and ground. The first preset voltage parameter value includes a first input voltage value. The second preset voltage parameter value includes a second input voltage value. The power sourcing equipment determines the insulation resistance value at the input end of the power sourcing equipment based on the first input voltage value, a first voltage-to-ground value, the first residual current value, the second input voltage value, a second voltage-to-ground, and the second residual current value. The first voltage-to-ground value is a voltage detected between the first input end of the power sourcing equipment and the ground when the input voltage of the power sourcing equipment is the first input voltage value. The second voltage-to-ground is a voltage detected between the first input end of the power sourcing equipment and the ground and when the input voltage of the power sourcing equipment is the second input voltage value.

With reference to the second aspect, in a second possible implementation, the voltage parameter includes an input voltage and a voltage-to-ground of the power sourcing equipment. The voltage-to-ground is a voltage between a first input end of the power sourcing equipment and ground. The first preset voltage parameter value includes a first voltage-to-ground value. The second preset voltage parameter value includes a second voltage-to-ground value. The power sourcing equipment determines the insulation resistance value at the input end of the power sourcing equipment based on a first input voltage value, the first voltage-to-ground value, the first residual current value, a second input voltage value, the second voltage-to-ground, and the second residual current value. The first input voltage is an input voltage of the power sourcing equipment that is detected when the voltage-to-ground is the first voltage-to-ground value. The second input voltage is an input voltage of the power sourcing equipment that is detected when the voltage-to-ground is the second voltage-to-ground value.

With reference to the second aspect, in a third possible implementation, the voltage parameter includes an input voltage and a voltage-to-ground of the power sourcing equipment, the voltage-to-ground is a voltage between a first input end of the power sourcing equipment and ground, the first preset voltage parameter value includes a first input voltage value and a first voltage-to-ground value, and the second preset voltage parameter value includes a second input voltage value and a second voltage-to-ground value.

With reference to the second aspect, in a fourth possible implementation, when the first input end is a positive input end of the power sourcing equipment, the insulation resistance value at the input end of the power sourcing equipment is as follows: $K = [2(V_1 - V_2) - V_{in1} + V_{in2}]/[2(I_{RCD\_1} - I_{RCD\_2})]$; or when the first input end is a negative input end of the power sourcing equipment, the insulation resistance value at the input end of the power sourcing equipment is as follows: $K = [2(V_1 - V_2) + V_{in1} - V_{in2}]/[2(I_{RCD\_1} - I_{RCD\_2})]$, where K is the insulation resistance value, $V_1$ is the first voltage-to-ground value, $V_2$ is the second voltage-to-ground value, $V_{in1}$ is the first input voltage value, $V_{in2}$ is the second input voltage value, $I_{RCD\_1}$ is the first residual current value, and $I_{RCD\_2}$ is the second residual current value.

With reference to the second aspect, in a fifth possible implementation, the power sourcing equipment determines a residual current compensation value based on an initial insulation resistance value at the input end of the power sourcing equipment, the first input voltage value, the first voltage-to-ground value, and the first residual current value; and determines the insulation resistance value at the input end of the power sourcing equipment based on the residual current compensation value, the second input voltage value, the second voltage-to-ground value, and the second residual current value.

With reference to the second aspect, in a sixth possible implementation, when the first input end is a positive input end of the power sourcing equipment, the residual current compensation value is as follows: $I_{RCD\_com} = (2V_1 - V_{in1})/(2K_0) - I_{RCD\_1}$; or when the first input end is a negative input end of the power sourcing equipment, the residual current compensation value is follows: $I_{RCD\_com} = (2V_1 + V_{in1})/(2K_0) - I_{RCD\_1}$, where $I_{RCD\_com}$ is the residual current compensation value, $V_1$ is the first voltage-to-ground value, $V_{in1}$ is the first input voltage value, $K_0$ is the initial insulation resistance value, and $I_{RCD\_1}$ is the first residual current value.

With reference to the second aspect, in a seventh possible implementation, when the first input end is a positive input end of the power sourcing equipment, the insulation resistance value at the input end of the power sourcing equipment is as follows: $K = (2V_2 - V_{in2})/[2(I_{RCD\_2} + I_{RCD\_com})]$; or when the first input end is a negative input end of the power sourcing equipment, the insulation resistance value at the input end of the power sourcing equipment is as follows: $K = (2V_2 + V_{in2})/[2(I_{RCD\_2} + I_{RCD\_com})]$, where K is the insulation resistance value, $V_2$ is the second voltage-to-ground value, $V_{in2}$ is the second input voltage value, $I_{RCD\_2}$ is the second residual current value, and $I_{RCD\_com}$ is the residual current compensation value.

With reference to the second aspect, in an eighth possible implementation, the power sourcing equipment further includes a positive direct current bus and a negative direct current bus. The positive direct current bus is coupled to the positive input end of the power sourcing equipment. The negative direct current bus is coupled to the negative input end of the power sourcing equipment. The positive direct current bus and the negative direct current bus are coupled to an output end of the power sourcing equipment through the residual current detection unit.

With reference to the second aspect, in a ninth possible implementation, the power sourcing equipment further includes an initial insulation resistance detection unit, a positive direct current bus, and a negative direct current bus. The initial insulation resistance detection unit is configured to detect an initial insulation resistance value at the input end of the power sourcing equipment. The positive direct current bus is coupled to the positive input end of the power sourcing equipment. The negative direct current bus is coupled to the negative input end of the power sourcing equipment. The initial insulation resistance detection unit is coupled between the positive direct current bus and the negative direct current bus.

With reference to the second aspect, in a tenth possible implementation, the power sourcing equipment further includes a positive direct current bus, a negative direct current bus, and a boost unit. A positive input end of the boost unit is coupled to the positive input end of the power sourcing equipment, and a negative input end of the boost unit is coupled to the negative input end of the power sourcing equipment. A positive output end of the boost unit is coupled to the positive direct current bus, and a negative output end of the boost unit is coupled to the negative direct current bus. When the first input end of the power sourcing equipment is the negative input end, the negative input end of the boost unit and the negative output end of the boost unit are directly coupled or are coupled through low resistance, and the voltage-to-ground is a voltage between the negative direct current bus and the ground. When the first input end of the power sourcing equipment is the positive input end, the positive input end of the boost unit and the negative output end of the boost unit are directly coupled or are coupled through low resistance, and the voltage-to-ground is a voltage between the negative direct current bus and the ground. When the first input end of the power sourcing equipment is the positive input end, the positive input end of the boost unit and the positive output end of the boost unit are directly coupled or are coupled through low resistance, and the voltage-to-ground is a voltage between the positive direct current bus and the ground. When the first input end of the power sourcing equipment is the negative input end, the negative input end of the boost unit and the positive output end of the boost unit are directly coupled or are coupled through low resistance, and the voltage-to-ground is a voltage between the positive direct current bus and the ground.

With reference to the second aspect, in an eleventh possible implementation, the power sourcing equipment further includes a positive direct current bus and a negative direct current bus, the direct current power supply includes at least two direct current power supplies, and the input end of the power sourcing equipment includes at least two pairs of input ends. Each pair of input ends of the at least two pairs of input ends are correspondingly coupled to two output ends of each of the at least two direct current power supplies. A positive input end of each pair of input ends is coupled to the positive direct current bus, and a negative input end of each pair of input ends is coupled to the negative direct current bus. The input voltage of the power sourcing equipment includes a voltage of each pair of input ends.

With reference to the second aspect, in a twelfth possible implementation, the power sourcing equipment further includes a positive direct current bus, a negative direct current bus, a direct current neutral wire, a first group of boost units, and a second group of boost units. The first group of boost units and the second group of boost units each include at least one boost unit. The direct current power supply includes a first group of direct current power supplies and a second group of direct current power supplies. The first group of direct current power supplies and the second group of direct current power supplies each include at least one direct current power supply. The input end of the power sourcing equipment includes a first group of input ends and a second group of input ends. The first group of input ends and the second group of input ends each include at least one pair of input ends.

Each pair of input ends in the first group of input ends are correspondingly coupled to two output ends of each direct current power supply in the first group of direct current power supplies.

Each pair of input ends in the second group of input ends are correspondingly coupled to two output ends of each direct current power supply in the second group of direct current power supplies.

Two input ends of each boost unit in the first group of boost units are correspondingly coupled to each pair of input ends in the first group of input ends.

Two input ends of each boost unit in the second group of boost units are correspondingly coupled to each pair of input ends in the second group of input ends.

A positive output end of each boost unit in the first group of boost units is connected to the positive direct current bus, and a negative output end of each boost unit in the first group of boost units is connected to the direct current neutral wire.

A positive output end of each boost unit in the second group of boost units is connected to the direct current neutral wire, and a negative output end of each boost unit in the second group of boost units is connected to the negative direct current bus.

When the first input end is the negative input end, a negative input end and the negative output end of each boost unit in the first group of boost units are directly coupled or are coupled through low resistance, a negative input end and the positive output end of each boost unit in the second group of boost units are directly coupled or are coupled through low resistance, and the voltage-to-ground is a voltage between the direct current neutral wire and the ground.

When the first input end is the positive input end, a positive input end and the negative output end of each boost unit in the first group of boost units are directly coupled or are coupled through low resistance, a positive input end and the positive output end of each boost unit in the second group of boost units are directly coupled or are coupled through low resistance, and the voltage-to-ground is a voltage between the direct current neutral wire and the ground.

With reference to the second aspect, in a thirteenth possible implementation, the power sourcing equipment further includes an initial insulation resistance detection unit. The initial insulation resistance detection unit is configured to detect an initial insulation resistance value at the input end of the power sourcing equipment. The initial insulation resistance detection unit is coupled between any two of the positive direct current bus, the negative direct current bus, and the direct current neutral wire.

With reference to the second aspect, in a fourteenth possible implementation, the positive direct current bus, the negative direct current bus, and the direct current neutral wire are coupled to an output end of the power sourcing equipment through the residual current detection unit.

It should be understood that mutual reference may be made between implementations and benefits of the foregoing plurality of aspects of this application.

## BRIEF DESCRIPTION OF DRAWINGS

FIG. 1 is a method for detecting insulation resistance at an input end of power sourcing equipment in the conventional technology;
FIG. 2 is a schematic diagram of a structure of power sourcing equipment according to this application;
FIG. 3a is a schematic diagram of another structure of power sourcing equipment according to this application;
FIG. 3b is a schematic diagram of another structure of power sourcing equipment according to this application;
FIG. 4a is a schematic diagram of another structure of power sourcing equipment according to this application;
FIG. 4b is a schematic diagram of another structure of power sourcing equipment according to this application;
FIG. 5a is a schematic diagram of another structure of power sourcing equipment according to this application;
FIG. 5b is a schematic diagram of another structure of power sourcing equipment according to this application;
FIG. 5c is a schematic diagram of another structure of power sourcing equipment according to this application;
FIG. 6a is a schematic diagram of another structure of power sourcing equipment according to this application;
FIG. 6b is a schematic diagram of another structure of power sourcing equipment according to this application;
FIG. 6c is a schematic diagram of another structure of power sourcing equipment according to this application;
FIG. 7a is a schematic diagram of still another structure of power sourcing equipment according to this application; and
FIG. 7b is a schematic diagram of still another structure of power sourcing equipment according to this application.

## DESCRIPTION OF EMBODIMENTS

When insulation resistance-to-ground of a direct current power supply (for example, a power battery of an electric vehicle or a photovoltaic array) is poor or a resistance value is less than a value specified in a safety regulation, a housing of a device using the direct current power supply is conductive. Consequently, the device is likely to be damaged, and a great threat is also caused to personal safety. Therefore, an insulation resistance-to-ground value at an input end of power sourcing equipment that is connected to an output end of the direct current power supply needs to be detected, so that corresponding protection measures can be taken in a timely manner to ensure safety of the equipment and safety of personnel.

In the conventional technology, an insulation resistance-to-ground value at an input end of power sourcing equipment is determined by detecting a voltage-to-ground value at the input end of the power sourcing equipment and a residual current value of the power sourcing equipment. However, because an RCD has an offset, in a method shown in FIG. 1, accuracy of detecting insulation resistance-to-ground at the input end of the power sourcing equipment is significantly reduced. Consequently, a false positive occurs, and operation time of the power sourcing equipment connected to the direct current power supply is shortened.

In this application, an offset of an RCD may be compensated for or canceled based on residual current values and voltage parameters of power sourcing equipment that are obtained by the power sourcing equipment in two different operating statuses, to improve accuracy of detecting insulation resistance-to-ground at an input end of the power sourcing equipment. In addition, in this application, an existing circuit in the power sourcing equipment is used to detect the insulation resistance-to-ground at the input end of the power sourcing equipment. Therefore, circuit or device costs do not need to be additionally increased, and applicability is high.

FIG. 2 is a schematic diagram of a structure of power sourcing equipment according to this application. As shown in FIG. 2, an input end of power sourcing equipment 10 is coupled to an output end of a direct current power supply 11, and the power sourcing equipment 10 includes a voltage detection unit 101, a residual current detection unit 102, and a controller 103. The voltage detection unit 101 is configured to detect a voltage parameter of the power sourcing equipment 10, where the voltage parameter of the power sourcing equipment 10 includes an input voltage and a voltage-to-ground of the power sourcing equipment 10, and the voltage-to-ground is a voltage between a first input end (namely, a positive input end or a negative input end) of the power sourcing equipment 10 and ground. The residual current detection unit 102 is configured to: when the voltage parameter of the power sourcing equipment 10 includes a first preset voltage parameter, detect a first residual current value of the power sourcing equipment 10; and when the voltage parameter of the power sourcing equipment 10 includes a second preset voltage parameter, detect a second residual current value of the power sourcing equipment 10, where the first preset voltage parameter and the second preset voltage parameter are different from each other. The controller 103 is configured to determine an insulation resistance value at the input end of the power sourcing equipment 10, to be specific, an insulation resistance-to-ground value of the power sourcing equipment 10, the direct current power supply 11, and a connection cable between the power sourcing equipment 10 and the direct current power supply 11, based on the first preset voltage parameter, the first residual current value, the second preset voltage parameter, and the second residual current value.

In an implementation, the controller 103 may control the input voltage of the power sourcing equipment 10 to be a first input voltage value or a second input voltage value; and when the input voltage of the power sourcing equipment 10 is the first input voltage value, send a first voltage sampling signal to the voltage detection unit 101, and send a first current sampling signal to the residual current detection unit 102; or when the input voltage of the power sourcing equipment 10 is the second input voltage value, send a second voltage sampling signal to the voltage detection unit 101, and send a second current sampling signal to the residual current detection unit 102. The voltage detection unit 101 captures the voltage-to-ground of the power sourcing equipment 10 based on the first voltage sampling signal to obtain a first voltage-to-ground value, captures the voltage-to-ground of the power sourcing equipment 10 based on the second voltage sampling signal to obtain a second voltage-to-ground value, and returns the first voltage-to-ground value and the second voltage-to-ground value to the controller 103. The residual current detection unit 102 captures a residual current of the power sourcing equipment 10 based on the first current sampling signal to obtain the first residual current value, captures a residual current of the power sourcing equipment 10 based on the second current sampling signal to obtain the second residual current value, and returns the first residual current value and the second residual current value to the controller 103.

In another implementation, when there is a single direct current power supply 11, the controller 103 may control the voltage-to-ground of the power sourcing equipment 10 to be a first voltage-to-ground value or a second voltage-to-ground value; and when the voltage-to-ground voltage of the power sourcing equipment 10 is the first voltage-to-ground value, send a first voltage sampling signal to the voltage detection unit 101, and send a first current sampling signal to the residual current detection unit 102; or when the voltage-to-ground of the power sourcing equipment 10 is the second voltage-to-ground value, send a second voltage sampling signal to the voltage detection unit 101, and send a second current sampling signal to the residual current detection unit 102. The voltage detection unit 101 captures the input voltage of the power sourcing equipment 10 based on the first voltage sampling signal to obtain a first input voltage value, captures the input voltage of the power sourcing equipment 10 based on the second voltage sampling signal to obtain a second input voltage value, and returns the first input voltage value and the second input voltage value to the controller 103. The residual current detection unit 102 captures a residual current of the power sourcing equipment 10 based on the first current sampling signal to obtain the first residual current value, captures a residual current of the power sourcing equipment 10 based on the second current sampling signal to obtain the second residual current value, and returns the first residual current value and the second residual current value to the controller 103.

When there are at least two direct current power supplies 11, the controller 103 may control a voltage of each pair of input ends of the power sourcing equipment 10 to be a first input voltage value, and control the voltage-to-ground of the power sourcing equipment 10 to be a first voltage-to-ground value. When the voltage-to-ground of the power sourcing equipment 10 is the first voltage-to-ground, the controller 103 sends a first current sampling signal to the residual current detection unit 102. Then the controller 103 continues to control a voltage of each pair of input ends of the power sourcing equipment 10 to be the first input voltage value, and controls the voltage-to-ground of the power sourcing equipment 10 to be a second voltage-to-ground value. When the voltage-to-ground of the power sourcing equipment 10 is the second voltage-to-ground value, the controller 103 sends a second current sampling signal to the residual current detection unit 102. The residual current detection unit 102 captures a residual current of the power sourcing equipment 10 based on the first current sampling signal to obtain the first residual current value, captures a residual current of the power sourcing equipment 10 based on the second current sampling signal to obtain the second residual current value, and returns the first residual current value and the second residual current value to the controller 103.

In still another implementation, the controller 103 controls the input voltage and the voltage-to-ground of the power sourcing equipment 10 to be a first input voltage value and a first voltage-to-ground value respectively, and sends a first current sampling signal to the residual current detection unit 102 when the input voltage and the voltage-to-ground of the power sourcing equipment 10 are the first input voltage value and the first voltage-to-ground value respectively;

and the controller 103 controls the input voltage and the voltage-to-ground of the power sourcing equipment 10 to be a second input voltage value and a second voltage-to-ground value respectively, and sends a second current sampling signal to the residual current detection unit 102 when the input voltage and the voltage-to-ground of the power sourcing equipment 10 are the second input voltage value and the second voltage-to-ground value respectively. The residual current detection unit 102 captures a residual current of the power sourcing equipment 10 based on the first current sampling signal to obtain the first residual current value, captures a residual current of the power sourcing equipment 10 based on the second current sampling signal to obtain the second residual current value, and returns the first residual current value and the second residual current value to the controller 103.

Then the controller 103 calculates an insulation resistance-to-ground value at the input end of the power sourcing equipment 10 based on the first input voltage value, the first voltage-to-ground value, the first residual current value, the second input voltage value, the second voltage-to-ground value, and the second residual current value.

In an implementation, when the first input end is the positive input end of the power sourcing equipment 10, the insulation resistance value at the input end of the power sourcing equipment 10 is as follows: $K = [2(V_1 - V_2) - V_{in1} + V_{in2}]/[2(I_{RCD\_1} - I_{RCD\_2})]$; or when the first input end is the negative input end of the power sourcing equipment 10, the insulation resistance value at the input end of the power sourcing equipment 10 is as follows: $K = [2(V_1 - V_2) + V_{in1} - V_{in2}]/[2(I_{RCD\_1} - I_{RCD\_2})]$, where K is the insulation resistance value, $V_1$ is the first voltage-to-ground value, $V_2$ is the second voltage-to-ground value, $V_{in1}$ is the first input voltage value, $V_{in2}$ is the second input voltage value, $I_{RCD\_1}$ is the first residual current value, and $I_{RCD\_2}$ is the second residual current value.

In another implementation, the controller 103 determines a residual current compensation value based on an initial insulation resistance value at the input end of the power sourcing equipment 10, the first input voltage value, the first voltage-to-ground value, and the first residual current value; and determines the insulation resistance value at the input end of the power sourcing equipment 10 based on the residual current compensation value, the second input voltage value, the second voltage-to-ground value, and the second residual current value.

Specifically, when the first input end is the positive input end of the power sourcing equipment 10, the insulation resistance value at the input end of the power sourcing equipment 10 is as follows: $K = (2V_2 - V_{in2})/[2(I_{RCD\_2} + I_{RCD\_com})]$, where $I_{RCD\_com} = (2V_1 - V_{in1})/(2K_0) - I_{RCD\_1}$; or when the first input end is the negative input end of the power sourcing equipment 10, the insulation resistance value at the input end of the power sourcing equipment 10 is as follows: $K = (2V_2 + V_{in2})/[2(I_{RCD\_2} + I_{RCD\_com})]$, where $I_{RCD\_com} = (2V_1 + V_{in1})/(2K_0) - I_{RCD\_1}$, K is the insulation resistance value, $V_2$ is the second voltage-to-ground value, $V_{in2}$ is the second input voltage value, $I_{RCD\_2}$ is the second residual current value, $I_{RCD\_com}$ is the residual current compensation value, $V_1$ is the first voltage-to-ground value, $V_{in1}$ is the first input voltage value, $K_0$ is the initial insulation resistance value, and $I_{RCD\_1}$ is the first residual current value.

In this embodiment of this application, the power sourcing equipment 10 may compensate for or cancel an offset of an RCD based on residual current values and voltage parameters of the power sourcing equipment that are obtained by the power sourcing equipment 10 in two different operating statuses, to improve accuracy of detecting insulation resistance-to-ground at the input end of the power sourcing equipment 10. Therefore, applicability is high.

The foregoing power sourcing equipment 10 and the method for detecting insulation resistance at the input end of the power sourcing equipment 10 may be applied to the following scenarios.

In an optional embodiment, technical solutions of this application may be applied to a photovoltaic scenario. In this case, the power sourcing equipment 10 provided in this application may be a power conversion device connected to a string (corresponding to the direct current power supply 11) in a photovoltaic system. The string may be a photovoltaic string or an energy storage battery string. Each photovoltaic string may include a plurality of photovoltaic modules connected in series and/or in parallel. Each energy storage battery string may include a plurality of energy storage batteries connected in series and/or in parallel. For example, the power conversion device is a direct current-to-direct current converter (Direct current-to-Direct current converter, DC/DC converter), configured to perform direct current conversion on a direct current generated by a string connected to the power conversion device, supply a current obtained through direct current conversion to a direct current bus, and then convert, through inversion by using an inverter connected to the direct current bus, a direct current on the direct current bus into an alternating current that meets a requirement of power grid; or the power conversion device is an inverter, configured to convert a direct current generated by a string connected to the power conversion device into an alternating current that meets a requirement of a power grid.

An example in which the power sourcing equipment 10 is an inverter connected to a string is used below for description. The inverter detects a first residual current value when a voltage parameter includes a first preset voltage parameter, and detects a second residual current value when the voltage parameter includes a second preset voltage parameter, where the first preset voltage parameter and the second preset voltage parameter are different from each other. The inverter determines an insulation resistance-to-ground value (to be specific, an insulation resistance-to-ground value of the string, the inverter, and a connection cable between the string and the inverter) at an input end of the inverter based on the first preset voltage parameter, the first residual current value, the second preset voltage parameter, and the second residual current value. In the foregoing manner, an offset of an RCD may be compensated for or canceled based on residual current values and voltage parameters of the inverter that are obtained in two different operating statuses of the inverter, to improve accuracy of detecting insulation resistance-to-ground at the input end of the inverter. Therefore, applicability is high.

In another optional embodiment, technical solutions of this application may alternatively be applied to a battery charging/discharging scenario. In this case, the power sourcing equipment 10 provided in this application may be an electric device connected to an output end of an energy storage battery string (corresponding to the direct current power supply 11). An input end of the energy storage battery string is connected to a charging device. Each energy storage battery string may include a plurality of energy storage batteries connected in series and/or in parallel. The electric device may be an in-vehicle system or the like. The charging device may be a charging pile, a power grid, or the like. Further, a DC/DC converter may be further connected between the output end of the energy storage battery string and an input end of the electric device, and is configured to convert an output voltage of the energy storage battery string into a preset fixed voltage value, and output the preset fixed voltage value to the electric device. In this case, the power sourcing equipment provided in this application is the DC/DC converter.

An example in which the power sourcing equipment is a DC/DC converter connected to an energy storage battery string is used below for description. The DC/DC converter detects a first residual current value when a voltage parameter is a first preset voltage parameter, and detects a second residual current value when the voltage parameter is a second preset voltage parameter, where the first preset voltage parameter and the second preset voltage parameter are different from each other. The DC/DC converter determines an insulation resistance-to-ground value (to be specific, an insulation resistance-to-ground value of the energy storage battery string, the DC/DC converter, and a connection cable between the energy storage battery string and the DC/DC converter) at an input end of the DC/DC converter based on the first preset voltage parameter, the first residual current value, the second preset voltage parameter, and the second residual current value. In the foregoing manner, an offset of an RCD may be compensated for or canceled based on residual current values and voltage parameters of the DC/DC converter that are obtained in two different operating statuses of the DC/DC converter, to improve accuracy of detecting insulation resistance-to-ground at the input end of the DC/DC converter. Therefore, applicability is high.

The foregoing are merely non-exhaustive examples of application scenarios of the power sourcing equipment 10 and the method for detecting insulation resistance at the input end of the power sourcing equipment 10 in this application. An application scenario is not limited in this application.

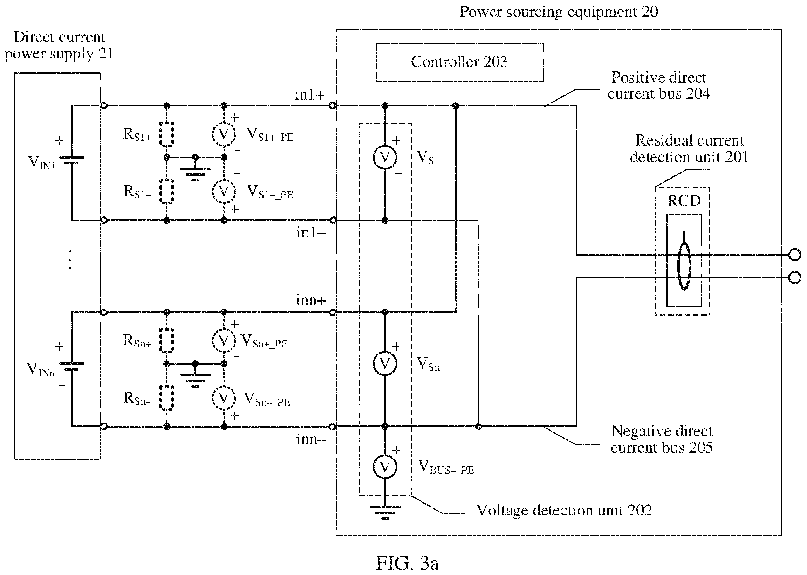

For example, FIG. 3a is a schematic diagram of another structure of power sourcing equipment according to this application. As shown in FIG. 3a, the power sourcing equipment 20 includes a residual current detection unit 201, a voltage detection unit 202, a controller 203, a positive direct current bus 204, and a negative direct current bus 205. The power sourcing equipment 20 includes n pairs of input ends, where n is an integer greater than or equal to 1. A positive input end in1+ of a first pair of input ends of the power sourcing equipment 20 is coupled to a positive output end of a direct current power supply $V_{IN1}$, and a negative input end inl- of the first pair of input ends of the power sourcing equipment 20 is coupled to a negative output end of the direct current power supply $V_{IN1}$; ...; and a positive input end inn+ of an $n^{th}$ pair of input ends of the power sourcing equipment 20 is coupled to a positive output end of a direct current power supply $V_{INn}$, and a negative input end inn- of the $n^{th}$ pair of input ends of the power sourcing equipment 20 is coupled to a negative output end of the direct current power supply $V_{INn}$. In addition, the positive input end in1+ of the first pair of input ends of the power sourcing equipment 20, ..., and the positive input end inn+ of the $n^{th}$ pair of input ends of the power sourcing equipment 20 are all coupled to the positive direct current bus 204 (namely, a common positive bus), and the negative input end in1- of the first pair of input ends of the power sourcing equipment 20, ..., and the negative input end inn+ of the $n^{th}$ pair of input ends of the power sourcing equipment 20 are all coupled to the negative direct current bus 205 (namely, a common negative bus). The positive direct current bus 204 and the negative direct current bus 205 are coupled to an output end of the power sourcing equipment 20 through the residual current detection unit 201.

In an implementation, the controller 203 may control an input voltage at each pair of input ends of the power sourcing equipment 20 to be a first input voltage value $V_{in1}$. To be specific, $V_{in1} = V_{S1} = \cdots = V_{Sn} = V_{IN1} = \cdots = V_{INn}$. When $V_{in1} = V_{S1} = \cdots = V_{Sn}$, the controller 203 obtains a voltage $V_{BUS\_PE}$ between the negative direct current bus 205 of the power sourcing equipment 20 and ground through the voltage detection unit 202, to obtain a first voltage-to-ground $V_1$. Because a negative input end of each pair of input ends of the power sourcing equipment 20 is coupled to the negative direct current bus 205, a voltage between the negative input end of each pair of input ends of the power sourcing equipment 20 and the ground is $V_1$. In addition, when $V_{in1} = V_{S1} = \cdots = V_{Sn}$, the controller 203 obtains a residual current of the power sourcing equipment 20 through the residual current detection unit 201, to obtain a first residual current value $I_{RCD\_1}$. Then the controller 203 may control an input voltage at each pair of input ends of the power sourcing equipment 20 to be a second input voltage value $V_{in2}$, where $V_{in2} \neq V_{in1}$. To be specific, $V_{in2} = V_{S1} = \cdots = V_{Sn} = V_{IN1} = \cdots = V_{INn}$. When $V_{in2} = V_{S1} = \cdots = V_{Sn}$, the controller 203 obtains a voltage $V_{BUS\_PE}$ between the negative direct current bus 205 of the power sourcing equipment 20 and the ground through the voltage detection unit 202, to obtain a second voltage-to-ground $V_2$. Because a negative input end of each pair of input ends of the power sourcing equipment 20 is coupled to the negative direct current bus 205, a voltage between the negative input end of each pair of input ends of the power sourcing equipment 20 and the ground is $V_2$. In addition, when $V_{in2} = V_{S1} = \cdots = V_{Sn}$, the controller 203 obtains a residual current of the power sourcing equipment 20 through the residual current detection unit 201, to obtain a second residual current value $I_{RCD\_2}$.

In another implementation, the controller 203 may control an input voltage at each pair of input ends of the power sourcing equipment 20 to be a first input voltage value $V_{in1}$. To be specific, $V_{in1} = V_{S1} = \cdots = V_{Sn} = V_{IN1} = \cdots = V_{INn}$. In addition, the controller 203 controls a voltage (corresponding to $V_{BUS\_PE}$) between the negative direct current bus 205 of the power sourcing equipment 20 and ground to be a first voltage-to-ground value $V_1$. Because a negative input end of each pair of input ends of the power sourcing equipment 20 is coupled to the negative direct current bus 205, a voltage between the negative input end of each pair of input ends of the power sourcing equipment 20 and the ground is also $V_1$. When $V_{Bus\_PE} = V_1$, the controller 203 obtains a residual current of the power sourcing equipment 20 through the residual current detection unit 201, to obtain a first residual current value $I_{RCD\_1}$. Then the controller 203 may control an input voltage at each pair of input ends of the power sourcing equipment 20 to be a second input voltage value $V_{in2}$, where $V_{in2} = V_{in1}$. To be specific, $V_{in2} = V_{in1} = V_{S1} = \cdots = V_{Sn} = V_{IN1} = \cdots = V_{INn}$. In addition, the controller 203 controls a voltage (corresponding to $V_{BUS\_PE}$) between the negative direct current bus 205 of the power sourcing equipment 20 and the ground to be a second voltage-to-ground value $V_2$, where $V_2 \neq V_1$. In addition, when $V_{Bus\_PE} = V_2$, the controller 203 obtains a residual current of the power sourcing equipment 20 through the residual current detection unit 201, to obtain a second residual current value $I_{RCD\_2}$.

In still another implementation, the controller 203 may control an input voltage at each pair of input ends of the power sourcing equipment 20 to be a first input voltage value $V_{in1}$. To be specific, $V_{in1} = V_{S1} = \cdots = V_{Sn} = V_{IN1} = \cdots = V_{INn}$. In addition, the controller 203 controls a voltage (corresponding to $V_{BUS\_PE}$) between the negative direct current bus 205 of the power sourcing equipment 20 and ground to be a first voltage-to-ground value $V_1$. Because a negative input end of each pair of input ends of the power sourcing equipment 20 is coupled to the negative direct current bus 205, a voltage between the negative input end of each pair of input ends of the power sourcing equipment 20 and the ground is also $V_1$. When $V_{in1} = V_{S1} = \cdots = V_{Sn}$ and $V_{Bus\_PE} = V_1$, the controller 203 obtains a residual current of the power sourcing equipment 20 through the residual current detection unit 201, to obtain a first residual current value $I_{RCD\_1}$. Then the controller 203 may control an input voltage at each pair of input ends of the power sourcing equipment 20 to be a second input voltage value $V_{in2}$. To be specific, $V_{in2} = V_{S1} = \cdots = V_{Sn} = V_{IN1} = \cdots = V_{INn}$. In addition, the controller 203 controls a voltage (corresponding to $V_{BUS\_PE}$) between the negative direct current bus 205 of the power sourcing equipment 20 and the ground to be a second voltage-to-ground value $V_2$. When $V_{in2} = V_{S1} = \cdots = V_{Sn}$ and $V_{BUS\_PE} = V_2$, the controller 203 obtains a residual current of the power sourcing equipment 20 through the residual current detection unit 201, to obtain a second residual current value $I_{RCD\_2}$. It should be noted that values of $V_{in1}$, $V_{in2}$, $V_1$, and $V_2$ may include the following cases: (1) $V_{in2} \neq V_{in1}$ and $V_2 = V_1$; and (2) $V_{in2} \neq V_{in1}$ and $V_2 \neq V_1$.

In an optional embodiment, the controller 203 determines, based on $V_{in1}$ and $V_1$, a voltage $V_{S1+\_PE} = \cdots = V_{Sn+\_PE} = V_{in1} + V_1$ between a positive input end of each pair of input ends of the power sourcing equipment 20 and the ground and a voltage $V_{S1-\_PE} = \cdots = V_{Sn-\_PE} = V_1$ between a negative input end of each pair of input ends and the ground when the residual current detection unit 201 detects that the residual current of the power sourcing equipment 20 is $I_{RCD\_1}$. Considering that an RCD has an offset $I_{RCD\_set}$, the controller 203 substitutes $V_{S1+\_PE} = \cdots = V_{Sn+\_PE} = V_{in1} + V_1$, $V_{S1-\_PE} = \cdots = V_{Sn-\_PE} = V_1$, and $I_{RCD} = I_{RCD\_1}$ into a formula $I_{RCD} = V_{S1+\_PE}/R_{S1+} + \cdots + V_{Sn+\_PE}/R_{Sn+} + V_{S1-\_PE}/R_{S1-} + \cdots + V_{Sn-\_PE}/R_{Sn-} + I_{RCD\_set}$ to obtain an equation 1:

$$I_{RCD\_1} = \left(V_{in1} + V_1\right) * \left(1/R_{S1+} + \cdots + 1/R_{Sn+}\right) + V_1 * \left(1/R_{S1-} + \cdots + 1/R_{Sn-}\right) + I_{RCD\_set}.$$

The controller 203 determines, based on $V_{in2}$ and $V_2$, a voltage $V_{S1+\_PE} = \cdots = V_{Sn+\_PE} = V_{in2} + V_2$ between a positive input end of each pair of input ends of the power sourcing equipment 20 and the ground and a voltage $V_{S1-\_PE} = \cdots = V_{Sn-\_PE} = V_2$ between a negative input end of each pair of input ends and the ground when the residual current detection unit 201 detects that the residual current of the power sourcing equipment 20 is $I_{RCD\_2}$. Considering that an RCD has an offset $I_{RCD\_set}$, the controller 203 substitutes $V_{S1+\_PE} = \cdots = V_{Sn+\_PE} = V_{in2} + V_2$, $V_{S1-\_PE} = \cdots = V_{Sn-\_PE} = V_2$, and $I_{RCD} = I_{RCD\_2}$ into a formula $I_{RCD} = V_{S1+\_PE}/R_{S1+} + \cdots + V_{Sn+\_PE}/R_{Sn+} + V_{S1-\_PE}/R_{S1-} + \cdots + V_{Sn-\_PE}/R_{Sn-} + I_{RCD\_set}$ to obtain an equation 2:

$$I_{RCD\_2} = \left(V_{in2} + V_2\right) * \left(1/R_{S1+} + \cdots + 1/R_{Sn+}\right) + V_2 * \left(1/R_{S1-} + \cdots + 1/R_{Sn-}\right) + I_{RCD\_set}.$$

In a normal case, an insulation resistance-to-ground value at a positive input end of power sourcing equipment is equal to or approximately equal to an insulation resistance-to-ground value at a negative input end of the same power sourcing equipment. Therefore, $1/R_{S1+} + \cdots + 1/R_{Sn+} = 1/R_{S1-} + \cdots + 1/R_{Sn-} = 1/(2K)$, where K is an insulation resistance-to-ground value at the input end of the power sourcing equipment 20, to be specific, an insulation resistance-to-ground value of the direct current power supply 21, the power sourcing equipment 20, and the connection cable between the direct current power supply 21 and the power sourcing equipment 20. The controller 203 first substitutes $1/R_{S1+} + \cdots + 1/R_{Sn+} = 1/R_{S1-} + \cdots + 1/R_{Sn-} = 1/(2K)$ into the equation 1 and the equation 2 to obtain an equation 3 $I_{RCD\_1} = (V_{in1} + V_1)/(2K) + V_1/(2K) + I_{RCD\_set}$ and an equation 4 $I_{RCD\_2} = (V_{in2} + V_2)/(2K) + V_2/(2K) + I_{RCD\_set}$ respectively, and then subtracts the equation 4 from the equation 3 (that is, cancels $I_{RCD\_set}$) to obtain the following:

$$K = \left[ 2\left(V_1 - V_2\right) + V_{in1} - V_{in2} \right] / \left[ 2\left(I_{RCD\_1} - I_{RCD\_2}\right) \right].$$

In this embodiment of this application, when calculating the insulation resistance-to-ground value at the input end of the power sourcing equipment 20, the power sourcing equipment 20 considers the offset of the RCD, and cancels the offset of the RCD based on residual current values and voltage parameter values of the power sourcing equipment 20 that are obtained by the power sourcing equipment 20 in two different operating statuses, to improve accuracy of detecting insulation resistance-to-ground at the input end of the power sourcing equipment 20. Therefore, applicability is high. In addition, in this application, an existing circuit (to be specific, the residual current detection unit 201, the voltage detection unit 202, and the controller 203) in the power sourcing equipment 20 is used to detect insulation resistance-to-ground at the input end of the power sourcing equipment 20. Therefore, circuit or device costs do not need to be additionally increased.

Based on the power sourcing equipment 20 shown in FIG. 3a, this application further provides a method for detecting insulation resistance at an input end of power sourcing equipment. The method includes the following step: When the first input end is the negative input end of each pair of input ends of the power sourcing equipment 20, the power sourcing equipment 20 calculates the insulation resistance-to-ground value at the input end of the power sourcing equipment 20 as follows:

$$K = \left[ 2\left(V_1 - V_2\right) + V_{in1} - V_{in2} \right] / \left[ 2\left(I_{RCD\_1} - I_{RCD\_2}\right) \right].$$

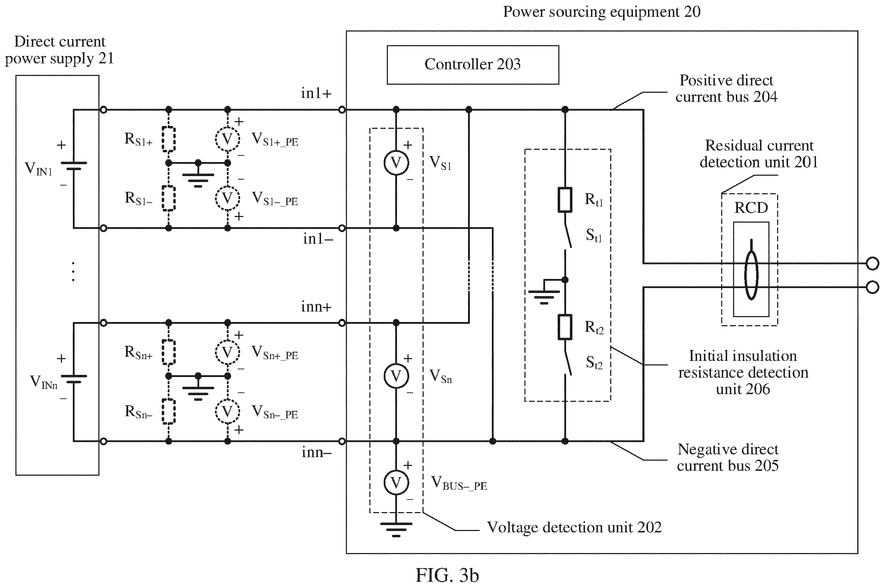

Further, the power sourcing equipment shown in FIG. 3a may further include an initial insulation resistance detection unit 206. For details, refer to a schematic diagram of another structure of the power sourcing equipment shown in FIG. 3b. As shown in FIG. 3b, the initial insulation resistance detection unit 206 is coupled between the positive direct current bus 204 and the negative direct current bus 205, and is configured to detect an initial insulation resistance value at the input end of the power sourcing equipment 20. In addition, the initial insulation resistance detection unit 206 includes a resistor $R_{t1}$ and a controllable switch $S_{\varepsilon i}$ that are connected in series between a positive output end of each direct current power supply of the direct current power supply 21 and the ground, and a resistor $R_{t2}$ and a controllable switch $S_{t2}$ that are connected in series between a negative output end of each direct current power supply and the ground.

In an optional embodiment, before the power sourcing equipment 20 is started, the controller 203 controls the controllable switch $S_{\varepsilon i}$ to be turned on and $S_{t2}$ to be turned off, where in this case, $R_{S1+}, ..., $ and $R_{Sn+}$ are connected to $R_{t1}$ in parallel, and $R_{S1-}, ..., $ and $R_{Sn-}$ are connected in parallel; and obtains a voltage $V_{BUS-\_PE1}$ between the negative direct current bus 205 and the ground and a voltage $V_{BUS+\_PE1}$ between the positive direct current bus 204 and the ground when the controllable switch $S_{\varepsilon i}$ is turned on and $S_{t2}$ is turned off. In addition, the controller 203 controls the controllable switch $S_{t1}$ to be turned off and $S_{t2}$ to be turned on, where in this case, $R_{S1+}, ..., $ and $R_{Sn+}$ are connected in parallel, and $R_{S1-}, ..., $ and $R_{Sn-}$ are connected to $R_{t2}$ in parallel; obtains a voltage $V_{BUS-\_PE2}$ between the negative direct current bus 205 and the ground and a voltage $V_{BUS+\_PE2}$ between the positive direct current bus 204 and the ground when the controllable switch $S_{\varepsilon i}$ is turned off and $S_{t2}$ is turned on; then obtains simultaneous equations based on that a current value on a resistor $(R_{S1+}//...// R_{Sn+}//R_{t1})$ is equal to a current value on a resistor $(R_{S1-}//...//R_{Sn-})$ when $S_{t1}$ is turned on and $S_{t2}$ is turned off and that a current value on the resistor $(R_{S1-}//...//R_{Sn-}//R_{t2})$ is equal to a current value on the resistor $(R_{S1+}//...//R_{Sn+})$ when $S_{t1}$ is turned off and $S_{t2}$ is turned on; and finally calculates the initial insulation resistance value $K_0$ at the input end of the power sourcing equipment 20. To be specific, the initial insulation resistance-to-ground value is as follows: $K_0 = 1/(1/R_{S1+} + \cdots + 1/R_{Sn+} + 1/R_{S1-} + \cdots + 1/R_{Sn-})$. In a normal case, an insulation resistance-to-ground value at a positive output end of a power supply is equal to or approximately equal to an insulation resistance-to-ground value at a negative output end of the same power supply. Therefore, $1/(1/R_{S1+} + \cdots + 1/R_{Sn+}) = 1/(1/R_{S1-} + \cdots + 1/R_{Sn-}) = 2K_0$.

Then the controller 203 may obtain $V_{in1}$, $V_1$, and $I_{RCD\_1}$ in the three manners in the embodiment shown in FIG. 3a. Details are not described herein again. The controller 203 determines, based on $V_{in1}$ and $V_1$, a voltage $V_{S1+\_PE} = \cdots = V_{Sn+\_PE} = V_{in1} + V_1$ between a positive input end of each pair of input ends of the power sourcing equipment 20 and the ground and a voltage $V_{S1-\_PE} = \cdots = V_{Sn-\_PE} = V_1$ between a negative input end of each pair of input ends and the ground when the residual current detection unit 201 detects that the residual current of the power sourcing equipment 20 is $I_{RCD\_1}$. Because short time has elapsed since startup of the power sourcing equipment 20, insulation resistance in the direct current power supply 21 or the power sourcing equipment 20 has not changed. In this case, $V_{S1+\_PE} = \cdots = V_{Sn+\_PE} = V_{in1} + V_1$, $V_{S1-\_PE} = \cdots = V_{Sn-\_PE} = V_1$, and $1/(1/R_{S1+} + \cdots + 1/R_{Sn+}) = 1/(1/R_{S1-} + \cdots + 1/R_{Sn-}) = 2K_0$ are substituted into a formula $I_{RCD\_ref} = V_{S1+\_PE}/R_{S1+} + \cdots + V_{Sn+\_PE}/R_{Sn+} + V_{S1-\_PE}/R_{S1-} + \cdots + V_{Sn-\_PE}/R_{Sn-}$ to calculate a reference residual current value of the power sourcing equipment 20: $I_{RCD\_ref} = (V_{in1}+V_1)/(2K_0) + V_1/(2K_0)$. To cancel the offset of the RCD, the controller 203 calculates a difference between $I_{RCD\_ref}$ and $I_{RCD\_1}$ to obtain a residual current compensation value $I_{RCD\_com}$. To be specific, $I_{RCD\_com} = I_{RCD\_ref} - I_{RCD\_1} = (2V_1 + V_{in1})/(2K_0) - I_{RCD\_1}$.

Then the controller 203 may obtain $V_{in2}$, $V_2$, and $I_{RCD\_2}$ in the three manners in the embodiment shown in FIG. 3a. Details are not described herein again. The controller 203 determines, based on $V_{in2}$ and $V_2$, a voltage $V_{S1+\_PE} = \cdots = V_{Sn+\_PE} = V_{in2} + V_2$ between a positive input end of each pair of input ends of the power sourcing equipment 20 and the ground and a voltage $V_{S1-\_PE} = \cdots = V_{Sn-\_PE} = V_2$ between a negative input end of each pair of input ends and the ground when the residual current detection unit 201 detects that the residual current of the power sourcing equipment 20 is $I_{RCD\_2}$. To cancel the offset of the RCD, the controller 203 substitutes $V_{S1+\_PE} = \cdots = V_{Sn+\_PE} = V_{in2}+V_2$, $V_{S1-\_PE} = \cdots = V_{Sn-\_PE} = V_2$, $I_{RCD} = I_{RCD\_2}$, and $1/(1/R_{S1+} + \cdots + 1/R_{Sn+}) = 1/(1/R_{S1-} + \cdots + 1/R_{Sn-}) = 2K$ into a formula $I_{RCD} + I_{RCD\_com} = V_{S1+\_PE}/R_{S1+} + \cdots + V_{Sn+\_PE}/R_{Sn+} + V_{S1-\_PE}/R_{S1-} + \cdots + V_{Sn-\_PE}/R_{Sn-}$ to calculate the insulation resistance-to-ground value at the input end of the power sourcing equipment 20 as follows: $K = (2V_2 + V_{in2})/[2(I_{RCD\_2} + I_{RCD\_com})]$.

In this embodiment of this application, the power sourcing equipment 20 may calculate the residual current compensation value based on the initial insulation resistance-to-ground value at the input end of the power sourcing equipment 20 that is detected by the initial insulation resistance detection unit 206, and cancel the offset of the RCD based on the residual current compensation value, to improve accuracy of detecting insulation resistance-to-ground of the direct current power supply 21. Therefore, applicability is high. In addition, in this application, an existing circuit (to be specific, the residual current detection unit 201, the voltage detection unit 202, the controller 203, and the initial insulation resistance detection unit 206) in the power sourcing equipment 20 is used to detect insulation resistance-to-ground at the input end of the power sourcing equipment 20. Therefore, circuit or device costs do not need to be additionally increased.

Based on the power sourcing equipment 20 shown in FIG. 3b, this application further provides a method for detecting insulation resistance at an input end of power sourcing equipment. The method includes the following step: When the first input end is the negative input end of each pair of input ends of the power sourcing equipment 20, the power sourcing equipment 20 calculates the residual current compensation value as follows: $I_{RCD\_com} = (2V_1 + V_{in1})/(2K_0) - I_{RCD\_1}$; and then calculates the insulation resistance-to-ground value of the direct current power supply 21 as follows:

$$K = \left(2V_2 + V_{in2}\right) \Big/ \left[ 2\left(I_{RCD\_2} + I_{RCD\_com}\right)\right].$$

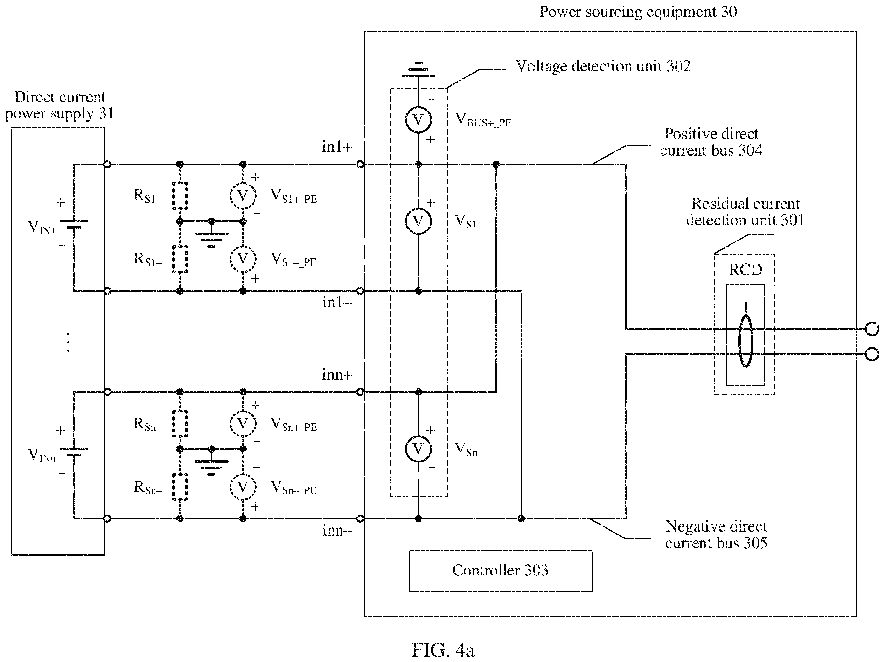

For example, FIG. 4a is a schematic diagram of another structure of power sourcing equipment according to this application. As shown in FIG. 4a, the power sourcing equipment 30 includes a residual current detection unit 301, a voltage detection unit 302, a controller 303, a positive direct current bus 304, and a negative direct current bus 305. The power sourcing equipment 30 includes n pairs of input ends, where n is an integer greater than or equal to 1. A positive input end in1+ of a first pair of input ends of the power sourcing equipment 30 is coupled to a positive output end of a direct current power supply $V_{IN1}$, and a negative input end in1- of the first pair of input ends of the power sourcing equipment 30 is coupled to a negative output end of the direct current power supply $V_{IN1}$; ...; and a positive input end inn+ of an $n^{th}$ pair of input ends of the power sourcing equipment 30 is coupled to a positive output end of a direct current power supply $V_{INn}$, and a negative input end inn- of the $n^{th}$ pair of input ends of the power sourcing equipment 30 is coupled to a negative output end of the direct current power supply $V_{INn}$. In addition, the positive input end in1+ of the first pair of input ends of the power sourcing equipment 30, ..., and the positive input end inn+ of the $n^{th}$ pair of input ends of the power sourcing equipment 30 are all coupled to the positive direct current bus 304 (namely, a common positive bus), and the negative input end in1- of the first pair of input ends of the power sourcing equipment 30, ..., and the negative input end inn+ of the $n^{th}$ pair of input ends of the power sourcing equipment 30 are all coupled to the negative direct current bus 305 (namely, a common negative bus). The positive direct current bus 304 and the negative direct current bus 305 are coupled to an output end of the power sourcing equipment 30 through the residual current detection unit 301.

In an implementation, the controller 303 may control an input voltage at each pair of input ends of the power sourcing equipment 30 to be a first input voltage value $V_{in1}$. To be specific, $V_{in1} = V_{S1} = \cdots = V_{Sn} = V_{IN1} = \cdots = V_{INR}$. When $V_{in1} = V_{S1} = \cdots = V_{Sn}$ the controller 303 obtains a voltage $V_{BUS+\_PE}$ between the positive direct current bus 304 of the power sourcing equipment 30 and ground through the voltage detection unit 302, to obtain a first voltage-to-ground $V_1$. Because a positive input end of each pair of input ends of the power sourcing equipment 30 is coupled to the positive direct current bus 304, a voltage between the positive input end of each pair of input ends of the power sourcing equipment 30 and the ground is $V_1$. In addition, when $V_{in1} = V_{S1} = \cdots = V_{Sn}$, the controller 303 obtains a residual current of the power sourcing equipment 30 through the residual current detection unit 301, to obtain a first residual current value $I_{RCD\_1}$. Then the controller 303 may control an input voltage at each pair of input ends of the power sourcing equipment 30 to be a second input voltage value $V_{in2}$, where $V_{in2} \neq V_{in1}$. To be specific, $V_{in2} = V_{S1} = \cdots = V_{Sn} = V_{IN1} = \cdots = V_{INn}$. When $V_{in2} = V_{S1} = \cdots = V_{Sn}$, the controller 303 obtains a voltage $V_{BUS+\_PE}$ between the positive direct current bus 304 of the power sourcing equipment 30 and ground through the voltage detection unit 302, to obtain a second voltage-to-ground $V_2$. Because a positive input end of each pair of input ends of the power sourcing equipment 20 is coupled to the positive direct current bus 304, a voltage between the positive input end of each pair of input ends of the power sourcing equipment 30 and the ground is $V_2$. In addition, when $V_{in2} = V_{S1} = \cdots = V_{Sn}$, the controller 303 obtains a residual current of the power sourcing equipment 30 through the residual current detection unit 301, to obtain a second residual current value $I_{RCD\_2}$.

In another implementation, the controller 303 may control an input voltage at each pair of input ends of the power sourcing equipment 30 to be a first input voltage value $V_{in1}$. To be specific, $V_{in1} = V_{S1} = \cdots = V_{Sn} = V_{IN1} = \cdots = V_{INn}$. In addition, the controller 303 controls a voltage (corresponding to $V_{BUS+\_PE}$) between the positive direct current bus 304 of the power sourcing equipment 30 and ground to be a first voltage-to-ground value $V_1$. Because a positive input end of each pair of input ends of the power sourcing equipment 30 is coupled to the positive direct current bus 304, a voltage between the positive input end of each pair of input ends of the power sourcing equipment 30 and the ground is also $V_1$. When $V_{BUS+\_PE} = V_1$, the controller 303 obtains a residual current of the power sourcing equipment 30 through the residual current detection unit 301, to obtain a first residual current value $I_{RCD\_1}$. Then the controller 303 may control an input voltage at each pair of input ends of the power sourcing equipment 30 to be a second input voltage value $V_{in2}$, where $V_{in2} = V_{in1}$. To be specific, $X_{in2} = V_{in1} = V_{S1} = \cdots = V_{Sn} = V_{IN1} = \cdots = V_{INn}$. In addition, the controller 303 controls a voltage (corresponding to $V_{BUS+\_PE}$) between the positive direct current bus 304 of the power sourcing equipment 30 and the ground to be a second voltage-to-ground value $V_2$, where $V_2 \neq V_1$. In addition, when $V_{BUS+\_PE} = V_2$, the controller 303 obtains a residual current of the power sourcing equipment 30 through the residual current detection unit 301, to obtain a second residual current value $I_{RCD\_2}$.

In still another implementation, the controller 303 may control an input voltage at each pair of input ends of the power sourcing equipment 30 to be a first input voltage value $V_{in1}$. To be specific, $V_{in1} = V_{S1} = \cdots = V_{Sn} = V_{IN1} = \cdots = V_{INn}$. In addition, the controller 303 controls a voltage (corresponding to $V_{BUS+\_PE}$) between the positive direct current bus 304 of the power sourcing equipment 30 and ground to be a first voltage-to-ground value $V_1$. Because a positive input end of each pair of input ends of the power sourcing equipment 30 is coupled to the positive direct current bus 304, a voltage between the positive input end of each pair of input ends of the power sourcing equipment 30 and the ground is also $V_1$. When $V_{in1} = V_{S1} = \cdots = V_{Sn}$ and $V_{BUS+\_PE} = V_1$, the controller 303 obtains a residual current of the power sourcing equipment 30 through the residual current detection unit 301, to obtain a first residual current value $I_{RCD\_1}$. Then the controller 303 may control an input voltage at each pair of input ends of the power sourcing equipment 30 to be a second input voltage value $V_{in2}$. To be specific, $V_{in2} = V_{S1} = \cdots = V_{Sn} = V_{IN1} = \cdots = V_{INn}$. In addition, the controller 303 controls a voltage (corresponding to $V_{BUS+\_PE}$) between the positive direct current bus 304 of the power sourcing equipment 30 and the ground to be a second voltage-to-ground value $V_2$. When $V_{in2} = V_{S1} = \cdots = V_{Sn}$ and $V_{BUS+\_PE} = V_2$, the controller 303 obtains a residual current of the power sourcing equipment 30 through the residual current detection unit 301, to obtain a second residual current value $I_{RCD\_2}$. It should be noted that values of $V_{in1}$, $V_{in2}$, $V_1$, and $V_2$ may include the following cases: (1) $Y_{in2} \neq V_{in1}$ and $V_2 = V_1$; and (2) $V_{in2} \neq V_{in1}$ and $V_2 \neq V_1$.

In an optional embodiment, the controller 303 determines, based on $V_{in1}$ and $V_1$, a voltage $V_{S1+\_PE} = \cdots = V_{Sn+\_PE} = V_1$ between a positive input end of each pair of input ends of the power sourcing equipment 30 and the ground and a voltage $V_{S1-\_PE} = \cdots = V_{Sn-\_PE} = V_1 - V_{in1}$ between a negative input end of each pair of input ends and the ground when the residual current detection unit 301 detects that the residual current of the power sourcing equipment 30 is $I_{RCD\_1}$. Considering that an RCD has an offset $I_{RCD\_set}$, the controller 303 substitutes $V_{S1+\_PE} = \cdots = V_{Sn+\_PE} = V_1$, $V_{S1-\_PE} = \cdots = V_{Sn-\_PE} = V_1 - V_{in1}$, and $I_{RCD} - I_{RCD\_1}$ into a formula $I_{RCD} = V_{S1+\_PE}/R_{S1+} + \cdots + V_{Sn+\_PE}/R_{Sn+} + V_{S1-\_PE}/R_{S1\_} + \cdots + V_{Sn-\_PE}/R_{Sn-} + I_{RCD\_set}$ to obtain an equation 1:

$$I_{RCD\_1} = V_1 * \left(1/R_{S1+} + \cdots + 1/R_{Sn+}\right) + \left(V_1 - V_{in1}\right) * \left(1/R_{S1-} + \cdots + 1/R_{Sn-}\right) + I_{RCD\_set}.$$

The controller 303 determines, based on $V_{in2}$ and $V_2$, a voltage $V_{S1+\_PE} = \cdots = V_{Sn+\_PE} = V_2$ between each pair of positive input ends of the power sourcing equipment 30 and the ground and a voltage $V_{S1\_PE} = \cdots = V_{Sn-\_PE} = V_2 - V_{in2}$ between a negative input end of each pair of input ends and the ground when the residual current detection unit 301 detects that the residual current of the power sourcing equipment 30 is $I_{RCD\_2}$. Considering that an RCD has an offset $I_{RCD\_set}$, the controller 303 substitutes $V_{S1+\_PE} = \cdots = V_{Sn+\_PE} = V_2$, $V_{S1-\_PE} = \cdots = V_{Sn-\_PE} = V_2 - V_{in2}$, and $I_{RCD} = I_{RCD\_2}$ into a formula $I_{RCD} = V_{S1+\_PE}/R_{S1+} + \cdots + V_{Sn+\_PE}/R_{Sn+} + V_{S1-\_PE}/R_{S1-} + \cdots + V_{Sn-\_PE}/R_{Sn-} + I_{RCD\_set}$ to obtain an equation 2:

$$I_{RCD\_2} = V_2 * \left(1/R_{S1+} + \cdots + 1/R_{Sn+}\right) + \left(V_2 - V_{in2}\right) * \left(1/R_{S1-} + \cdots + 1/R_{Sn-}\right) + I_{RCD\_set}.$$

In a normal case, an insulation resistance-to-ground value at a positive input end of power sourcing equipment is equal to or approximately equal to an insulation resistance-to-ground value at a negative input end of the same power sourcing equipment. Therefore, $1/R_{S1+} + ... + 1/R_{Sn+} = 1/R_{S1-} + \cdots + 1/R_{Sn-} = 1/(2K)$, where K is an insulation resistance-to-ground value at the input end of the power sourcing equipment 30, to be specific, an insulation resistance-to-ground value of the direct current power supply 31, the power sourcing equipment 30, and the connection cable between the direct current power supply 31 and the power sourcing equipment 30. The controller 303 first substitutes $1/R_{S1+} + \cdots + 1/R_{Sn+} = 1/R_{S1} + \cdots + 1/R_{Sn-} = 1/(2K)$ into the equation 1 and the equation 2 to obtain an equation 3 $I_{RCD\_1} = V_1/(2K) + (V_1 - V_{in1})/(2k) + I_{RCD\_set}$ and an equation 4 $I_{RCD\_2} = V_2/(2K) + (V_2 - V_{in2})/(2K) + I_{RCD\_set}$ respectively, and then subtracts the equation 4 from the equation 3 (that is, cancels $I_{RCD\_set}$) to obtain the following:

$$K = \left[ 2\left(V_1 - V_2\right) - V_{in1} + V_{in2} \right] \Big/ \left[ 2\left(I_{RCD\_1} - I_{RCD\_2}\right) \right].$$

In this embodiment of this application, when calculating the insulation resistance-to-ground value at the input end of the power sourcing equipment 30, the power sourcing equipment 30 considers the offset of the RCD, and cancels the offset of the RCD based on residual current values and voltage parameter values of the power sourcing equipment 30 that are obtained by the power sourcing equipment 30 in two different operating statuses, to improve accuracy of detecting insulation resistance-to-ground at the input end of the power sourcing equipment 30. Therefore, applicability is high. In addition, in this application, an existing circuit (to be specific, the residual current detection unit 301, the voltage detection unit 302, and the controller 303) in the power sourcing equipment 30 is used to detect insulation resistance-to-ground at the input end of the power sourcing equipment 30. Therefore, circuit or device costs do not need to be additionally increased.

Based on the power sourcing equipment 30 shown in FIG. 4a, this application further provides a method for detecting insulation resistance at an input end of power sourcing equipment. The method includes the following step: When the first input end is the positive input end of each pair of input ends of the power sourcing equipment 30, the power sourcing equipment 30 calculates the insulation resistance-to-ground value at the input end of the power sourcing equipment 30 as follows:

$$K = \left[ 2\left(V_1 - V_2\right) - V_{in1} + V_{in2} \right] \Big/ \left[ 2\left(I_{RCD\_1} - I_{RCD\_2}\right) \right].$$

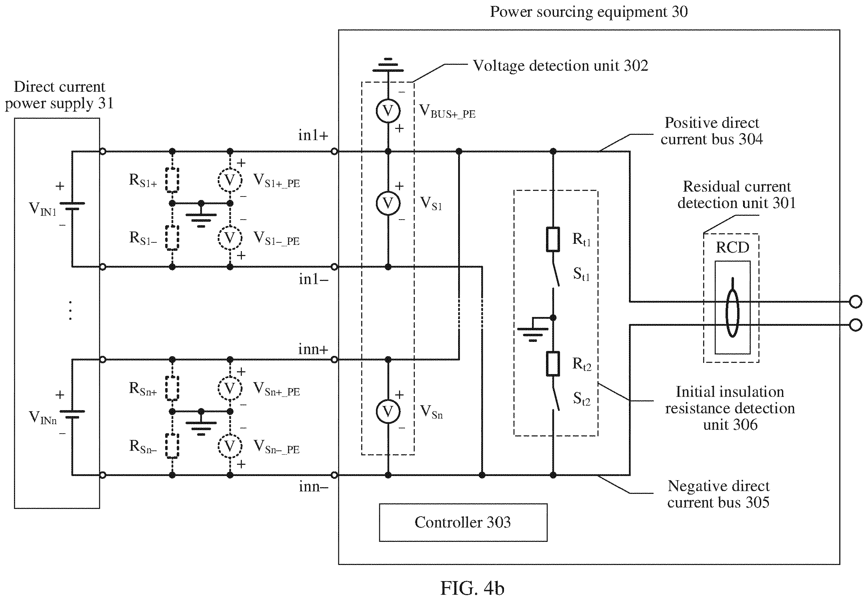

Further, the power sourcing equipment shown in FIG. 4a may further include an initial insulation resistance detection unit 306. For details, refer to a schematic diagram of another structure of the power sourcing equipment shown in FIG. 4b. As shown in FIG. 4b, the initial insulation resistance detection unit 306 is coupled between the positive direct current bus 304 and the negative direct current bus 305, and is configured to detect an initial insulation resistance value at the input end of the power sourcing equipment 30. In addition, the initial insulation resistance detection unit 306 includes a resistor $R_{t1}$ and a controllable switch $S_{t1}$ that are connected in series between a positive output end of each direct current power supply of the direct current power supply 31 and the ground, and a resistor $R_{t2}$ and a controllable switch $S_{t2}$ that are connected in series between a negative output end of each direct current power supply and the ground.

In an optional embodiment, before the power sourcing equipment 30 is started, the controller 303 controls the controllable switch $S_{t1}$ to be turned on and $S_{t2}$ to be turned off, where in this case, $R_{S1+}$, ..., and $R_{Sn+}$ are connected to $R_{t1}$ in parallel, and $R_{S1-}$, ..., and $R_{Sn-}$ are connected in parallel; and obtains a voltage $V_{BUS-\_PE1}$ between the negative direct current bus 305 and the ground and a voltage $V_{BUS+\_PE1}$ between the positive direct current bus 304 and the ground when the controllable switch $S_{t1}$ is turned on and $S_{t2}$ is turned off. In addition, the controller 303 controls the controllable switch $S_{t1}$ to be turned off and $S_{t2}$ to be turned on, where in this case, $R_{S1+}$, ..., and $R_{Sn+}$ are connected in parallel, and $R_{S1-}$, ..., and $R_{Sn-}$ are connected to $R_{t2}$ in parallel; obtains a voltage $V_{BUS-\_PE2}$ between the negative direct current bus 305 and the ground and a voltage $V_{BUS+\_PE2}$ between the positive direct current bus 304 and the ground when the controllable switch $S_{t1}$ is turned off and $S_{t2}$ is turned on; then obtains simultaneous equations based on that a current value on a resistor ($R_{S1+}//...//R_{Sn+}//R_{t1}$) is equal to a current value on a resistor ($R_{S1-}//...//R_{Sn-}$) when $S_{t1}$ is turned on and $S_{t2}$ is turned off and that a current value on the resistor ($R_{S1-}//...//R_{Sn-}//R_{t2}$) is equal to a current value on the resistor ($R_{S1+}//...//R_{Sn+}$) when $S_{t1}$ is turned off and $S_{t2}$ is turned on; and finally calculates the initial insulation

resistance value $K_0$ at the input end of the power sourcing equipment 30. To be specific, the initial insulation resistance-to-ground value is as follows: $K_0 = 1/(I/R_{S1+} + \cdots + 1/R_{Sn+} + 1/R_{S1\_} + \cdots + 1/R_{Sn\_})$. In a normal case, an insulation resistance-to-ground value at a positive output end of a power supply is equal to or approximately equal to an insulation resistance-to-ground value at a negative output end of the same power supply. Therefore, $1/(1/R_{S1+} + \cdots + 1/R_{Sn+}) = 1/(1/R_{S1\_} + \cdots + 1/R_{Sn-}) = 2K_0$.

Then the controller 303 may obtain $V_{in1}$, $V_1$, and $I_{RCD\_1}$ in the three manners in the embodiment shown in FIG. 4a. Details are not described herein again. The controller 303 determines, based on $V_{in1}$ and $V_1$, a voltage $V_{S1+\_PE} = \cdots = V_{Sn+\_PE} = V_1$ between a positive input end of each pair of input ends of the power sourcing equipment 30 and the ground and a voltage $V_{S1-\_PE} = \cdots = V_{Sn-\_PE} = V_1 - V_{in1}$ between a negative input end of each pair of input ends and the ground when the residual current detection unit 301 detects that the residual current of the power sourcing equipment 30 is $I_{RCD\_1}$. Because short time has elapsed since startup of the power sourcing equipment 30, insulation resistance in the direct current power supply 31 or the power sourcing equipment 30 has not changed. In this case, $V_{S1+\_PE} = \cdots = V_{Sn+\_PE} = V_1$, $V_{S1-\_PE} = \cdots = V_{Sn-\_PE} = V_1 - V_{in1}$ and $1/(1/R_{S1+} + \cdots + 1/R_{Sn+}) = 1/(1/R_{S1\_} + \cdots + 1/R_{Sn-}) = 2K_0$ are substituted into a formula $I_{RCD\_ref} = V_{S1\_PE}/R_{S1+} + \cdots + V_{Sn+\_PE}/R_{Sn+} + V_{S1-\_PE}/R_{S1\_} + \cdots + V_{Sn-\_PE}/R_{Sn-}$ to calculate a reference residual current value of the power sourcing equipment 30 when the residual current of the power sourcing equipment 30 is $I_{RCD\_1}$: $I_{RCD\_ref} = V_1/(2K_0) + (V_1 - V_{in1})/(2K_0)$. To cancel the offset of the RCD, the controller 203 calculates a difference between $I_{RCD\_ref}$ and $I_{RCD\_1}$ to obtain a residual current compensation value $I_{RCD\_com}$. To be specific, $I_{RCD\_com} = I_{RCD\_ref} - I_{RCD\_1} = (2V_1 - V_{in1})/(2K_0) - I_{RCD\_1}$

Then the controller 303 may obtain $V_{in2}$, $V_2$, and $I_{RCD\_2}$ in the three manners in the embodiment shown in FIG. 4a. Details are not described herein again. The controller 303 determines, based on $V_{in2}$ and $V_2$, a voltage $V_{S1+\_PE} = \cdots = V_{Sn+\_PE} = V_2$ between a positive input end of each pair of input ends of the power sourcing equipment 30 and the ground and a voltage $V_{S1-\_PE} = \cdots = V_{Sn-\_PE} = V_2 - V_{in2}$ between a negative input end of each pair of input ends and the ground when the residual current detection unit 301 detects that the residual current of the power sourcing equipment 30 is $I_{RCD\_2}$. To cancel the offset of the RCD, the controller 303 substitutes $V_{S1+\_PE} = \cdots = V_{Sn+\_PE} = V_2$, $V_{S1-\_PE} = \cdots = V_{Sn-\_PE} = V_2 - V_{in2}$, $I_{RCD} = I_{RCD\_2}$, and $1/(1/R_{S1+} + \cdots + 1/R_{Sn+}) = 1/(1/R_{S1-} + \cdots + 1/R_{Sn-}) = 2K$ into a formula $I_{RCD} + I_{RCD\_com} = V_{S1+\_PE}/R_{S1+} + \cdots + V_{Sn+\_PE}/R_{Sn+} + V_{S1-\_PE}/R_{S1-} + \cdots + V_{Sn-\_PE}/R_{Sn-}$ to calculate the insulation resistance-to-ground value at the input end of the power sourcing equipment 30 as follows: $K = (2V_2 - V_{in2})/[2 (I_{RCD-2} + I_{RCD-com})]$.

In this embodiment of this application, the power sourcing equipment 30 may calculate the residual current compensation value based on the initial insulation resistance-to-ground value at the input end of the power sourcing equipment 30 that is detected by the initial insulation resistance detection unit 306, and cancel the offset of the RCD based on the residual current compensation value, to improve accuracy of detecting insulation resistance-to-ground at the input end of the power sourcing equipment 30. Therefore, applicability is high. In addition, in this application, an existing circuit (to be specific, the residual current detection unit 301, the voltage detection unit 302, the controller 303, and the initial insulation resistance detection unit 306) in the power sourcing equipment 30 is used to detect insulation resistance-to-ground at the input end of the power sourcing equipment 30. Therefore, circuit or device costs do not need to be additionally increased.

Based on the power sourcing equipment 30 shown in FIG. 4b, this application further provides a method for detecting insulation resistance at an input end of power sourcing equipment. The method includes the following step: When the first input end is the positive input end of each pair of input ends of the power sourcing equipment 30, the power sourcing equipment 30 calculates the residual current compensation value as follows: $I_{RCD\_com} = (2V_1 - V_{in1})/(2K_0) - I_{RCD\_1}$; and then calculates the insulation resistance-to-ground value at the input end of the power sourcing equipment 30 as follows: $K = (2V_2 - V_{in2})/[2 (I_{RCD\_2} + I_{RCD\_com})]$.

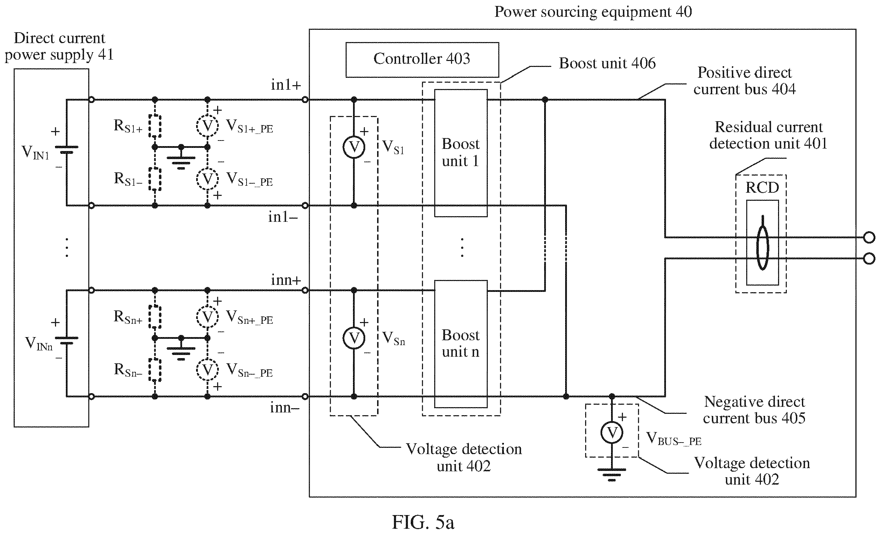

For example, FIG. 5a is a schematic diagram of another structure of power sourcing equipment according to this application. As shown in FIG. 5a, the power sourcing equipment 40 includes a residual current detection unit 401, a voltage detection unit 402, a controller 403, a positive direct current bus 404, a negative direct current bus 405, and a boost unit 406. The power sourcing equipment 40 includes n pairs of input ends, and each pair of input ends of the n pairs of input ends is coupled to an independent direct current power supply. The boost unit 406 includes n boost units, and two input ends of each boost unit are respectively coupled to each pair of input ends of the power sourcing equipment 40, where n is an integer greater than or equal to 1. As shown in FIG. 5a, a positive input end in1+ of a first pair of input ends of the power sourcing equipment 40 is coupled to a positive output end of a direct current power supply $V_{IN1}$, and a negative input end in1- of the first pair of input ends of the power sourcing equipment 40 is coupled to a negative output end of the direct current power supply $V_{IN1}$; ...; and a positive input end inn+ of an $n^{th}$ pair of input ends of the power sourcing equipment 40 is coupled to a positive output end of a direct current power supply $V_{INn}$, and a negative input end inn- of the $n^{th}$ pair of input ends of the power sourcing equipment 40 is coupled to a negative output end of the direct current power supply $V_{INn}$. The positive input end in1+ of the first pair of input ends of the power sourcing equipment 40 is coupled to a positive input end of a boost unit 1, and the negative input end in1- of the first pair of input ends of the power sourcing equipment 40 is coupled to a negative input end of the boost unit 1; ...; and the positive input end inn+ of the $n^{th}$ pair of input ends of the power sourcing equipment 40 is coupled to a positive input end of a boost unit n, and the negative input end inn- of the $n^{th}$ pair of input ends of the power sourcing equipment 40 is coupled to a negative input end of the boost unit n. A positive output end of the boost unit 1, ..., and a positive output end of the boost unit n are all coupled to the positive direct current bus 404 (namely, a common positive bus). A negative output end of the boost unit 1, ..., and a negative output end of the boost unit n are all coupled to the negative direct current bus 405 (namely, a common negative bus). In addition, the negative input end and the negative output end of the boost unit 1 are directly coupled or are coupled through low resistance, ..., and the negative input end and the negative output end of the boost unit n are directly coupled or are coupled through low resistance. The positive direct current bus 404 and the negative direct current bus 405 are coupled to an output end of the power sourcing equipment 40 through the residual current detection unit 401.

In an implementation, the controller 403 may control a switching transistor in each boost unit of the boost unit 406, to control an input voltage at each pair of input ends of the power sourcing equipment 40 to be a first input voltage value $V_{in1}$. To be specific, $V_{in1} = V_{S1} = \cdots = V_{Sn} = V_{IN1} = \cdots = V_{INn}$. When $V_{in1} = V_{S1} = \cdots = V_{Sn}$, the controller 403 obtains a voltage $V_{BUS\_PE}$ between the negative direct current bus 405 of the power sourcing equipment 40 and ground through the voltage detection unit 402, to obtain a first voltage-to-ground $V_1$ Because a negative input end of each pair of input ends of the power sourcing equipment 40 is coupled to the negative direct current bus 405, a voltage between the negative input end of each pair of input ends of the power sourcing equipment 40 and the ground is $V_1$. In addition, when $V_{in1} = V_{S1} = \cdots = V_{Sn}$, the controller 403 obtains a residual current of the power sourcing equipment 40 through the residual current detection unit 401, to obtain a first residual current value $I_{RCD\_1}$. Then the controller 403 may control an input voltage at each pair of input ends of the power sourcing equipment 40 to be a second input voltage value $V_{in2}$, where $V_{in2} \neq V_{in1}$. To be specific, $V_{in2} = V_{S1} = \cdots - V_{Sn} = V_{IN1} = \cdots = V_{INn}$. When $V_{in2} = V_{S1} = \cdots = V_{Sn}$, the controller 403 obtains a voltage $V_{BUS\_PE}$ between the negative direct current bus 405 of the power sourcing equipment 40 and the ground through the voltage detection unit 402, to obtain a second voltage-to-ground $V_2$. Because a negative input end of each pair of input ends of the power sourcing equipment 40 is coupled to the negative direct current bus 405, a voltage between the negative input end of each pair of input ends of the power sourcing equipment 40 and the ground is $V_2$. In addition, when $V_{in2} = V_{S1} = \cdots = V_{Sn}$, the controller 403 obtains a residual current of the power sourcing equipment 40 through the residual current detection unit 401, to obtain a second residual current value $I_{RCD\_2}$.

In another implementation, the controller 403 may control a switching transistor in each boost unit of the boost unit 406, to control an input voltage at each pair of input ends of the power sourcing equipment 40 to be a first input voltage value $V_{in1}$. To be specific, $V_{in1} = V_{S1} = \cdots = V_{Sn} = V_{IN1} = \cdots = V_{INn}$. In addition, the controller 403 controls a voltage (corresponding to $V_{BUS\_PE}$) between the negative direct current bus 405 of the power sourcing equipment 40 and ground to be a first voltage-to-ground value $V_1$. Because a negative input end of each pair of input ends of the power sourcing equipment 40 is coupled to the negative direct current bus 405, a voltage between the negative input end of each pair of input ends of the power sourcing equipment 40 and the ground is also $V_1$. When $V_{Bus\_PE} = V_1$, the controller 403 obtains a residual current of the power sourcing equipment 40 through the residual current detection unit 401, to obtain a first residual current value $I_{RCD\_1}$. Then the controller 403 may control an input voltage at each pair of input ends of the power sourcing equipment 40 to be a second input voltage value $V_{in2}$, where $V_{in2} = V_{in1}$. To be specific, $V_{in2} = V_{in1} = V_{S1} = \cdots = V_{Sn} = V_{IN1} = \cdots = V_{INn}$. In addition, the controller 403 controls a voltage (corresponding to $V_{BUS\_PE}$) between the negative direct current bus 405 of the power sourcing equipment 40 and the ground to be a second voltage-to-ground value $V_2$, where $V_2 \neq V_1$. In addition, when $V_{Bus\_PE} = V_2$, the controller 403 obtains a residual current of the power sourcing equipment 40 through the residual current detection unit 401, to obtain a second residual current value $I_{RCD\_2}$.

In still another implementation, the controller 403 may control a switching transistor in each boost unit of the boost unit 406, to control an input voltage at each pair of input ends of the power sourcing equipment 40 to be a first input voltage value $V_{in1}$. To be specific, $V_{in1} = V_{S1} = \cdots = V_{Sn} = V_{N1} = \cdots = V_{INn}$. In addition, the controller 403 controls a voltage (corresponding to $V_{BUS\_PE}$) between the negative direct current bus 405 of the power sourcing equipment 40 and ground to be a first voltage-to-ground value $V_1$. Because a negative input end of each pair of input ends of the power sourcing equipment 40 is coupled to the negative direct current bus 405, a voltage between the negative input end of each pair of input ends of the power sourcing equipment 40 and the ground is also $V_1$. When $V_{in1} = V_{S1} = \cdots = V_{Sn}$ and $V_{BUS\_PE} = V_1$, the controller 403 obtains a residual current of the power sourcing equipment 40 through the residual current detection unit 401, to obtain a first residual current value $I_{RCD\_1}$. Then the controller 403 may control an input voltage at each pair of input ends of the power sourcing equipment 40 to be a second input voltage value $V_{in2}$. To be specific, $V_{in2} = V_{S1} = \cdots = V_{Sn} = V_{IN1} = \cdots = Y_{INn}$. In addition, the controller 403 controls a voltage (corresponding to $V_{BUS\_PE}$) between the negative direct current bus 405 of the power sourcing equipment 40 and the ground to be a second voltage-to-ground value $V_2$. When $V_{in2} = V_{S1} = \cdots = V_{Sn}$ and $V_{BUS\_PE} = V_2$, the controller 403 obtains a residual current of the power sourcing equipment 40 through the residual current detection unit 401, to obtain a second residual current value $I_{RCD\_2}$. It should be noted that values of $V_{in1}$, $V_{in2}$, $V_1$, and $V_2$ may include the following cases: (1) $V_{in2} \neq V_{in1}$ and $V_2 = V_1$; and (2) $V_{in2} \neq V_{in1}$ and $V_2 \neq V_1$.

In an optional embodiment, the controller 403 determines, based on $V_{in1}$ and $V_1$, a voltage $V_{S1+\_PE} = \cdots =$

$V_{Sn+\_PE} = V_{in1} + V_1$ between a positive input end of each pair of input ends of the power sourcing equipment 40 and the ground and a voltage $V_{S1-\_PE} = \cdots = V_{Sn-\_PE} = V_1$ between a negative input end of each pair of input ends and the ground when the residual current detection unit 401 detects that the residual current of the power sourcing equipment 40 is $I_{RCD\_1}$. Considering that an RCD has an offset $I_{RCD\_set}$, the controller 403 substitutes $V_{S1+\_PE} = \cdots = V_{Sn+\_PE} = V_{in1} + V_1$, $V_{S1-\_PE} = \cdots = V_{Sn-\_PE} = V_1$, and $I_{RCD} = I_{RCD\_1}$ into a formula $I_{RCD} = V_{S1+\_PE}/R_{S1+} + \cdots + V_{Sn+\_PE}/R_{Sn+} + V_{S1-\_PE}/R_{S1-} + \cdots + V_{Sn-\_PE}/R_{Sn-} + I_{RCD\_set}$ to obtain an equation 1: $I_{RCD\_1} = (V_{in1} + V_1)(1/R_{S1+} + \cdots + 1/R_{Sn+}) + V_1 * (1/R_{S1-} + \cdots + 1/R_{Sn-}) + I_{RCD\_set}$.

The controller 403 determines, based on $V_{in2}$ and $V_2$, a voltage $V_{S1+\_PE} = \cdots = V_{Sn+\_PE} = V_{in2} + V_2$ between a positive input end of each pair of input ends of the power sourcing equipment 40 and the ground and a voltage $V_{S1-\_PE} = \cdots = V_{Sn-\_PE} = V_2$ between a negative input end of each pair of input ends and the ground when the residual current detection unit 401 detects that the residual current of the power sourcing equipment 40 is $I_{RCD\_2}$. Considering that an RCD has an offset $I_{RCD\_set}$, the controller 403 substitutes $V_{S1+\_PE} = \cdots = V_{Sn+\_PE} = V_{in2} + V_2$, $V_{S1-\_PE} = \cdots = V_{Sn-\_PE} = V_2$, and $I_{RCD} = I_{RCD\_2}$ into a formula $I_{RCD} = V_{S1+\_PE}/R_{S1+} + \cdots + V_{Sn+\_PE}/R_{Sn+} + V_{S1-\_PE}/R_{S1-} + \cdots + V_{Sn-\_PE}/R_{Sn-} + I_{RCD\_set}$ to obtain an equation 2:

$$I_{RCD\_2} = \left(V_{in2} + V_1\right)\left(1/R_{S1+} + \cdots + 1/R_{Sn+}\right) + V_2 * \left(1/R_{S1-} + \cdots + 1/R_{Sn-}\right) + I_{RCD\_set}.$$

In a normal case, an insulation resistance-to-ground value at a positive input end of power sourcing equipment is equal to or approximately equal to an insulation resistance-to-ground value at a negative input end of the same power sourcing equipment. Therefore, $1/R_{S1+} + \cdots + 1/R_{Sn+} = 1/R_{St-} + \cdots + 1/R_{Sn-} = 1/(2K)$, where K is an insulation resistance-to-ground value at the input end of the power sourcing equipment 40, to be specific, an insulation resistance-to-ground value of the direct current power supply 41, the power sourcing equipment 40, and the connection cable between the direct current power supply 41 and the power sourcing equipment 40. The controller 403 first substitutes $1/R_{S1+} + \cdots + 1/R_{Sn+} = 1/R_{S1-} + \cdots + 1/R_{Sn-} = 1/(2K)$ into the equation 1 and the equation 2 to obtain an equation 3 $I_{RCD\_1} = (V_{in1} + V_1)/(2K) + V_1/(2K) + I_{RCD\_set}$ and an equation 4 $I_{RCD\_2} = (V_{in2} + V_1)/(2K) + V_2/(2K) + I_{RCD\_set}$ respectively, and then subtracts the equation 4 from the equation 3 (that is, cancels $I_{RCD\_set}$) to obtain the following:

$$K = \left[2\left(V_1 - V_2\right) + V_{in1} - V_{in2}\right]/\left[2\left(I_{RCD\_1} - I_{RCD\_2}\right)\right].$$

It should be noted that, when the voltage detection unit 402 detects a voltage between the positive input end of each pair of input ends of the power sourcing equipment 40 and the ground, the negative input end and the negative output end of each boost unit of the boost unit 406 are no longer directly coupled or coupled through low resistance, and the positive input end and the negative output end of each boost unit are directly coupled or are coupled through low resistance. A voltage between the positive input end of each pair of input ends of the power sourcing equipment 40 and the ground is a voltage between the negative direct current bus 405 and the ground, and a corresponding insulation resistance-to-ground value is as follows:

$$K = \left[2\left(V_1 - V_2\right) - V_{in1} + V_{in2}\right]/\left[2\left(I_{RCD\_1} - I_{RCD\_2}\right)\right].$$

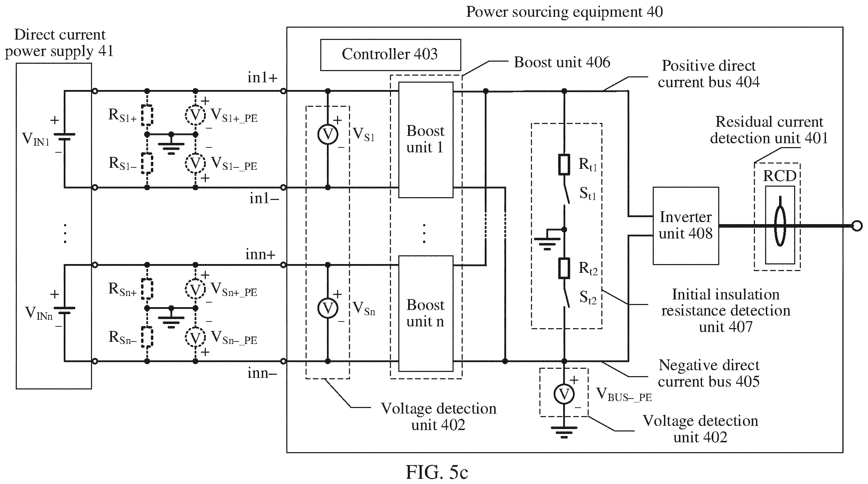

Further, the power sourcing equipment 40 shown in FIG. 5a may further include an inverter unit. Two input ends of the inverter unit are coupled to the positive direct current bus 404 and the negative direct current bus 405 respectively. An output end of the inverter unit is coupled to the output end of the power sourcing equipment 40 through the residual current detection unit 401. For a specific connection, refer to FIG. 5c.

When the power sourcing equipment 40 shown in FIG. 5a further includes the inverter unit, a manner of calculating, by the power sourcing equipment 40, the insulation resistance-to-ground value at the input end of the power sourcing equipment 40 remains unchanged. Details are as follows:

When the voltage detection unit 402 detects a voltage between the negative input end of each pair of input ends of the power sourcing equipment 40 and the ground, the controller 403 calculates the insulation resistance-to-ground value at the input end of the power sourcing equipment 40 as follows: $K = [2(V_1 - V_2) + V_{in1} - V_{in2}]/[2(I_{RCD\_1} - I_{RCD\_2})]$.

When the voltage detection unit 402 detects a voltage between the positive input end of each pair of input ends of the power sourcing equipment 40 and the ground, the negative input end and the negative output end of each boost unit of the boost unit 406 are no longer directly coupled or coupled through low resistance, and the positive input end and the negative output end of each boost unit are directly coupled or are coupled through low resistance. The controller 403 calculates a corresponding insulation resistance-to-ground value as follows:

$$K = \left[ 2\left(V_1 - V_2\right) - V_{in1} + V_{in2} \right] \Big/ \left[ 2\left(I_{RCD\_1} - I_{RCD\_2}\right) \right].$$

In this embodiment of this application, when calculating the insulation resistance-to-ground value at the input end of the power sourcing equipment 40, the power sourcing equipment 40 considers the offset of the RCD, and cancels the offset of the RCD based on residual current values and voltage parameter values of the power sourcing equipment 40 that are obtained by the power sourcing equipment 40 in two different operating statuses, to improve accuracy of detecting insulation resistance-to-ground at the input end of the power sourcing equipment 40. Therefore, applicability is high. In addition, in this application, an existing circuit (to be specific, the residual current detection unit 401, the voltage detection unit 402, and the controller 403) in the power sourcing equipment 40 is used to detect insulation resistance-to-ground at the input end of the power sourcing equipment 40. Therefore, circuit or device costs do not need to be additionally increased.

Based on the power sourcing equipment 40 shown in FIG. 5a, this application further provides a method for detecting insulation resistance at an input end of power sourcing equipment. The method includes the following step: When the first input end is the negative input end of each pair of input ends of the power sourcing equipment 40, the power sourcing equipment 40 calculates the insulation resistance-to-ground value at the input end of the power sourcing equipment 40 as follows:

$$K = \left[ 2\left(V_1 - V_2\right) + V_{in1} - V_{in2} \right] \Big/ \left[ 2\left(I_{RCD\_1} - I_{RCD\_2}\right) \right].$$

Further, based on the power sourcing equipment 40 shown in FIG. 5a, this application further provides a method for detecting insulation resistance at an input end of power sourcing equipment. The method includes the following step: When the first input end is the positive input end of each pair of input ends of the power sourcing equipment 40, the negative input end and the negative output end of each boost unit of the boost unit 406 are no longer directly coupled or coupled through low resistance, and the positive input end and the negative output end of each boost unit are directly coupled or are coupled through low resistance. The power sourcing equipment 40 calculates a corresponding insulation resistance-to-ground value as follows: $K = [2(V_1 - V_2) - V_{in1} + V_{in2}]/[2(I_{RCD\_1} - I_{RCD\_2})]$.

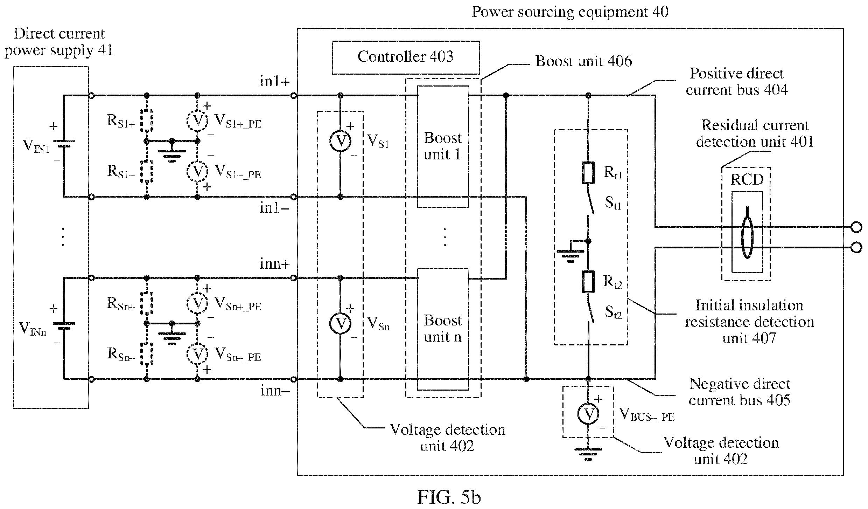

Further, the power sourcing equipment shown in FIG. 5a may further include an initial insulation resistance detection unit 407. For details, refer to a schematic diagram of another structure of the power sourcing equipment shown in FIG. 5b. As shown in FIG. 5b, the initial insulation resistance detection unit 407 is coupled between the positive direct current bus 404 and the negative direct current bus 405, and is configured to detect an initial insulation resistance value at the input end of the power sourcing equipment 40. In addition, the initial insulation resistance detection unit 407 includes a resistor $R_{t1}$ and a controllable switch $S_{\varepsilon i}$ that are connected in series between a positive output end of each direct current power supply of the direct current power supply 41 and the ground, and a resistor $R_{t2}$ and a controllable switch $S_{t2}$ that are connected in series between a negative output end of each direct current power supply and the ground.

In an optional embodiment, before the power sourcing equipment 40 is started, the controller 403 controls the controllable switch $S_{\varepsilon i}$ to be turned on and $S_{t2}$ to be turned off, where in this case, $R_{S1+}$, ..., and $R_{Sn+}$ are connected to $R_{t1}$ in parallel, and $R_{S1-}$, ..., and $R_{Sn-}$ are connected in parallel; and obtains a voltage $V_{BUS-\_PE1}$ between the negative direct current bus 405 and the ground and a voltage $V_{BUS+\_PE1}$ between the positive direct current bus 404 and the ground when the controllable switch $S_{\varepsilon i}$ is turned on and $S_{t2}$ is turned off. In addition, the controller 403 controls the controllable switch $S_{\varepsilon i}$ to be turned off and $S_{t2}$ to be turned on, where in this case, $R_{S1+}$, ..., and $R_{Sn+}$ are connected in parallel, and $R_{S1-}$, ..., and $R_{Sn-}$ are connected to $R_{t2}$ in parallel; obtains a voltage $V_{BUS-\_PE2}$ between the negative direct current bus 405 and the ground and a voltage $V_{BUS+\_PE2}$ between the positive direct current bus 404 and the ground when the controllable switch $S_{t1}$ is turned off and $S_{t2}$ is turned on; then obtains simultaneous equations based on that a current value on a resistor $(R_{S1+}//.../R_{Sn+}//R_{t1})$ is equal to a current value on a resistor $(R_{S1-}//.../R_{Sn-})$ when $S_{t1}$ is turned on and $S_{t2}$ is turned off and that a current value on the resistor $(R_{S1-}//.../R_{Sn-}//R_{t2})$ is equal to a current value on the resistor $(R_{S1+}//.../R_{Sn+})$ when $S_{t1}$ is turned off and $S_{t2}$ is turned on; and finally calculates the initial insulation resistance value $K_0$ at the input end of the power sourcing equipment 40. To be specific, the initial insulation resistance-to-ground value is as follows: $K_0 = 1/(1/R_{S1+} + \cdots + 1/R_{Sn+} + 1/R_{S1-} + \cdots + 1/R_{Sn-})$. In a normal case, an insulation resistance-to-ground value at a positive output end of a power supply is equal to or approximately equal to an insulation resistance-to-ground value at a negative output end of the same power supply. Therefore, $1/(1/R_{S1+} + \cdots + 1/R_{Sn+}) = 1/(1/R_{S1-} + \cdots + 1/R_{Sn-}) = 2K_0$.

Then the controller 403 may obtain $V_{in1}$, $V_1$, and $I_{RCD\_1}$ in the three manners in the embodiment shown in FIG.

5a. Details are not described herein again. The controller 403 determines, based on $V_{in1}$ and $V_1$, a voltage $V_{S1+\_PE} = \cdots = V_{Sn+\_PE} = V_{in1} + V_1$ between a positive input end of each pair of input ends of the power sourcing equipment 40 and the ground and a voltage $V_{S1-\_PE} = \cdots = V_{Sn-\_PE} = V_1$ between a negative input end of each pair of input ends and the ground when the residual current detection unit 401 detects that the residual current of the power sourcing equipment 40 is $I_{RCD\_1}$. Because short time has elapsed since startup of the power sourcing equipment 40, insulation resistance in the direct current power supply 41 or the power sourcing equipment 40 has not changed. In this case, $V_{S1+\_PE} = \cdots = V_{Sn+\_PE} = V_{in1} + V_1$, $V_{S1-\_PE} = \cdots = V_{Sn-\_PE} = V_1$, and $1/(1/R_{S1+} + \cdots + 1/R_{Sn+}) = 1/(1/R_{S1-} + \cdots + 1/R_{Sn-}) = 2K_0$ are substituted into a formula $I_{RCD\_ref} = V_{S1+\_PE}/R_{S1+} + \cdots + V_{Sn+\_PE}/R_{Sn+} + V_{S1-\_PE}/R_{S1-} + \cdots + V_{Sn-\_PE}/R_{Sn-}$ to calculate a reference residual current value of the power sourcing equipment 40 when the residual current of the power sourcing equipment 40 is $I_{RCD\_1}$: $I_{RCD\_ref} = (V_{in1} + V_1)/(2K_0) + V_1/(2K_0)$. To cancel the offset of the RCD, the controller 403 calculates a difference between $I_{RCD\_ref}$ and $I_{RCD\_1}$ to obtain a residual current compensation value $I_{RCD\_com}$. To be specific, $I_{RCD\_com} = I_{RCD\_ref} - I_{RCD\_1} = (2V_1 + V_{in1})/(2K_0) - I_{RCD\_1}$.

Then the controller 403 may obtain $V_{in2}$, $V_2$, and $I_{RCD\_2}$ in the three manners in the embodiment shown in FIG. 3a. Details are not described herein again. The controller 403 determines, based on $V_{in2}$ and $V_2$, a voltage $V_{S1+\_PE} = \cdots = V_{Sn+\_PE} = V_{in2} + V_2$ between a positive input end of each pair of input ends of the power sourcing equipment 40 and the ground and a voltage $V_{S1-\_PE} = \cdots = V_{Sn-\_PE} = V_2$ between a negative input end of each pair of input ends and the ground when the residual current detection unit 401 detects that the residual current of the power sourcing equipment 40 is $I_{RCD\_2}$. To cancel the offset of the RCD, the controller 403 substitutes $V_{S1+\_PE} = \cdots = V_{Sn+\_PE} = V_{in2} + V_2$, $V_{S1-\_PE} = \cdots = V_{Sn-\_PE} = V_2$, $I_{RCD} = I_{RCD\_2}$, and $1/(1/R_{S1+} + \cdots + 1/R_{Sn+}) = 1/(1/R_{S1-} + \cdots + 1/R_{Sn-}) = 2K$ into a formula $I_{RCD} + I_{RCD\_com} = V_{S1+\_PE}/R_{S1+} + \cdots + V_{Sn+\_PE}/R_{Sn+} + V_{S1-\_PE}/R_{S1-} + \cdots + V_{Sn-\_PE}/R_{Sn-}$ to calculate the insulation resistance-to-ground value at the input end of the power sourcing equipment 40 as follows: $K = (2V_2 + V_{in2})/[2(I_{RCD\_2} + I_{RCD\_com})]$.

It should be noted that, when the voltage detection unit 402 detects a voltage between the positive input end of each pair of input ends of the power sourcing equipment 40 and the ground, the negative input end and the negative output end of each boost unit of the boost unit 406 are no longer directly coupled or coupled through low resistance, and the positive input end and the negative output end of each boost unit are directly coupled or are coupled through low resistance. A voltage between the positive input end of each pair of input ends of the power sourcing equipment 40 and the ground is a voltage between the negative direct current bus 405 and the ground. A corresponding residual current compensation value is as follows: $I_{RCD\_com} = (2V_1 - V_{in1})/(2K_0) - I_{RCD\_1}$. A corresponding insulation resistance-to-ground value is as follows: $K = (2V_2-V_{in2})/[2(I_{RCD\_2} + I_{RCD\_com})]$.

In this embodiment of this application, the power sourcing equipment 40 may calculate the residual current compensation value based on the initial insulation resistance-to-ground value at the input end of the power sourcing equipment 40 that is detected by the initial insulation resistance detection unit 407, and cancel the offset of the RCD based on the residual current compensation value, to improve accuracy of detecting insulation resistance-to-ground at the input end of the power sourcing equipment 40. Therefore, applicability is high. In addition, in this application, an existing circuit (to be specific, the residual current detection unit 401, the voltage detection unit 402, the controller 403, and the initial insulation resistance detection unit 407) in the power sourcing equipment 40 is used to detect insulation resistance-to-ground at the input end of the power sourcing equipment 40. Therefore, circuit or device costs do not need to be additionally increased.

Based on the power sourcing equipment 40 shown in FIG. 5b, this application further provides a method for detecting insulation resistance at an input end of power sourcing equipment. The method includes the following step: When the first input end is the negative input end of each pair of input ends of the power sourcing equipment 40, the power sourcing equipment 40 calculates the residual current compensation value as follows: $I_{RCD\_com} = (2V_1 + V_{in1})/(2K_0) - I_{RCD\_1}$; and then calculates the insulation resistance-to-ground value at the input end of the power sourcing equipment 40 as follows: $K = (2V_2 + V_{in2})/[2(I_{RCD\_2} + I_{RCD\_com})]$.

Further, based on the power sourcing equipment 40 shown in FIG. 5b, this application further provides a method for detecting insulation resistance at an input end of power sourcing equipment. The method includes the following step: When the first input end is the positive input end of each pair of input ends of the power sourcing equipment 40, the negative input end and the negative output end of each boost unit of the boost unit 406 are no longer directly coupled or coupled through low resistance, and the positive input end and the negative output end of each boost unit are directly coupled or are coupled through low resistance. The power sourcing equipment 40 calculates a residual current compensation value as follows: $I_{RCD\_com} = (2V_1 - V_{in1})/(2K_0) - I_{RCD\_1}$; and then calculates a corresponding insulation resistance-to-ground value as follows:

$$K = \left(2V_2 - V_{in2}\right)\Big/\left[2\left(I_{RCD\_2} + I_{RCD\_com}\right)\right].$$

Further, the power sourcing equipment shown in FIG. 5b may further include an inverter unit 408. For details, refer to a schematic diagram of another structure of the power sourcing equipment shown in FIG. 5c. As shown in FIG. 5c, two input ends of the inverter unit 408 are respectively coupled to the positive direct current bus 404 and the negative direct current bus 405, and an output end of the inverter unit 408 is coupled to the output end of the power sourcing equipment 40 through the residual current detection unit 401.

In this embodiment of this application, a manner of calculating, by the power sourcing equipment 40, the insulation resistance-to-ground value at the input end of the power sourcing equipment 40 is the same as the manner of calculating the insulation resistance-to-ground value at the input end of the power sourcing equipment 40 in the embodiment shown in FIG. 5b. Details are not described herein again.

In this embodiment of this application, the power sourcing equipment 40 may calculate the residual current compensation value based on the initial insulation resistance-to-ground value at the input end of the power sourcing equipment 40 that is detected by the initial insulation resistance detection unit 407, and cancel the offset of the RCD based on the residual current compensation value, to improve accuracy of detecting insulation resistance-to-ground at the input end of the power sourcing equipment 40. Therefore, applicability is high. In addition, in this application, an existing circuit (to be specific, the residual current detection unit 401, the voltage detection unit 402, the controller 403, and the initial insulation resistance detection unit 407) in the power sourcing equipment 40 is used to detect insulation resistance-to-ground at the input end of the power sourcing equipment 40. Therefore, circuit or device costs do not need to be additionally increased.

Based on the power sourcing equipment 40 shown in FIG. 5c, this application further provides a method for detecting insulation resistance at an input end of power sourcing equipment. The method includes the following step: When the first input end is the negative input end of each pair of input ends of the power sourcing equipment 40, the power sourcing equipment 40 calculates the residual current compensation value as follows: $I_{RCD\_com} = (2V_1 + V_{in1})/(2K_0) - I_{RCD\_1}$; and then calculates the insulation resistance-to-ground value at the input end of the power sourcing equipment 40 as follows: $K = (2V_2 + V_{in2})/[2(I_{RCD\_2} + I_{RCD\_com})]$.

Further, based on the power sourcing equipment 40 shown in FIG. 5c, this application further provides a method for detecting insulation resistance at an input end of power sourcing equipment. The method includes the following step: When the first input end is the positive input end of each pair of input ends of the power sourcing equipment 40, the negative input end and the negative output end of each boost unit of the boost unit 406 are no longer directly coupled or coupled through low resistance, and the positive input end and the negative output end of each boost unit are directly coupled or are coupled through low resistance. The power sourcing equipment 40 calculates a residual current compensation value as follows: $I_{RCD\_com} = (2V_1 - V_{in1})/(2K_0) - I_{RCD\_1}$; and then calculates a corresponding insulation resistance-to-ground value as follows:

$$K = \left(2V_2 - V_{in2}\right)\Big/\left[2\left(I_{RCD\_2} + I_{RCD\_com}\right)\right].$$

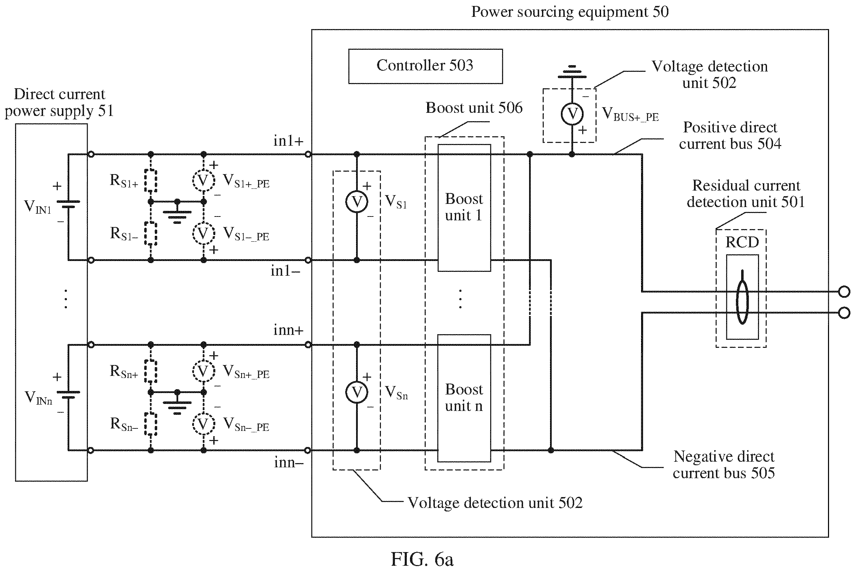

For example, FIG. 6a is a schematic diagram of another structure of power sourcing equipment according to this application. As shown in FIG. 6a, the power sourcing equipment 50 includes a residual current detection unit 501, a voltage detection unit 502, a controller 503, a positive direct current bus 504, a negative direct current bus 505, and a boost unit 506. The power sourcing equipment 50 includes n pairs of input ends, and each pair of input ends of the n pairs of input ends is coupled to an independent direct current power supply. The boost unit 506 includes n boost units, and two input ends of each boost unit are respectively coupled to each pair of input ends of the power sourcing equipment 50, where n is an integer greater than or equal to 1. As shown in FIG. 5a, a positive input end in1+ of a first pair of input ends of the power sourcing equipment 50 is coupled to a positive output end of a direct current power supply $V_{IN1}$, and a negative input end in1- of the first pair of input ends of the power sourcing equipment 50 is coupled to a negative output end of the direct current power supply $V_{IN1}$; ...; and a positive input end inn+ of an nth pair of input ends of the power sourcing equipment 50 is coupled to a positive output end of a direct current power supply $V_{INn}$, and a negative input end inn- of the nth pair of input ends of the power sourcing equipment 50 is coupled to a negative output end of the direct current power supply $V_{INn}$. The positive input end in1+ of the first pair of input ends of the power sourcing equipment 50 is coupled to a positive input end of a boost unit 1, and the negative input end in1- of the first pair of input ends of the power sourcing equipment 50 is coupled to a negative input end of the boost unit 1; ...; and the positive input end inn+ of the nth pair of input ends of the power sourcing equipment 50 is coupled to a positive input end of a boost unit n, and the negative input end inn- of the nth pair of input ends of the power sourcing equipment 50 is coupled to a negative input end of the boost unit n. A positive output end of the boost unit 1, ..., and a positive output end of the boost unit n are all coupled to the positive direct current bus 504 (namely, a common positive bus). A negative output end of the boost unit 1, ..., and a negative output end of the boost unit n are all coupled to the negative direct current bus 505 (namely, a common negative bus). In addition, the positive input end and the positive output end of the boost unit 1 are directly coupled or are coupled through low resistance,..., and the positive input end and the positive output end of the boost unit n are directly coupled or are coupled through low resistance. The positive direct current bus 504 and the negative direct current bus 505 are coupled to an output end of the power sourcing equipment 50 through the residual current detection unit 501.

In an implementation, the controller 503 may control a switching transistor in each boost unit of the boost unit 506, to control an input voltage at each pair of input ends of the power sourcing equipment 50 to be a first input voltage value $V_{in1}$. To be specific, $V_{in1} = V_{S1} = \cdots = V_{Sn} = V_{IN1} = \cdots = V_{INn}$. When $V_{in1} = V_{S1} = \cdots = V_{Sn}$, the controller 503 obtains a voltage $V_{BUS+\_PE}$, between the positive direct current bus 504 of the power sourcing equipment 50 and ground through the voltage detection unit 502, to obtain a first voltage-to-ground $V_1$. Because a positive input end of each pair of input ends of the power sourcing equipment 50 is coupled to the positive direct current bus 504, a voltage between the positive input end of each pair of input ends of the power sourcing equipment 50 and the ground is $V_1$. In addition, when $V_{in1} = V_{S1} = \cdots = V_{Sn}$, the controller 503 obtains a residual current of the power sourcing equipment 50 through the residual current detection unit 501, to obtain a first residual current value $I_{RCD\_1}$. Then the controller 503 may control an input voltage at each pair of input ends of the power sourcing equipment 50 to be a second input voltage value $V_{in2}$, where $V_{in2} \neq V_{in1}$. To be specific, $V_{in2} = V_{S1} = \cdots = V_{Sn} = V_{IN1} = \cdots = V_{INn}$. When $V_{in2} = V_{S1} = \cdots = V_{Sn}$, the controller 503 obtains a voltage $V_{BUS+\_PE}$ between the positive direct current bus 504 of the power sourcing equipment 50 and ground through the voltage detection unit 502, to obtain a second voltage-to-ground $V_2$. Because a positive input end of each pair of input ends of the power sourcing equipment 50 is coupled to the positive direct current bus 504, a voltage between the positive input end of each pair of input ends of the power sourcing equipment 50 and the ground is $V_2$. In addition, when $V_{in2} = V_{S1} = \cdots = V_{Sn}$, the controller 503 obtains a residual current of the power sourcing equipment 50 through the residual current detection unit 501, to obtain a second residual current value $I_{RCD\_2}$.

In another implementation, the controller 503 may control a switching transistor in each boost unit of the boost unit 506, to control an input voltage at each pair of input ends of the power sourcing equipment 50 to be a first input voltage value $V_{in1}$. To be specific, $V_{in1} = V_{S1} = \cdots = V_{Sn} = V_{IN1} = \cdots = V_{INn}$. In addition, the controller 503 controls a voltage (corresponding to $V_{BUS+\_PE}$) between the positive direct current bus 504 of the power sourcing equipment 50 and ground to be a first voltage-to-ground value $V_1$. Because a positive input end of each pair of input ends of the power sourcing equipment 50 is coupled to the positive direct current bus 504, a voltage between the positive input end of each pair of input ends of the power sourcing equipment 50 and the ground is also $V_1$. When $V_{BUS+\_PE} = V_1$, the controller 503 obtains a residual current of the power sourcing equipment 50 through the residual current detection unit 501, to obtain a first residual current value $I_{RCD\_1}$. Then the controller 503 may control an input voltage at each pair of input ends of the power sourcing equipment 50 to be a second input voltage value $V_{in2}$, where $V_{in2} = V_{in1}$. To be specific, $V_{in2} = V_{in1} = V_{S1} = \cdots = V_{Sn} = V_{IN1} = \cdots = V_{INn}$. In addition, the controller 503 controls a voltage (corresponding to $V_{BUS+\_PE}$) between the positive direct current bus 504 of the power sourcing equipment 50 and the ground to be a second voltage-to-ground value $V_2$, where $V_2 \neq V_1$. In addition, when $V_{BUS+\_PE} = V_2$, the controller 503 obtains a residual current of the power sourcing equipment 50 through the residual current detection unit 501, to obtain a second residual current value $I_{RCD\_2}$.

In still another implementation, the controller 503 may control a switching transistor in each boost unit of the boost unit 506, to control an input voltage at each pair of input ends of the power sourcing equipment 50 to be a first input voltage value $V_{in1}$. To be specific, $V_{in1} = V_{S1} = \cdots = V_{Sn} = V_{IN1} = \cdots = V_{INn}$. In addition, the controller 503 controls a voltage (corresponding to $V_{BUS+\_PE}$) between the positive direct current bus 504 of the power sourcing equipment 50 and ground to be a first voltage-to-ground value $V_1$. Because a positive input end of each pair of input ends of the power sourcing equipment 50 is coupled to the positive direct current bus 504, a voltage between the positive input end of each pair of input ends of the power sourcing equipment 50 and the ground is also $V_1$. When $V_{in1} = V_{S1} = \cdots = V_{Sn}$ and $V_{BUS+\_PE} = V_1$, the controller 503 obtains a residual current of the power sourcing equipment 50 through the residual current detection unit 501, to obtain a first residual current value $I_{RCD\_1}$. Then the controller 503 may control an input voltage at each pair of input ends of the power sourcing equipment 50 to be a second input voltage value $V_{in2}$. To be specific, $V_{in2} = V_{S1} = \cdots = V_{Sn} = V_{IN1} = \cdots = V_{INn}$. In addition, the controller 503 controls a voltage (corresponding to $V_{BUS+\_PE}$) between the positive direct current bus 504 of the power sourcing equipment 50 and the ground to be a second voltage-to-ground value $V_2$. When $V_{in2} = V_{S1} = \cdots = V_{Sn}$ and $V_{BUS+\_PE} = V_2$, the controller 503 obtains a residual current of the power sourcing equipment 50 through the residual current detection unit 501, to obtain a second residual current value $I_{RCD\_2}$. It should be noted that values of $V_{in1}$, $V_{in2}$, $V_1$, and $V_2$ may include the following cases: (1) $V_{in2} \neq V_{in1}$ and $V_2 = V_1$; and (2) $V_{in2} \neq V_{in1}$ and $V_2 \neq V_1$.

In an optional embodiment, the controller 503 determines, based on $V_{in1}$ and $V_1$, a voltage $V_{S1+\_PE} = \cdots = V_{Sn+\_PE} = V_1$ between a positive input end of each pair of input ends of the power sourcing equipment 50 and the ground and a voltage $V_{S1-\_PE} = \cdots = V_{Sn-\_PE} = V_1 - V_{in1}$ between a negative input end of each pair of input ends and the ground when the residual current detection unit 501 detects that the residual current of the power sourcing equipment 50 is $I_{RCD\_1}$. Considering that an RCD has an offset $I_{RCD\_set}$, the controller 503 substitutes $V_{S1+\_PE} = \cdots = V_{Sn+\_PE} = V_1$, $V_{S1-\_PE} = \cdots = V_{Sn-\_PE} = V_1 - V_{in1}$, and $I_{RCD} = I_{RCD\_1}$ into a formula $I_{RCD} = V_{S1+\_PE}/R_{S1+} + \cdots + V_{Sn+\_PE}/R_{Sn+} + V_{S1-\_PE}/R_{S1-} + \cdots + V_{Sn-\_PE}/R_{Sn-} + I_{RCD\_set}$ to obtain an equation 1:

$$I_{RCD\_1} = V_1 * \left(1/R_{S1+} + \cdots + 1/R_{Sn+}\right) + \left(V_1 - V_{in1}\right) * \left(1/R_{S1-} + \cdots + 1/R_{Sn-}\right) + I_{RCD\_set}$$

The controller 503 determines, based on $V_{in2}$ and $V_2$, a voltage $V_{S1+\_PE} = \cdots = V_{Sn+\_PE} = V_2$ between a positive input end of each pair of input ends of the power sourcing equipment 50 and the ground and a voltage $V_{S1-\_PE} = \cdots = V_{Sn-\_PE} = V_2 - V_{in2}$ between a negative input end of each pair of input ends and the ground when the residual current detection unit 501 detects that the residual current of the power sourcing equipment 50 is $I_{RCD\_2}$. Considering that an RCD has an offset $I_{RCD\_set}$, the controller 503 substitutes $V_{S1+\_PE} = \cdots = V_{Sn+\_PE} = V_2$, $V_{S1-\_PE} = \cdots = V_{Sn-\_PE} = V_2 - V_{in2}$ and $I_{RCD} = I_{RCD\_2}$ into a formula $I_{RCD} = V_{S1+\_PE}/R_{S1+} + \cdots + V_{Sn+\_PE}/R_{Sn+} + V_{S1-\_PE}/R_{S1-} + \cdots + V_{Sn-\_PE}/R_{Sn-} + I_{RCD\_set}$ to obtain an equation 2:

$$I_{RCD\_2} = V_2 * \left(1/R_{S1+} + \cdots + 1/R_{Sn+}\right) + \left(V_2 - V_{in2}\right) * \left(1/R_{S1-} + \cdots + 1/R_{Sn-}\right) + I_{RCD\_set}$$

In a normal case, an insulation resistance-to-ground value at a positive input end of power sourcing equipment is equal to or approximately equal to an insulation resistance-to-ground value at a negative input end of the same power sourcing equipment. Therefore, $1/R_{S1+} + ... + 1/R_{Sn+} = 1/R_{S1-} + \cdots + 1/R_{Sn-} = 1/(2K)$, where K is an insulation resistance-to-ground value at the input end of the power sourcing equipment 50, to be specific, an insulation resistance-to-ground value of the direct current power supply 51, the power sourcing equipment 50, and the connection cable between the direct current power supply 51 and the power sourcing equipment 50. The controller 503 first substitutes $1/R_{S1+} + \cdots + 1/R_{Sn+} = 1/R_{S1-} + \cdots + 1/R_{Sn-} = 1/(2K)$ into the equation 1 and the equation 2 to obtain an equation 3 $I_{RCD\_1} = V1/(2K) + (V_1 - V_{in1})/(2K) + I_{RCD\_set}$ and an equation 4 $I_{RCD\_2} = V_2/(2K) + (V_2 - V_{in2})/(2K) + I_{RCD\_set}$ respectively, and then subtracts the equation 4 from the equation 3 (that is, cancels $I_{RCD\_set}$) to obtain the following:

$$K = \left[2\left(V_1 - V_2\right) - V_{in1} + V_{in2}\right] / \left[2\left(I_{RCD\_1} - I_{RCD\_2}\right)\right]$$

It should be noted that, when the voltage detection unit 502 detects a voltage between the negative input end of each pair of input ends of the power sourcing equipment 50 and the ground, the positive input end and the positive output end of each boost unit of the boost unit 506 are no longer directly coupled or coupled through low resistance, and the negative input end and the positive output end of each boost unit are directly coupled or are coupled through low resistance. A voltage between the negative input end of each pair of input ends of the power sourcing equipment 50 and the ground is a voltage between the positive direct current bus 504 and the ground, and a corresponding insulation resistance-to-ground value is as follows:

$$K = \left[2\left(V_1 - V_2\right) + V_{in1} - V_{in2}\right] / \left[2\left(I_{RCD\_1} - I_{RCD\_2}\right)\right]$$

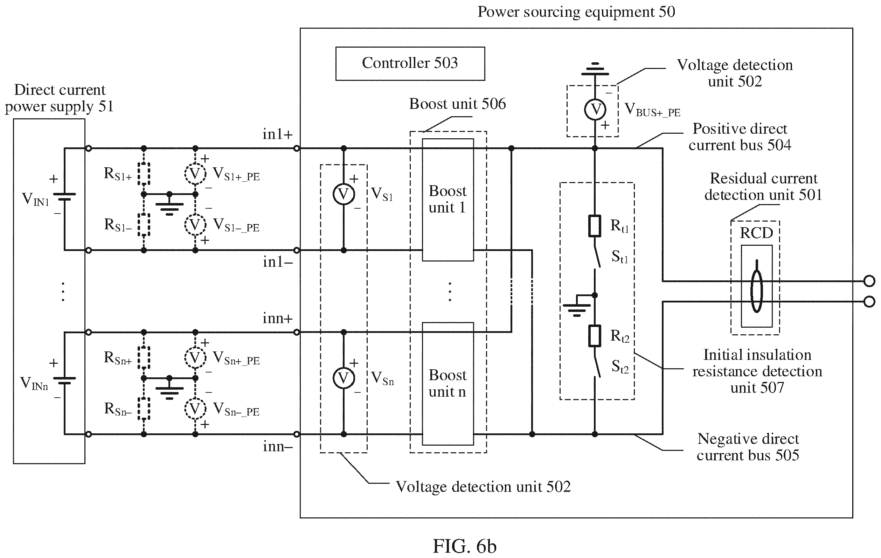

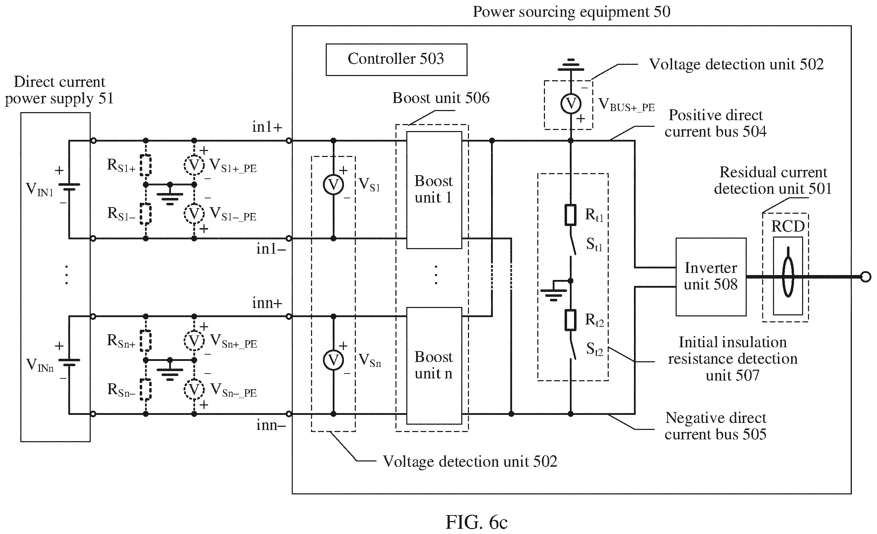

Further, the power sourcing equipment 50 shown in FIG. 6b may further include an inverter unit. Two input ends of the inverter unit are coupled to the positive direct current bus 504 and the negative direct current bus 505 respectively. An output end of the inverter unit is coupled to the output end of the power sourcing equipment 50 through the residual current detection unit 501. For a specific connection, refer to FIG. 6c.

When the power sourcing equipment 50 shown in FIG. 6a further includes the inverter unit, a manner of calculating, by the power sourcing equipment 50, the insulation resistance-to-ground value at the input end of the power sourcing equipment 50 remains unchanged. Details are as follows:

When the first input end is the positive input end of each pair of input ends of the power sourcing equipment 50, the power sourcing equipment 50 calculates the insulation resistance-to-ground value at the input end of the power sourcing equipment 50 as follows:

$$K = \left[2\left(V_1 - V_2\right) - V_{in1} + V_{in2}\right] / \left[2\left(I_{RCD\_1} - I_{RCD\_2}\right)\right]$$

Further, based on the power sourcing equipment 50 shown in FIG. 6a, this application further provides a method for detecting insulation resistance at an input end of power sourcing equipment. The method includes the following step: When the first input end is the negative input end of each pair of input ends of the power sourcing equipment 50, the positive input end and the positive output end of each boost unit of the boost unit 506 are no longer directly coupled or coupled through low resistance, and the negative input end and the positive output end of each boost unit are directly coupled or are coupled through low resistance. The power sourcing equipment 50 calculates a corresponding insulation resistance-to-ground value as follows: $K = [2(V_1 - V_2) + V_{in1} - V_{in2}]/[2(I_{RCD\_1} - I_{RCD\_2})]$.

In this embodiment of this application, when calculating the insulation resistance-to-ground value at the input end of the power sourcing equipment 50, the power sourcing equipment 50 considers the offset of the RCD, and cancels the offset of the RCD based on residual current values and voltage parameter values of the power sourcing equipment 50 that are obtained by the power sourcing equipment 50 in two different operating statuses, to improve accuracy of detecting insulation resistance-to-ground at the input end of the power sourcing equipment 50. Therefore, applicability is high. In addition, in this application, an existing circuit (to be specific, the residual current detection unit 501, the voltage detection unit 502, and the controller 503) in the power sourcing equipment 50 is used to detect insulation resistance-to-ground at the input end of the power sourcing equipment 50. Therefore, circuit or device costs do not need to be additionally increased.

Based on the power sourcing equipment 50 shown in FIG. 6a, this application further provides a method for detecting insulation resistance at an input end of power sourcing equipment. The method includes the following step: When the first input end is the positive input end of each pair of input ends of the power sourcing equipment 50, the power sourcing equipment 50 calculates the insulation resistance-to-ground value at the input end of the power sourcing equipment 50 as follows:

$$K = \left[ 2\left( V_1 - V_2 \right) - V_{in1} + V_{in2} \right] / \left[ 2\left( I_{RCD\_1} - I_{RCD\_2} \right) \right].$$

Further, based on the power sourcing equipment 50 shown in FIG. 6a, this application further provides a method for detecting insulation resistance at an input end of power sourcing equipment. The method includes the following step: When the first input end is the negative input end of each pair of input ends of the power sourcing equipment 50, the positive input end and the positive output end of each boost unit of the boost unit 506 are no longer directly coupled or coupled through low resistance, and the negative input end and the positive output end of each boost unit are directly coupled or are coupled through low resistance. The power sourcing equipment 50 calculates a corresponding insulation resistance-to-ground value as follows: $K = [2(V_1 - V_2) + V_{in1} - V_{in2}]/[2(I_{RCD\_1} - I_{RCD\_2})]$.

Further, the power sourcing equipment shown in FIG. 6a may further include an initial insulation resistance detection unit 507. For details, refer to a schematic diagram of another structure of the power sourcing equipment shown in FIG. 6b. As shown in FIG. 6b, the initial insulation resistance detection unit 507 is coupled between the positive direct current bus 504 and the negative direct current bus 505, and is configured to detect an initial insulation resistance value at the input end of the power sourcing equipment 50. In addition, the initial insulation resistance detection unit 507 includes a resistor $R_{t1}$ and a controllable switch $S_{\varepsilon i}$ that are connected in series between a positive output end of each direct current power supply of the direct current power supply 51 and the ground, and a resistor $R_{t2}$ and a controllable switch $S_{t2}$ that are connected in series between a negative output end of each direct current power supply and the ground.

In an optional embodiment, before the power sourcing equipment 50 is started, the controller 503 controls the controllable switch $S_{\varepsilon i}$ to be turned on and $S_{t2}$ to be turned off, where in this case, $R_{S1+}$, ..., and $R_{Sn+}$ are connected to $R_{t1}$ in parallel, and $R_{S1-}$, ..., and $R_{Sn-}$ are connected in parallel; and obtains a voltage $V_{BUS-\_PE1}$ between the negative direct current bus 505 and the ground and a voltage $V_{BUS+\_PE1}$ between the positive direct current bus 504 and the ground when the controllable switch $S_{\varepsilon i}$ is turned on and $S_{t2}$ is turned off. In addition, the controller 503 controls the controllable switch $S_{\varepsilon i}$ to be turned off and $S_{t2}$ to be turned on, where in this case, $R_{S1+}$, ..., and $R_{Sn+}$ are connected in parallel, and $R_{S1-}$, ..., and $R_{Sn-}$ are connected to $R_{t2}$ in parallel; obtains a voltage $V_{BUS-\_PE2}$ between the negative direct current bus 505 and the ground and a voltage $V_{BUS+\_PE2}$ between the positive direct current bus 504 and the ground when the controllable switch $S_{\varepsilon i}$ is turned off and $S_{t2}$ is turned on; then obtains simultaneous equations based on that a current value on a resistor $(R_{S1+}//...//R_{Sn+}//R_{t1})$ is equal to a current value on a resistor $(R_{S1-}//...//R_{Sn-})$ when $S_{\varepsilon i}$ is turned on and $S_{t2}$ is turned off and that a current value on the resistor $(R_{S1-}//...//R_{Sn-}//R_{t2})$ is equal to a current value on the resistor $(R_{S1+}//...//R_{Sn+})$ when $S_{t1}$ is turned off and $S_{t2}$ is turned on; and finally calculates the initial insulation resistance value $K_0$ at the input end of the power sourcing equipment 50. To be specific, the initial insulation resistance-to-ground value is as follows: $K_0 = 1/(1/R_{S1+} + \cdots + 1/R_{Sn+} + 1/R_{S1-} + \cdots + 1/R_{Sn-})$. In a normal case, an insulation resistance-to-ground value at a positive output end of a power supply is equal to or approximately equal to an insulation resistance-to-ground value at a negative output end of the same power supply. Therefore, $1/(1/R_{S1+} + \cdots + 1/R_{Sn+}) = 1/(1/R_{S1-} + \cdots + 1/R_{Sn-}) = 2K_0$.

Then the controller 503 may obtain $V_{in1}$, $V_1$, and $I_{RCD\_1}$ in the three manners in the embodiment shown in FIG. 6a. Details are not described herein again. The controller 503 determines, based on $V_{in1}$ and $V_1$, a voltage $V_{S1+\_PE} = \cdots = V_{Sn+\_PE} = V_1$ between a positive input end of each pair of input ends of the power sourcing equipment 50 and the ground and a voltage $V_{S1-\_PE} = \cdots = V_{Sn-\_PE} = V_1 - V_{in1}$ between a negative input end of each pair of input ends and the ground when the residual current detection unit 501 detects that the residual current of the power sourcing equipment 50 is $I_{RCD\_1}$. Because short time has elapsed since startup of the power sourcing equipment 50, insulation resistance in the direct current power supply 51 or the power sourcing equipment 50 has not changed. In this case, $V_{S1+\_PE} = \cdots = V_{Sn+\_PE} = V_1$, $V_{S1-\_PE} = \cdots = V_{Sn-\_PE} = V_1 - V_{in1}$, and $1/(1/R_{S1+} + \cdots + 1/R_{Sn+}) = 1/(1/R_{S1-} + \cdots + 1/R_{Sn-}) = 2K_0$ are substituted into a formula $I_{RCD\_ref} = V_{S1+\_PE}/R_{S1+} + \cdots + V_{Sn+\_PE}/R_{Sn+} + V_{S1-\_PE}/R_{S1-} + \cdots + V_{SN-\_PE}/S_{n-}$ to calculate a reference residual current value of the power sourcing equipment 50 when the residual current of the power sourcing equipment 50 is $I_{RCD\_1}$: $I_{RCD\_ref} = V_1/(2K_0) + (V_1 - V_{in1})/(2K_0)$. To cancel the offset of the RCD, the controller 503 calculates a difference between $I_{RCD\_ref}$ and $I_{RCD\_1}$ to obtain a residual current compensation value $I_{RCD\_com}$. To be specific, $I_{RCD\_com} = I_{RCD\_ref} - I_{RCD\_1} = (2V_1 - V_{n1})/(2K_0) - I_{RCD\_1}$.

Then the controller 503 may obtain $V_{in2}$, $V_2$, and $I_{RCD\_2}$ in the three manners in the embodiment shown in FIG. 6a. Details are not described herein again. The controller 503 determines, based on $V_{in2}$ and $V_2$, a voltage $V_{S1+\_PE} = \cdots = V_{Sn+\_PE} = V_2$ between a positive input end of each pair of input ends of the power sourcing equipment 50 and the ground and a voltage $V_{S1-\_PE} = \cdots = V_{Sn-\_PE} = V_2 - V_{in2}$ between a negative input end of each pair of input ends and the ground when the residual current detection unit 501 detects that the residual current of the power sourcing equipment 50 is $I_{RCD\_2}$. To cancel the offset of the RCD, the controller 503 substitutes $V_{S1+\_PE} = \cdots = V_{Sn+\_PE} = V_2$, $V_{S1-\_PE} = \cdots = V_{Sn-\_PE} = V_2 - V_{in2}$, $I_{RCD} = I_{RCD\_2}$, and $1/(1/R_{S1+} + \cdots + 1/R_{Sn+}) = 1/1/R_{S1-} + \cdots + 1/R_{Sn-}) = 2K$ into a formula $I_{RCD} + I_{RCD\_com} = V_{S1+\_PE}/R_{S1+} + \cdots + V_{Sn+\_PE}/R_{Sn+} + V_{S1-\_PE}/S_{1-} + \cdots + V_{Sn-\_PE}/R_{Sn-}$ to calculate the insulation resistance-to-ground value at the input end of the power sourcing equipment 50 as follows: $K = (2V_2 - V_{in2})/[2(I_{RCD\_2} + I_{RCD\_com})]$.

It should be noted that, when the voltage detection unit 502 detects a voltage between the negative input end of each pair of input ends of the power sourcing equipment 50 and the ground, the positive input end and the positive output end of each boost unit of the boost unit 506 are no longer directly coupled or coupled through low resistance, and the negative input end and the positive output end of each boost unit are directly coupled or are coupled through low resistance. A voltage between the negative input end of each pair of input ends of the power sourcing equipment 50 and the ground is a voltage between the positive direct current bus 504 and the ground. A corresponding residual current compensation value is as follows: $I_{RCD\_com} = (2V_1 + V_{in1})/(2K_0) - I_{RCD\_1}$. A corresponding insulation resistance-to-ground value is as follows: $K = (2V_2 + V_{in2})/[2(I_{RCD\_2} + I_{RCD\_com})]$.

In this embodiment of this application, the power sourcing equipment 50 may calculate the residual current compensation value based on the initial insulation resistance-to-ground value at the input end of the power sourcing equipment 50 that is detected by the initial insulation resistance detection unit 507, and cancel the offset of the RCD based on the residual current compensation value, to improve accuracy of detecting insulation resistance-to-ground at the input end of the power sourcing equipment 50. Therefore, applicability is high. In addition, in this application, an existing circuit (to be specific, the residual current detection unit 501, the voltage detection unit 502, the controller 503, and the initial insulation resistance detection unit 507) in the power sourcing equipment 50 is used to detect insulation resistance-to-ground at the input end of the power sourcing equipment 50. Therefore, circuit or device costs do not need to be additionally increased.

Based on the power sourcing equipment 50 shown in FIG. 6b, this application further provides a method for detecting insulation resistance at an input end of power sourcing equipment. The method includes the following step: When the first input end is the positive input end of each pair of input ends of the power sourcing equipment 50, the power sourcing equipment 50 calculates the residual current compensation value as follows: $I_{RCD\_com} = (2V_1 - V_{in1})/(2K_0) - I_{RCD\_1}$; and then calculates the insulation resistance-to-ground value at the input end of the power sourcing equipment 50 as follows: $K = (2V_2 - V_{in2})/[2(I_{RCD\_2} + I_{RCD\_com})]$.

Further, based on the power sourcing equipment 50 shown in FIG. 6b, this application further provides a method for detecting insulation resistance at an input end of power sourcing equipment. The method includes the following step: When the first input end is the negative input end of each pair of input ends of the power sourcing equipment 50, the positive input end and the positive output end of each boost unit of the boost unit 506 are no longer directly coupled or coupled through low resistance, and the negative input end and the positive output end of each boost unit are directly coupled or are coupled through low resistance. The power sourcing equipment 50 calculates a residual current compensation value as follows: $I_{RCD\_com} = (2V_1 + V_{in1})/(2K_0) - I_{RCD\_1}$; and then calculates a corresponding insulation resistance-to-ground value as follows:

$$K = \left(2V_2 + V_{in2}\right) \Big/ \left[2\left(I_{RCD\_2} + I_{RCD\_com}\right)\right].$$

Further, the power sourcing equipment shown in FIG. 6b may further include an inverter unit 508. For details, refer to a schematic diagram of another structure of the power sourcing equipment shown in FIG. 6c. As shown in FIG. 6c, two input ends of the inverter unit 508 are respectively coupled to the positive direct current bus 504 and the negative direct current bus 505, and an output end of the inverter unit 508 is coupled to the output end of the power sourcing equipment 50 through the residual current detection unit 501.

In this embodiment of this application, a manner of calculating, by the power sourcing equipment 50, the insulation resistance-to-ground value at the input end of the power sourcing equipment 50 is the same as the manner of calculating the insulation resistance-to-ground value at the input end of the power sourcing equipment 50 in the embodiment shown in FIG. 6b. Details are not described herein again.

In this embodiment of this application, the power sourcing equipment 50 may calculate the residual current compensation value based on the initial insulation resistance-to-ground value at the input end of the power sourcing equipment 50 that is detected by the initial insulation resistance detection unit 507, and cancel the offset of the RCD based on the residual current compensation value, to improve accuracy of detecting insulation resistance-to-ground at the input end of the power sourcing equipment 50. Therefore, applicability is high. In addition, in this application, an existing circuit (to be specific, the residual current detection unit 501, the voltage detection unit 502, the controller 503, and the initial insulation resistance detection unit 507) in the power sourcing equipment 50 is used to detect insulation resistance-to-ground at the input end of the power sourcing equipment 50. Therefore, circuit or device costs do not need to be additionally increased.

Based on the power sourcing equipment 50 shown in FIG. 6c, this application further provides a method for detecting insulation resistance at an input end of power sourcing equipment. The method includes the following step: When the first input end is the positive input end of each pair of input ends of the power sourcing equipment 50, the power sourcing equipment 50 calculates the residual current compensation value as follows: $I_{RCD\_com} = (2V_1 - V_{in1})/(2K_0)$ $- I_{RCD\_1}$; and then calculates the insulation resistance-to-ground value at the input end of the power sourcing equipment 50 as follows: $K = (2V_2 - V_{in2})/[2(I_{RCD\_2} + I_{RCD\_com})]$.

Further, based on the power sourcing equipment 50 shown in FIG. 6c, this application further provides a method for detecting insulation resistance at an input end of power sourcing equipment. The method includes the following step: When the first input end is the negative input end of each pair of input ends of the power sourcing equipment 50, the positive input end and the positive output end of each boost unit of the boost unit 506 are no longer directly coupled or coupled through low resistance, and the negative input end and the positive output end of each boost unit are directly coupled or are coupled through low resistance. The power sourcing equipment 50 calculates a residual current compensation value as follows: $I_{RCD\_com} = (2V_1 + V_{in1})/(2K_0) - I_{RCD\_1}$; and then calculates a corresponding insulation resistance-to-ground value as follows:

$$K = \left(2V_2 + V_{in2}\right)\Big/\left[2\left(I_{RCD\_2} + I_{RCD\_com}\right)\right].$$

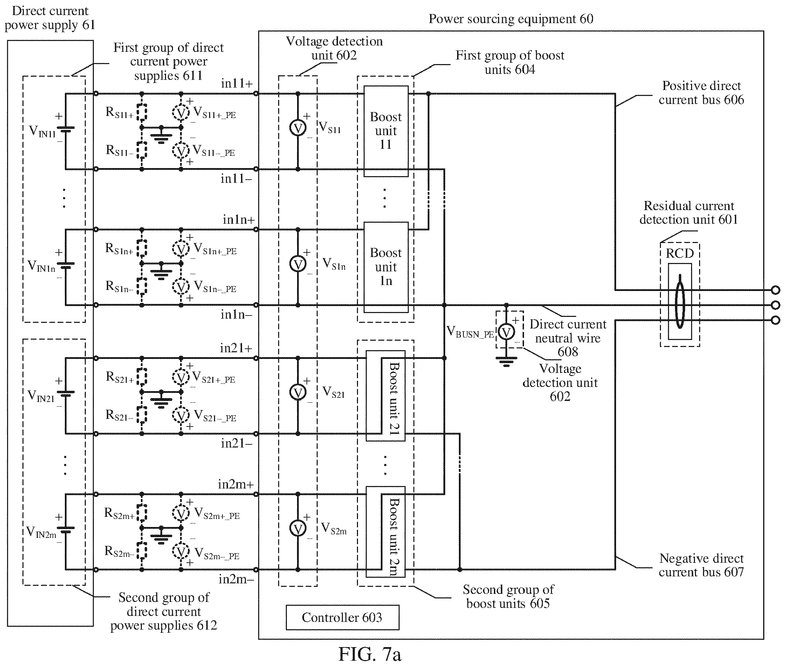

For example, FIG. 7a is a schematic diagram of still another structure of power sourcing equipment according to this application. As shown in FIG. 7a, the power sourcing equipment 60 includes a residual current detection unit 601, a voltage detection unit 602, a controller 603, a first group of boost units 604, a second group of boost units 605, a positive direct current bus 606, a negative direct current bus 607, and a direct current neutral wire 608. The power sourcing equipment 60 includes a first group of input ends and a second group of input ends. The first group of input ends includes n pairs of input ends: a first pair of input ends in11+ and in11-, ..., and an $n^{th}$ pair of input ends in1n+ and in1n-. The second group of input ends includes m pairs of input ends: a first pair of input ends in21+ and in21-, ..., and an $m^{th}$ pair of input ends in2m+ and in2m-. The first group of boost units 604 includes n boost units: a boost unit 11, ..., and a boost unit 1n. The second group of boost units 605 includes m boost units: a boost unit 21, ..., and a boost unit 2m. m and n are integers greater than or equal to 1.

As shown in FIG. 7a, the positive input end in11+ of the first pair of input ends in the first group of input ends is coupled to a positive output end of a direct current power supply $V_{IN11}$ in a first group of direct current power supplies 611, and the negative input end in11- of the first pair of input ends in the first group of input ends is coupled to a negative output end of the direct current power supply $V_{IN11}$; ...; and the positive input end in1n+ of the $n^{th}$ pair of input ends in the first group of input ends is coupled to a positive output end of a direct current power supply $V_{IN1n}$ in the first group of direct current power supplies 611, and the negative input end in1n- of the $n^{th}$ pair of input ends in the first group of input ends is coupled to a negative output end of the direct current power supply $V_{IN1n}$ in the first group of direct current power supplies 611.

The positive input end in21+ of the first pair of input ends in the second group of input ends is coupled to a positive output end of a direct current power supply $V_{IN21}$ in a second group of direct current power supplies 612, and the negative input end in21- of the first pair of input ends in the second group of input ends is coupled to a negative output end of the direct current power supply $V_{IN21}$; ...; and the positive input end in2m+ of the $m^{th}$ pair of input ends in the second group of input ends is coupled to a positive output end of a direct current power supply $V_{IN2m}$ in the second group of direct current power supplies 612, and the negative input end in2m- of the $m^{th}$ pair of input ends in the second group of input ends is coupled to a negative output end of the direct current power supply $V_{IN2m}$ in the second group of direct current power supplies 612.

The positive input end in11+ of the first pair of input ends in the first group of input ends is coupled to a positive input end of the boost unit 11, and the negative input end in11- of the first pair of input ends in the first group of input ends is coupled to a negative input end of the boost unit 11; ...; and the positive input end inln+ of the $n^{th}$ pair of input ends in the first group of input ends is coupled to a positive input end of the boost unit 1n, and the negative input end in1n-of the $n^{th}$ pair of input ends in the first group of input ends is coupled to a negative input end of the boost unit 1n.

The positive input end in21+ of the first pair of input ends in the second group of input ends is coupled to a positive input end of the boost unit 21, and the negative input end in21- of the first pair of input ends in the second group of input ends is coupled to a negative input end of the boost unit 21; ...; and the positive input end in2m+ of the $m^{th}$ pair of input ends in the second group of input ends is coupled to a positive input end of the boost unit 2m, and the negative input end in2m- of the $m^{th}$ pair of input ends in the second group of input ends is coupled to a negative input end of the boost unit 2m.

Positive output ends of the boost unit 11, ..., and the boost unit 1n are connected to the positive direct current bus 606, and negative output ends of the boost unit 11, ..., and the boost unit 1n are connected to the direct current neutral wire 608. Positive output ends of the boost unit 21, ..., and the boost unit 2m are connected to the direct current neutral wire 608, and negative output ends of the boost unit 21, ..., and the boost unit 2m are connected to the negative direct current bus 607.

A negative input end and a negative output end of each of the boost unit 11, ..., and the boost unit 1n are directly coupled or are coupled through low resistance coupling. A negative input end and a positive output end of each of the boost unit 21, ..., and the boost unit 2m are directly coupled or are coupled through low resistance.

The positive direct current bus 606, the negative direct current bus 607, and the direct current neutral wire 608 are coupled to an output end of the power sourcing equipment 60 through the residual current detection unit 601.

In an implementation, the controller 603 may control a switching transistor in each boost unit in the first group of boost units 604 and the second group of boost units 605, to control an input voltage at each pair of input ends of the power sourcing equipment 60 to be a first input voltage value $V_{in1}$. To be specific, $V_{in1} = V_{S11} = \cdots = V_{S1n} = V_{S21} = \cdots = V_{S2m} = V_{IN11} = \cdots = V_{IN1n} = V_{IN21} = \cdots = V_{IN2m}$. When $V_{in1} = V_{S11} = \cdots = V_{S1n} = V_{S21} = \cdots = V_{S2m}$, the controller 603 obtains a voltage $V_{BUSN\_PE}$ between the direct current neutral wire 608 of the power sourcing equipment 60 and ground through the voltage detection unit 602, to obtain a first voltage-to-ground $V_1$. Because a negative input end of each pair of input ends of the power sourcing equipment 60 is coupled to the direct current neutral wire 608, a voltage between the negative input end of each pair of input ends of the power sourcing equipment 60 and the ground is $V_1$. In addition, when $V_{in1} = V_{S11} = \cdots = V_{S1n} = V_{S21} = \cdots = V_{S2m}$, the controller 603 obtains a residual current of the power sourcing equipment 60 through the residual current detection unit 601, to obtain a first residual current value $I_{RCD\_1}$. Then the controller 603 may control an input voltage at each pair of input ends of the power sourcing equipment 60 to be a second input voltage value $V_{in2}$, where $V_{in2} \neq V_{in1}$. To be specific, $V_{in2} = V_{S11} = \cdots = V_{S1n} = V_{S21} = \cdots = V_{S2m} = V_{IN11} = \cdots = V_{IN1n} = V_{IN21} = \cdots = V_{IN2m}$. When $V_{in2} = V_{S11} = \cdots = V_{S1n} = V_{S21} = \cdots = V_{S2m}$, the controller 603 obtains a voltage $V_{BUSN\_PE}$ between the direct current neutral wire 608 of the power sourcing equipment 60 and the ground through the voltage detection unit 602, to obtain a second voltage-to-ground $V_2$. In addition, when $V_{in2} = V_{S11} = \cdots = V_{S1n} = V_{S21} = \cdots = V_{S2m}$, the controller 603 obtains a residual current of the power sourcing equipment 60 through the residual current detection unit 601, to obtain a second residual current value $I_{RCD\_2}$.

In another implementation, the controller 603 may control a switching transistor in each boost unit in the first group of boost units 604 and the second group of boost units 605, to control an input voltage at each pair of input ends of the power sourcing equipment 60 to be a first input voltage value $V_{in1}$. To be specific, $V_{in1} = V_{S11} = \cdots = V_{S1n} = V_{S21} = \cdots = V_{S2m} = V_{IN11} = \cdots = V_{IN1n} = V_{IN21} = \cdots = V_{IN2m}$. In addition, the controller 603 controls a voltage (corresponding to $V_{BUSN\_PE}$) between the direct current neutral wire 608 of the power sourcing equipment 60 and ground to be a first voltage-to-ground value $V_1$. Because a negative input end of each pair of input ends of the power sourcing equipment 60 is coupled to the direct current neutral wire 608, a voltage between the negative input end of each pair of input ends of the power sourcing equipment 60 and the ground is also . When $V_{BUSN\_PE} = V_1$, the controller 603 obtains a residual current of the power sourcing equipment 60 through the residual current detection unit 601, to obtain a first residual current value $I_{RCD\_1}$. Then the controller 603 may control an input voltage at each pair of input ends of the power sourcing equipment 60 to be a second input voltage value $V_{in2}$, where $V_{in2} = V_{in1}$. To be specific, $V_{in2} = V_{S11} = \cdots = V_{S1n} = V_{S21} = \cdots = V_{S2m} = V_{IN11} = \cdots = V_{IN1n} = V_{IN21} = \cdots = V_{IN2m}$. In addition, the controller 603 controls a voltage (corresponding to $V_{BUSN\_PE}$) between the direct current neutral wire 608 of the power sourcing equipment 60 and the ground to be a second voltage-to-ground value $V_2$, where $V_2 \neq V_1$. In addition, when $V_{BUSN\_PE} = V_2$, the controller 603 obtains a residual current of the power sourcing equipment 60 through the residual current detection unit 601, to obtain a second residual current value $I_{RCD\_2}$.

In still another implementation, the controller 603 may control a switching transistor in each boost unit in the first group of boost units 604 and the second group of boost units 605, to control an input voltage at each pair of input ends of the power sourcing equipment 60 to be a first input voltage value $V_{in1}$. To be specific, $V_{in1} = V_{S11} = \cdots = V_{S1n} = V_{S21} = \cdots = V_{S2m} = V_{IN11} = \cdots = V_{IN1n} = V_{IN21} = \cdots = V_{IN2m}$. In addition, the controller 603 controls a voltage (corresponding to $V_{BUSN\_PE}$) between the direct current neutral wire 608 of the power sourcing equipment 60 and ground to be a first voltage-to-ground value $V_1$. When $V_{in1} = V_{S11} = \cdots = V_{21n} = V_{S21} = \cdots = V_{S2m}$ and $V_{BUSN\_PE} = V_1$, the controller 603 obtains a residual current of the power sourcing equipment 60 through the residual current detection unit 601, to obtain a first residual current value $I_{RCD\_1}$. Then the controller 603 may control an input voltage at each pair of input ends of the power sourcing equipment 60 to be a second input voltage value $V_{in2}$. To be specific, $V_{in2} = V_{S11} = \cdots = V_{S1n} = V_{S21} = \cdots = V_{S2m} = V_{IN11} = \cdots = V_{IN1n} = V_{IN21} = \cdots = V_{IN2m}$ In addition, the controller 603 controls a voltage (corresponding to $V_{BUSN\_PE}$) between the direct current neutral wire 608 of the power sourcing equipment 60 and the ground to be a second voltage-to-ground value $V_2$. When $V_{in2} = V_{S11} = \cdots = V_{S1n} = V_{S21} = \cdots = V_{S2m}$ and $V_{BUSN\_PE} = V_2$, the controller 603 obtains a residual current of the power sourcing equipment 60 through the residual current detection unit 601, to obtain a second residual current value $I_{RCD\_2}$. It should be noted that values of $V_{in1}$, $V_{in2}$, $V_1$, and $V_2$ may include the following cases: (1) $V_{in2} \neq V_{in1}$ and $V_2 = V_1$; and (2) $V_{in2} \neq V_{in1}$ and $V_2 \neq V1$.

In an optional embodiment, the controller 603 determines, based on $V_{in1}$ and $V_1$, a voltage $V_{S11-\_PE} = \cdots = V_{S1n-\_PE} = V_{S21-\_PE} = \cdots = V_{S2m-\_PE} = V_1$ between a negative input end of each pair of input ends of the power sourcing equipment 60 and the ground and a voltage $V_{S11+\_PE} = \cdots = V_{S1n+\_PE} = V_{S21+\_PE} = \cdots = V_{S2m+\_PE} = V_1 + V_{in1}$ between a positive input end of each pair of input ends and the ground when the residual current detection unit 601 detects that the residual current of the power sourcing equipment 60 is $I_{RCD\_1}$. Considering that an RCD has an offset $I_{RCD\_set}$, the controller 603 substitutes $V_{S11-\_PE} = \cdots = V_{S1n-\_PE} = V_{S21-\_PE} = \cdots = V_{S2m-\_PE} = V_1$, $V_{S11+\_PE} = \cdots = V_{S1n+\_PE} = V_{S21+\_PE} = \cdots = V_{S2m+\_PE} = V_1 + V_{in1}$, and $I_{RCD} = I_{RCD\_1}$ into a formula $I_{RCD} = V_{S11+\_PE}/R_{S11+} + \cdots + V_{S1n+\_PE}/R_{S1n+} + V_{S21+\_PE}/R_{S21+} + \cdots + V_{S2m+\_PE}/R_{S2m+} + V_{S11-\_PE}/R_{S11-} + \cdots + V_{S1n-\_PE}/R_{S1n-} + V_{S21-\_PE}/R_{S21-} + \cdots + V_{S2m-\_PE}/R_{S2m-} + I_{RCD\_set}$ to obtain an equation 1: $I_{RCD\_1} = (V_{in1} + V_1)(1/R_{S11+} + ... + 1/R_{S1n+} + 1/R_{S21+} + ... + 1/R_{S2m+}) + V_1 * (1/R_{S11-} + \cdots + 1/R_{S1n-} + 1/R_{S21-} + \cdots + 1/R_{S2m-}) + I_{RCD\_set}$.

The controller 603 determines, based on $V_{in2}$ and $V_2$, a voltage $V_{S11-\_PE} = \cdots = V_{S1n-\_PE} = V_{S21-\_PE} = \cdots = V_{S2m-\_PE} = V_2$ between a negative input end of each pair of input ends of the power sourcing equipment 60 and the ground and a voltage $V_{S11+\_PE} = \cdots = V_{S1n+\_PE} = V_{S21+\_PE} = \cdots = V_{S2m+\_PE} = V_2 + V_{in2}$ between a positive input end of each pair of input ends and the ground when the residual current detection unit 601 detects that the residual current of the power sourcing equipment 60 is $I_{RCD\_2}$. Considering that an RCD has an offset $I_{RCD\_set}$, the controller 603 substitutes $V_{S11-\_PE} = \cdots = V_{S1n-\_PE} = V_{S21-\_PE} = \cdots = V_{S2m-\_PE} = V_2$, $V_{S11+\_PE} = \cdots = V_{S1n+\_PE} = V_{S21+\_PE} = \cdots = V_{S2m+\_PE} = V_2 + V_{in2}$, and $I_{RCD} = I_{RCD\_2}$ into a formula $I_{RCD} = V_{S11+\_PE}/R_{S11+} + \cdots + V_{S1n+\_PE}/R_{S1n+} + V_{S21+\_PE}/R_{S21+} + \cdots + V_{S2m+\_PE}/R_{S2m+} + V_{S11-\_PE}/R_{S11-} + \cdots + V_{S1n-\_PE}/R_{S1n-} + V_{S21-\_PE}/R_{S21-} + \cdots + V_{S2m-\_PE}/R_{S2m-} + I_{RCD\_set}$ to obtain an equation 2:

$$I_{RCD\_2} = \left(V_{in2} + V_2\right)\left(1/R_{S11+} + \cdots + 1/R_{S1n+} + 1/R_{S21+} + \cdots + 1/R_{S2m+}\right) + V_2 * \left(1/R_{S11-} + \cdots + 1/R_{S1n-} + 1/R_{S21-} + \cdots + 1/R_{S2m-}\right) + I_{RCD\_set}.$$

In a normal case, an insulation resistance-to-ground value at a positive input end of power sourcing equipment is equal to or approximately equal to an insulation resistance-to-ground value at a negative input end of the same power sourcing equipment. Therefore, $1/R_{S11+} + \cdots + 1/R_{S1n+} + 1/R_{S21+} + \cdots + 1/R_{S2m+} = 1/R_{S11-} + \cdots + 1/R_{S1n-} + 1/R_{S21-} + \cdots + 1/R_{S2m-} = 1/(2K)$, where K is an insulation resistance-to-ground value at the input end of the power sourcing equipment 60, to be specific, an insulation resistance-to-ground value of the direct current power supply 61, the power sourcing equipment 60, and the connection cable between the direct current power supply 61 and the power sourcing equipment 60. The controller 603 first substitutes $1/R_{S11+} + \cdots + 1/R_{S1n+} + 1/R_{S21+} + \cdots + 1/R_{S2m+} = 1/R_{S11-} + \cdots + 1/R_{S1n-} + 1/R_{S21-} + \cdots + 1/R_{S2m-} = 1/(2K)$ into the equation 1 and the equation 2 to obtain an equation 3 $I_{RCD\_1} = (V_{in1} + V_1)/(2K) + V_1/(2K) + I_{RCD\_set}$ and an equation 4 $I_{RCD\_2} = (V_{in2} + V_2)/(2K) + V_2/(2K) + I_{RCD\_set}$ respectively, and then subtracts the equation 4 from the equation 3 (that is, cancels $I_{RCD\_set}$) to obtain the following:

$$K = \left[2\left(V_1 - V_2\right) + V_{in1} - V_{in2}\right]/\left[2\left(I_{RCD\_1} - I_{RCD\_2}\right)\right].$$

It should be noted that, when the voltage detection unit 602 detects a voltage between the positive input end of each pair of input ends of the power sourcing equipment 60 and the ground, the negative input end and the negative output end of each boost unit in the first group of boost units 604 are no longer directly coupled or coupled through low resistance, the positive input end and the negative output end of each boost unit in the first group of boost units 604 are directly coupled or are coupled through low resistance, the negative input end and the positive output end of each boost unit in the second group of boost units 605 are no longer directly coupled or coupled through low resistance, and the positive input end and the positive output end of each boost unit in the second group of boost units 605 are directly coupled or are coupled through low resistance. A voltage between the positive input end of each pair of input ends of the power sourcing equipment 60 and the ground is a voltage between the direct current neutral wire 608 and the ground. In this case, the controller 603 determines, based on $V_{in1}$ and $V_1$, a voltage $V_{S11-\_PE} = \cdots = V_{S1n-\_PE} = V_{S21-\_PE} = \cdots = V_{S2m-\_PE} = V_1 - V_{in1}$ between a negative input end of each pair of input ends of the power sourcing equipment 60 and the ground and a voltage $V_{S11+\_PE} = \cdots = V_{S1n+\_PE} = V_{S21+\_PE} = \cdots = V_{S2m+\_PE} = V_1$ between a positive input end of each pair of input ends and the ground when the residual current detection unit 601 detects that the residual current of the power sourcing equipment 60 is $I_{RCD\_1}$. According to the manner of calculating the insulation resistance-to-ground at the input end of the power sourcing equipment in this embodiment, the controller 603 may obtain the insulation resistance-to-ground value at the input end of the power sourcing equipment 60 as follows:

$$K = \left[ 2\left(V_1 - V_2\right) - V_{in1} + V_{in2} \right] \Big/ \left[ 2\left(I_{RCD\_1} - I_{RCD\_2}\right) \right].$$

In this embodiment of this application, when calculating the insulation resistance-to-ground value at the input end of the power sourcing equipment 60, the power sourcing equipment 60 considers the offset of the RCD, and cancels the offset of the RCD based on residual current values and voltage parameter values of the power sourcing equipment 60 that are obtained by the power sourcing equipment 60 in two different operating statuses, to improve accuracy of detecting insulation resistance-to-ground at the input end of the power sourcing equipment 60. Therefore, applicability is high. In addition, in this application, an existing circuit (to be specific, the residual current detection unit 601, the voltage detection unit 602, and the controller 603) in the power sourcing equipment 60 is used to detect insulation resistance-to-ground at the input end of the power sourcing equipment 60. Therefore, circuit or device costs do not need to be additionally increased.
Based on the power sourcing equipment 60 shown in FIG. 7a, this application further provides a method for detecting insulation resistance at an input end of power sourcing equipment. The method includes the following step: When the first input end is the negative input end of each pair of input ends of the power sourcing equipment 60, the power sourcing equipment 60 calculates the insulation resistance-to-ground value at the input end of the power sourcing equipment 60 as follows:

$$K = \left[ 2\left(V_1 - V_2\right) + V_{in1} - V_{in2} \right] \Big/ \left[ 2\left(I_{RCD\_1} - I_{RCD\_2}\right) \right].$$

Further, based on the power sourcing equipment 60 shown in FIG. 7a, this application further provides a method for detecting insulation resistance at an input end of power sourcing equipment. The method includes the following step: When the first input end is the positive input end of each pair of input ends of the power sourcing equipment 60, the negative input end and the negative output end of each boost unit in the first group of boost units 604 are no longer directly coupled or coupled through low resistance, the positive input end and the negative output end of each boost unit in the first group of boost units 604 are directly coupled or are coupled through low resistance, the negative input end and the positive output end of each boost unit in the second group of boost units 605 are no longer directly coupled or coupled through low resistance, and the positive input end and the positive output end of each boost unit in the second group of boost units 605 are directly coupled or are coupled through low resistance. The power sourcing equipment 60 calculates the insulation resistance-to-ground value at the input end of the power sourcing equipment 60 as follows:

$$K = \left[ 2\left(V_1 - V_2\right) - V_{in1} + V_{in2} \right] \Big/ \left[ 2\left(I_{RCD\_1} - I_{RCD\_2}\right) \right].$$

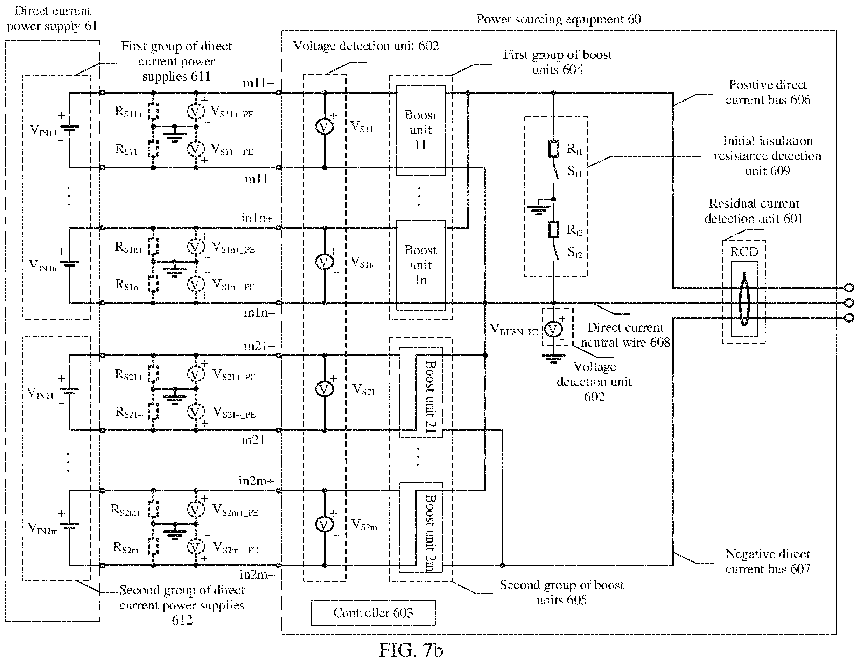

Further, the power sourcing equipment shown in FIG. 7a may further include an initial insulation resistance detection unit 609. For details, refer to a schematic diagram of still another structure of the power sourcing equipment shown in FIG. 7b. As shown in FIG. 7b, the initial insulation resistance detection unit 609 is coupled between the positive direct current bus 606 and the direct current neutral wire 608, and is configured to detect an initial insulation resistance value at the input end of the power sourcing equipment 60. In addition, the initial insulation resistance detection unit 609 includes a resistor $R_{t1}$ and a controllable switch $S_{t1}$ that are connected in series between a positive output end of each direct current power supply in the first group of direct current power supplies 611 and the ground, and a resistor $R_{t2}$ and

a controllable switch $S_{t2}$ that are connected in series between a negative output end of each direct current power supply in the first group of current power supplies 611 and the ground. In addition, the resistor $R_{t1}$ and the controllable switch $S\varepsilon i$ are further connected in series between a positive output end of each direct current power supply in the second group of direct current power supplies 612 and the ground, and the resistor $R_{t2}$ and the controllable switch $S_{t2}$ are further connected in series between a negative output end of each direct current power supply in the second group of direct current power supplies 612 and the ground.

In an optional embodiment, before the power sourcing equipment 60 is started, the controller 603 controls the controllable switch $S\varepsilon i$ to be turned on and $S_{t2}$ to be turned off, where in this case, $R_{S11+}$, ..., $R_{S1n+}$, $R_{S21+}$, ..., and $R_{S2m+}$ are connected to $R_{t1}$ in parallel, and $R_{S11-}$, ..., $R_{S1n-}$, $R_{S21-}$, ..., and $R_{S2m-}$ are connected in parallel; and obtains a voltage $V_{BUSN\_PE1}$ between the direct current neutral wire 608 and the ground and a voltage $V_{BUS+\_PE1}$ between the positive direct current bus 606 and the ground when the controllable switch $S\varepsilon i$ is turned on and $S_{t2}$ is turned off. In addition, the controller 603 controls the controllable switch $S\varepsilon i$ to be turned off and $S^{t2}$ to be turned on, where in this case, $R_{S11+}$, ..., $R_{S1n+}$, $R_{S21+}$, ..., and $R_{S2m+}$ are connected in parallel, and $R_{S11-}$, ..., $R_{S1n-}$, $R_{S21-}$, ..., and $R_{S2m-}$ are connected to $R_{t2}$ in parallel; obtains a voltage $V_{BUSN\_PE2}$ between the direct current neutral wire 608 and the ground and a voltage $V_{BUS+\_PE2}$ between the positive direct current bus 606 and the ground when the controllable switch $S\varepsilon i$ is turned off and $S_{t2}$ is turned on; then obtains simultaneous equations based on that a current value on a resistor $(R_{S11+}//.../R_{S1n+}//R_{S21+}//.../R_{S2m+}//R_{t1})$ is equal to a current value on a resistor $(R_{S11}//.../R_{S1n}// R_{S21}//.../R_{S2-})$ when $S_{t1}$ is turned on and $S_{t2}$ is turned off and that a current value on the resistor $(R_{S11}//.../R_{S1n}//R_{S21}//.../R_{S2m}//R_{t2})$ is equal to a current value on the resistor $(R_{S11+}//.../D_{S1n+}// R_{S21+}//.../ R_{S2m+})$ when $S_{t1}$ is turned off and $S_{t2}$ is turned on; and finally calculates the initial insulation resistance value $K_0$ at the input end of the power sourcing equipment 60. To be specific, the initial insulation resistance-to-ground value is as follows: $K_0 = 1/(1/R_{S11+} + \cdots + 1/R_{S1n+} + 1/R_{S11-} + \cdots + 1/R_{S1n-} + 1/R_{S21+} + \cdots + 1/R_{S2m+} + 1/R_{S21-} + \cdots + 1/R_{S2m-})$. In a normal case, an insulation resistance-to-ground value at a positive output end of a power supply is equal to or approximately equal to an insulation resistance-to-ground value at a negative output end of the same power supply. Therefore, $1/(1/RS_{1+} + \cdots + 1/R_{Sn+} + 1/R_{S21+} + \cdots + 1/R_{S2m+} = 1/(1/R_{S1-} + \cdots + 1/R_{Sn-} + 1/R_{S21-} + \cdots + 1/R_{S2m-} = 2K_0$.

Then the controller 603 may obtain $V_{in1}$, $V_1$, and $I_{RCD\_1}$ in the three manners in the embodiment shown in FIG. 7a. Details are not described herein again. The controller 603 determines, based on $V_{in1}$ and $V_1$, a voltage $V_{S11+\_PE} = \cdots = V_{S1n+\_PE} = V_{S21+\_PE} = \cdots = V_{S2m+\_PE} = V_{in1} + V_1$ between a positive input end of each pair of input ends of the power sourcing equipment 60 and the ground and a voltage $V_{S11-\_PE} = \cdots = V_{S1n-\_PE} = V_{S21-\_PE} = \cdots = V_{S2m-\_PE} = V_1$ between a negative input end of each pair of input ends and the ground when the residual current detection unit 601 detects that the residual current of the power sourcing equipment 60 is $I_{RCD\_1}$. Because short time has elapsed since startup of the power sourcing equipment 60, insulation resistance in the direct current power supply 61 or the power sourcing equipment 60 has not changed. In this case, $V_{S11+\_PE} = \cdots = V_{S1n+\_PE} = V_{S21+\_PE} = \cdots = V_{S2m+\_PE} = V_{in1} + V_1$, $V_{S11-\_PE} = \cdots = V_{S1n-\_PE} = V_{S21-\_PE} = \cdots = V_{S2m-\_PE} = V_1$, and $1/(1/RS_{1+} + \cdots + 1/R_{Sn+} + 1/R_{S21+} + \cdots + 1/R_{S2m+} = 1/(1/R_{S1-} + \cdots + 1/R_{Sn-} + 1/R_{S21-} + \cdots + 1/R_{S2m-}) = 2K_0$ are substituted into a formula $I_{RCD\_ref} = V_{S11+\_PE}/R_{S11+} + \cdots + V_{S1n+\_PE}/R_{S1n+} + V_{S21+\_PE}/R_{S21+} + \cdots + V_{S2m+\_PE}/R_{S2m+} + V_{S11-\_PE}/R_{S11-} + \cdots + V_{S1n-\_PE}/R_{S1n-} + V_{S21-\_PE}/R_{S21-} + \cdots + V_{S2m-\_PE}/R_{S2m-}$ to calculate a reference residual current value of the power sourcing equipment 60 when the residual current of the power sourcing equipment 60 is $I_{RCD\_1}$: $I_{RCD\_ref} = V_1/(2K_0) + (V_1 + V_{in1})/(2K_0)$. To cancel the offset of the RCD, the controller 603 calculates a difference between $I_{RCD\_ref}$ and $I_{RCD\_1}$ to obtain a residual current compensation value $I_{RCD\_com}$. To be specific, $I_{RCD\_com} = I_{RCD\_ref} - I_{RCD\_1} = (2V_1 + V_{in1})/(2K_0) - I_{RCD\_1}$

Then the controller 603 may obtain $V_{in2}$, $V_2$, and $I_{RCD\_2}$ in the three manners in the embodiment shown in FIG. 7a. Details are not described herein again. The controller 603 determines, based on $V_{in2}$ and $V_2$, a voltage $V_{S11+\_PE} = \cdots = V_{S1n+\_PE} = V_{S21+\_PE} = \cdots = V_{S2m+\_PE} = V_{in2} + V_2$ between a positive input end of each pair of input ends of the power sourcing equipment 60 and the ground and a voltage $V_{S11-\_PE} = \cdots = V_{S1n-\_PE} = V_{S21-\_PE} = \cdots = V_{S2m-\_PE} = V_2$ between a negative input end of each pair of input ends and the ground when the residual current detection unit 601 detects that the residual current of the power sourcing equipment 60 is $I_{RCD\_2}$. To cancel the offset of the RCD, the controller 603 substitutes $V_{S11+\_PE} = \cdots = V_{S1n+\_PE} = V_{S21+\_PE} = \cdots = V_{S2m+\_PE} = V_{in2} + V_2$, $V_{S11-\_PE} = \cdots = V_{S1n-\_PE} = V_{S21-\_PE} = \cdots = V_{S2m-\_PE} = V_2$, $I_{RCD} = I_{RCD\_2}$, and $1/(1/RS_{1+} + \cdots + 1/R_{Sn+} + 1/R_{S21+} + \cdots + 1/R_{S2m+}) = 1/(1/R_{S1-} + \cdots + 1/R_{Sn-} + 1/R_{S21-} + \cdots + 1/R_{S2m-}) = 2K_0$ into a formula $I_{RCD} + I_{RCD\_com} = V_{S11+\_PE}/R_{S11+} + \cdots + V_{S1n+\_PE}/R_{S1n+} + V_{S21+\_PE}/R_{S21+} + \cdots + V_{S2m\_PE}/R_{S2m+} + V_{S11-\_PE}/R_{S11-} + \cdots + V_{S1n-\_PE}/R_{S1n-} + V_{S21-\_PE}/R_{S21-} + \cdots + V_{S2m-\_PE}/R_{S2m-}$ to calculate the insulation resistance-to-ground value at the input end of the power sourcing equipment 60 as follows:

$$K = \left(2V_2 + V_{in2}\right) \Big/ \left[2\left(I_{RCD\_2} + I_{RCD\_com}\right)\right].$$

It should be noted that, when the voltage detection unit 602 detects a voltage between the positive input end of each pair of input ends of the power sourcing equipment 60 and the ground, the negative input end and the negative output end of each boost unit in the first group of boost units 604 are no longer directly coupled or coupled through low resistance, the positive input end and the negative output end of each boost unit in the first group of boost units 604 are directly coupled or are coupled through low resistance, the negative input end and the positive output end of each boost unit in the second group of boost units 605 are no longer directly coupled or coupled through low resistance, and the positive input end and the positive output end of each boost unit in the second group of boost units 605 are directly coupled or are coupled through low resistance. A voltage between the positive input end of each pair of input ends of the power sourcing equipment 60 and the ground is a voltage between the direct current neutral wire 608 and the ground. In this case, the controller 603 determines, based on $V_{in1}$ and $V_1$, a negative input end $V_{S11-\_PE} = \cdots = V_{Sin-\_PE} = V_{S21-\_PE} = \cdots = V_{S2m-\_PE} = V_1 - V_{in1}$ of each pair of input ends of the power sourcing equipment 60 and a voltage $V_{S11+\_PE} = \cdots = V_{Sin+\_PE} = V_{S21+\_PE} = \cdots = V_{S2m+\_PE} = V_1$ between a positive input end of each pair of input ends and the ground when the residual current detection unit 601 detects that the residual current of the power sourcing equipment 60 is $I_{RCD\_1}$. According to the manner of calculating the residual current compensation value in this embodiment, the controller 603 may obtain the residual current compensation value of the power sourcing equipment 60 as follows: $I_{RCD\_com} = (2V_1 - V_{n1})/(2K_0) - I_{RCD}\_1$. Further, according to the manner of calculating the insulation resistance-to-ground at the input end of the power sourcing equipment 60 in this embodiment, the controller 603 may obtain the insulation resistance-to-ground value at the input end of the power sourcing equipment 60 as follows: $K = (2V_2 - V_{in2})/[2(I_{RCD\_2} + I_{RCD\_com})]$ .

In addition, the initial insulation resistance detection unit 609 may alternatively be coupled between the direct current neutral wire 608 and the negative direct current bus 607, or coupled between the positive direct current bus 606 and the negative direct current bus 607. A parallel relationship between the resistor $R_{t1}$, the resistor $R_{t2}$, and insulation resistance-to-ground changes. The foregoing method for calculating the insulation resistance-to-ground value at the input end of the power sourcing equipment 60 remains unchanged. Details are not described again.

In this embodiment of this application, the power sourcing equipment 60 may calculate the residual current compensation value based on the initial insulation resistance-to-ground value at the input end of the power sourcing equipment 60 that is detected by the initial insulation resistance detection unit 609, and cancel the offset of the RCD based on the residual current compensation value, to improve accuracy of detecting insulation resistance-to-ground at the input end of the power sourcing equipment 60. Therefore, applicability is high. In addition, in this application, an existing circuit (to be specific, the residual current detection unit 601, the voltage detection unit 602, the controller 603, and the initial insulation resistance detection unit 609) in the power sourcing equipment 60 is used to detect insulation resistance-to-ground at the input end of the power sourcing equipment 60. Therefore, circuit or device costs do not need to be additionally increased.

Based on the power sourcing equipment 60 shown in FIG. 7b, this application further provides a method for detecting insulation resistance at an input end of power sourcing equipment. The method includes the following step: When the first input end is the negative input end of each pair of input ends of the power sourcing equipment 60, the power sourcing equipment 60 calculates the residual current compensation value as follows: $I_{RCD\_com} = (2V_1 + V_{in1})/(2K_0) - I_{RCD}\_1$; and then calculates the insulation resistance-to-ground value at the input end of the power sourcing equipment 60 as follows: $K = (2V_2 + V_{in2})/[2(I_{RCD-2} + I_{RCD-com})]$.

Further, based on the power sourcing equipment 60 shown in FIG. 7b, this application further provides a method for detecting insulation resistance at an input end of power sourcing equipment. The method includes the following step: When the first input end is the positive input end of each pair of input ends of the power sourcing equipment 60, the negative input end and the negative output end of each boost unit in the first group of boost units 604 are no longer directly coupled or coupled through low resistance, the positive input end and the negative output end of each boost unit in the first group of boost units 604 are directly coupled or are coupled through low resistance, the negative input end and the positive output end of each boost unit in the second group of boost units 605 are no longer directly coupled or coupled through low resistance, and the positive input end and the positive output end of each boost unit in the second group of boost units 605 are directly coupled or are coupled through low resistance. The power sourcing equipment 60 calculates the residual current compensation value as follows: $I_{RCD\_com} = (2V_1 - V_{in1})/(2K_0) - I_{RCD}\_1$; and then calculates the insulation resistance-to-ground value at the input end of the power sourcing equipment 60 as follows: $K = (2V_2 - V_{in2})/[2(I_{RCD\_2} + I_{RCD\_com})]$ .

It should be noted that the initial insulation resistance detection unit in this application is described by using the initial insulation resistance detection unit shown in FIG. 3b, FIG. 4b, FIG. 5b, FIG. 5c, FIG. 6b, FIG. 6c, and FIG. 7b. Initial insulation resistance detection units in other forms are also feasible, and all fall within the protection scope of this application.

According to the power sourcing equipment and the method for detecting insulation resistance at an input end of power sourcing equipment in this application, the offset of the RCD can be compensated for or canceled, to improve accuracy of detecting the insulation resistance-to-ground at the input end of the power sourcing equipment, and the insulation resistance-to-ground at the input end of the power sourcing equipment can be detected without additionally increasing circuit or device costs. Therefore, applicability is high.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

**Claims**

1. Power sourcing equipment, wherein an input end of the power sourcing equipment is coupled to an output end of a direct current power supply, and the power sourcing equipment comprises a residual current detection unit, a voltage detection unit, and a controller;

    the voltage detection unit is configured to detect a voltage parameter of the power sourcing equipment;
    the residual current detection unit is configured to: when the voltage parameter of the power sourcing equipment comprises a first preset voltage parameter value, detect a first residual current value of the power sourcing equipment; and when the voltage parameter of the power sourcing equipment comprises a second preset voltage parameter value, detect a second residual current value of the power sourcing equipment, wherein the first preset voltage parameter value and the second preset voltage parameter value are different from each other; and
    the controller is configured to determine an insulation resistance value at the input end of the power sourcing equipment based on the first preset voltage parameter value, the first residual current value, the second preset voltage parameter value, and the second residual current value.

2. The power sourcing equipment according to claim 1, wherein the voltage parameter comprises an input voltage and a voltage-to-ground of the power sourcing equipment, the voltage-to-ground is a voltage between a first input end of the power sourcing equipment and ground, the first preset voltage parameter value comprises a first input voltage value, and the second preset voltage parameter value comprises a second input voltage value; and
    the controller is configured to determine the insulation resistance value at the input end of the power sourcing equipment based on the first input voltage value, a first voltage-to-ground value, the first residual current value, the second input voltage value, a second voltage-to-ground, and the second residual current value, wherein the first voltage-to-ground value is a voltage that is between the first input end of the power sourcing equipment and the ground and that is detected by the voltage detection unit when the input voltage of the power sourcing equipment is the first input voltage value, and the second voltage-to-ground is a voltage that is between the first input end of the power sourcing equipment and the ground and that is detected by the voltage detection unit when the input voltage of the power sourcing equipment is the second input voltage value.

3. The power sourcing equipment according to claim 1, wherein the voltage parameter comprises an input voltage and a voltage-to-ground of the power sourcing equipment, the voltage-to-ground is a voltage between a first input end of the power sourcing equipment and ground, the first preset voltage parameter value comprises a first voltage-to-ground value, and the second preset voltage parameter value comprises a second voltage-to-ground value; and
    the controller is configured to determine the insulation resistance value at the input end of the power sourcing equipment based on a first input voltage value, the first voltage-to-ground value, the first residual current value, a second input voltage value, the second voltage-to-ground, and the second residual current value, wherein the first input voltage is an input voltage of the power sourcing equipment that is detected by the voltage detection unit when the voltage-to-ground is the first voltage-to-ground value, and the second input voltage is an input voltage of the power sourcing equipment that is detected by the voltage detection unit when the voltage-to-ground is the second voltage-to-ground value.

4. The power sourcing equipment according to claim 1, wherein the voltage parameter comprises an input voltage and a voltage-to-ground of the power sourcing equipment, the voltage-to-ground is a voltage between a first input end of the power sourcing equipment and ground, the first preset voltage parameter value comprises a first input voltage value and a first voltage-to-ground value, and the second preset voltage parameter value comprises a second input voltage value and a second voltage-to-ground value.

5. The power sourcing equipment according to any one of claims 2 to 4, wherein when the first input end is a positive input end of the power sourcing equipment, the insulation resistance value at the input end of the power sourcing equipment is as follows:

$$K = \left[ 2\left(V_1 - V_2\right) - V_{in1} + V_{in2} \right] / \left[ 2\left(I_{RCD\_1} - I_{RCD\_2}\right) \right];$$

or
when the first input end is a negative input end of the power sourcing equipment, the insulation resistance value at the input end of the power sourcing equipment is as follows: $K = [2(V_1 - V_2) + V_{in1} - V_{in2}]/[2(I_{RCD\_1} - I_{RCD\_2})]$ , wherein $K$ is the insulation resistance value, $V_1$ is the first voltage-to-ground value, $V_2$ is the second voltage-to-ground value, $V_{in1}$ is the first input voltage value, $V_{in2}$ is the second input voltage value, $I_{RCD\_1}$ is the first residual current value, and $I_{RCD\_2}$ is the second residual current value.

6. The power sourcing equipment according to any one of claims 2 to 4, wherein determining the insulation resistance value at the input end of the power sourcing equipment based on the first input voltage value, the first voltage-to-ground value, the first residual current value, the second input voltage value, the second voltage-to-ground value, and the second residual current value comprises:
determining a residual current compensation value based on an initial insulation resistance value at the input end of the power sourcing equipment, the first input voltage value, the first voltage-to-ground value, and the first residual current value, and determining the insulation resistance value at the input end of the power sourcing equipment based on the residual current compensation value, the second input voltage value, the second voltage-to-ground value, and the second residual current value.

7. The power sourcing equipment according to claim 6, wherein when the first input end is a positive input end of the power sourcing equipment, the residual current compensation value is as follows: $I_{RCD\_com} = (2V_1 - V_{in1})/(2K_0) - I_{RCD\_1}$; or
when the first input end is a negative input end of the power sourcing equipment, the residual current compensation value is follows: $I_{RCD\_com} = (2V_1 + V_{in1})/(2K_0) - I_{RCD\_1}$ , wherein $I_{RCD\_com}$ is the residual current compensation value, $V_1$ is the first voltage-to-ground value, $V_{in1}$ is the first input voltage value, $K_0$ is the initial insulation resistance value, and $I_{RCD\_1}$ is the first residual current value.

8. The power sourcing equipment according to claim 6, wherein when the first input end is a positive input end of the power sourcing equipment, the insulation resistance value at the input end of the power sourcing equipment is as follows: $K = (2V_2 - V_{in2})/[2(I_{RCD\_2} + I_{RCD\_com})]$; or
when the first input end is a negative input end of the power sourcing equipment, the insulation resistance value at the input end of the power sourcing equipment is as follows: $K = (2V_2 + V_{in2})/[2(I_{RCD\_2} + I_{RCD\_com})]$, wherein $K$ is the insulation resistance value, $V_2$ is the second voltage-to-ground value, $V_{in2}$ is the second input voltage value, $I_{RCD\_2}$ is the second residual current value, and $I_{RCD\_com}$ is the residual current compensation value.

9. The power sourcing equipment according to claims 1 to 8, wherein the power sourcing equipment further comprises a positive direct current bus and a negative direct current bus, the positive direct current bus is coupled to the positive input end of the power sourcing equipment, the negative direct current bus is coupled to the negative input end of the power sourcing equipment, and the positive direct current bus and the negative direct current bus are coupled to an output end of the power sourcing equipment through the residual current detection unit.

10. The power sourcing equipment according to claims 1 to 9, wherein the power sourcing equipment further comprises an initial insulation resistance detection unit, a positive direct current bus, and a negative direct current bus, wherein the initial insulation resistance detection unit is configured to detect an initial insulation resistance value at the input end of the power sourcing equipment, the positive direct current bus is coupled to the positive input end of the power sourcing equipment, the negative direct current bus is coupled to the negative input end of the power sourcing equipment, and the initial insulation resistance detection unit is coupled between the positive direct current bus and the negative direct current bus.

11. The power sourcing equipment according to claims 2 to 10, wherein the power sourcing equipment further comprises a positive direct current bus, a negative direct current bus, and a boost unit;

a positive input end of the boost unit is coupled to the positive input end of the power sourcing equipment, and a negative input end of the boost unit is coupled to the negative input end of the power sourcing equipment;
a positive output end of the boost unit is coupled to the positive direct current bus, and a negative output end of the boost unit is coupled to the negative direct current bus; and

when the first input end of the power sourcing equipment is the negative input end, the negative input end of the boost unit is directly coupled to the negative output end of the boost unit or is coupled to the negative output end of the boost unit through low resistance, and the voltage-to-ground is a voltage between the negative direct current bus and the ground;

when the first input end of the power sourcing equipment is the positive input end, the positive input end of the boost unit is directly coupled to the negative output end of the boost unit or is coupled to the negative output end of the boost unit through low resistance, and the voltage-to-ground is a voltage between the negative direct current bus and the ground;

when the first input end of the power sourcing equipment is the positive input end, the positive input end of the boost unit is directly coupled to the positive output end of the boost unit or is coupled to the positive output end of the boost unit through low resistance, and the voltage-to-ground is a voltage between the positive direct current bus and the ground; or

when the first input end of the power sourcing equipment is the negative input end, the negative input end of the boost unit is directly coupled to the positive output end of the boost unit or is coupled to the positive output end of the boost unit through low resistance, and the voltage-to-ground is a voltage between the positive direct current bus and the ground.

12. The power sourcing equipment according to claims 2 to 11, wherein the power sourcing equipment further comprises a positive direct current bus and a negative direct current bus, the direct current power supply comprises at least two direct current power supplies, and the input end of the power sourcing equipment comprises at least two pairs of input ends;

each pair of input ends of the at least two pairs of input ends are correspondingly coupled to two output ends of each of the at least two direct current power supplies;

a positive input end of each pair of input ends is coupled to the positive direct current bus, and a negative input end of each pair of input ends is coupled to the negative direct current bus; and

the input voltage of the power sourcing equipment comprises a voltage of each pair of input ends.

13. The power sourcing equipment according to claims 2 to 8, wherein the power sourcing equipment further comprises a positive direct current bus, a negative direct current bus, a direct current neutral wire, a first group of boost units, and a second group of boost units, the first group of boost units and the second group of boost units each comprise at least one boost unit, the direct current power supply comprises a first group of direct current power supplies and a second group of direct current power supplies, the first group of direct current power supplies and the second group of direct current power supplies each comprise at least one direct current power supply, the input end of the power sourcing equipment comprises a first group of input ends and a second group of input ends, and the first group of input ends and the second group of input ends each comprise at least one pair of input ends;

each pair of input ends in the first group of input ends are correspondingly coupled to two output ends of each direct current power supply in the first group of direct current power supplies;

each pair of input ends in the second group of input ends are correspondingly coupled to two output ends of each direct current power supply in the second group of direct current power supplies;

two input ends of each boost unit in the first group of boost units are correspondingly coupled to each pair of input ends in the first group of input ends;

two input ends of each boost unit in the second group of boost units are correspondingly coupled to each pair of input ends in the second group of input ends;

a positive output end of each boost unit in the first group of boost units is connected to the positive direct current bus, and a negative output end of each boost unit in the first group of boost units is connected to the direct current neutral wire;

a positive output end of each boost unit in the second group of boost units is connected to the direct current neutral wire, and a negative output end of each boost unit in the second group of boost units is connected to the negative direct current bus; and

when the first input end is the negative input end, a negative input end and the negative output end of each boost unit in the first group of boost units are directly coupled or are coupled through low resistance, a negative input end and the positive output end of each boost unit in the second group of boost units are directly coupled or are coupled through low resistance, and the voltage-to-ground is a voltage between the direct current neutral wire and the ground; or

when the first input end is the positive input end, a positive input end and the negative output end of each boost unit in the first group of boost units are directly coupled or are coupled through low resistance, a positive input end and the positive output end of each boost unit in the second group of boost units are directly coupled or are coupled through low resistance, and the voltage-to-ground is a voltage between the direct current neutral wire and the ground.

14. The power sourcing equipment according to claim 13, wherein the power sourcing equipment further comprises an initial insulation resistance detection unit, the initial insulation resistance detection unit is configured to detect an initial insulation resistance value of an input end of the power sourcing equipment, and the initial insulation resistance detection unit is coupled to any two of the positive direct current bus, the negative direct current bus, and the direct current neutral wire.

15. The power sourcing equipment according to claim 13 or 14, wherein the positive direct current bus, the negative direct current bus, and the direct current neutral wire are coupled to an output end of the power sourcing equipment through the residual current detection unit.

16. A method for detecting insulation resistance at an input end of power sourcing equipment, wherein the input end of the power sourcing equipment is coupled to an output end of a direct current power supply, and the method comprises:

detecting a voltage parameter of the power sourcing equipment;
when the voltage parameter of the power sourcing equipment comprises a first preset voltage parameter value, obtaining a first residual current value of the power sourcing equipment through detection, and when the voltage parameter of the power sourcing equipment comprises a second preset voltage parameter value, obtaining a second residual current value of the power sourcing equipment through detection, wherein the first preset voltage parameter value and the second preset voltage parameter value are different from each other;
determine an insulation resistance value at the input end of the power sourcing equipment based on the first preset operating status parameter, the first residual current value, the second preset operating status parameter, and the second residual current value.

17. The method according to claim 16, wherein the voltage parameter comprises an input voltage and a voltage-to-ground of the power sourcing equipment, the voltage-to-ground is a voltage between a first input end of the power sourcing equipment and ground, the first preset voltage parameter value comprises a first input voltage value, and the second preset voltage parameter value comprises a second input voltage value;
the determining an insulation resistance value at the input end of the power sourcing equipment based on the first preset operating status parameter, the first residual current value, the second preset operating status parameter, and the second residual current value comprises:
determining an insulation resistance value at the input end of the power sourcing equipment based on the first input voltage value, the first voltage-to-ground value, the first residual current value, the second input voltage value, the second voltage-to-ground, and the second residual current value, wherein the first voltage-to-ground value is a voltage that is between the first input end of the power sourcing equipment and the ground and that is detected when the input voltage of the power sourcing equipment is the first input voltage value; the second voltage-to-ground is a voltage that is between the first input end of the power sourcing equipment and the ground and that is detected when the input voltage of the power sourcing equipment is the second input voltage value.

18. The method according to claim 16, wherein the voltage parameter comprises an input voltage and a voltage-to-ground of the power sourcing equipment, the voltage-to-ground is a voltage between a first input end of the power sourcing equipment and ground, the first preset voltage parameter value comprises a first voltage-to-ground value, and the second preset voltage parameter value comprises a second voltage-to-ground value;
the determining an insulation resistance value at the input end of the power sourcing equipment based on the first preset operating status parameter, the first residual current value, the second preset operating status parameter, and the second residual current value comprises:
determining an insulation resistance value at the input end of the power sourcing equipment based on a first input voltage value, the first voltage-to-ground value, the first residual current value, the second input voltage value, the second voltage-to-ground, and the second residual current value, wherein the first input voltage is an input voltage of the power sourcing equipment that is detected when the voltage-to-ground is the first voltage-to-ground value, and the second input voltage is an input voltage of the power sourcing equipment that is detected when the voltage-to-ground is the second voltage-to-ground value.

19. The method according to claim 16, wherein the voltage parameter comprises an input voltage and a voltage-to-ground of the power sourcing equipment, the voltage-to-ground is a voltage between a first input end of the power sourcing equipment and ground, the first preset voltage parameter value comprises a first input voltage value and a first voltage-to-ground value, and the second preset voltage parameter value comprises a second input voltage value and a second voltage-to-ground value.

20. The method according to claims 17 to 19, wherein when the first input end is the positive input end of the power sourcing equipment, an insulation resistance value at the input end of the power sourcing equipment is;
when the first input end is a negative input end of the power sourcing equipment, the insulation resistance value at the input end of the power sourcing equipment is as follows: $K = [2(V_1 - V_2) + V_{in1} - V_{in2}]/[2(I_{RCD\_1} - I_{RCD\_2})]$, wherein K is the insulation resistance value, $V_1$ is the first voltage-to-ground value, $V_2$ is the second voltage-to-ground value, $V_{in1}$ is the first input voltage value, $V_{in2}$ is the second input voltage value, $I_{RCD\_1}$ is the first residual current value, and $I_{RCD\_2}$ is the second residual current value.

21. The method according to any one of claims 17 to 19, wherein the determining an insulation resistance value at the input end of the power sourcing equipment based on the first input voltage value, the first voltage-to-ground value, the first residual current value, the second input voltage value, the second voltage-to-ground value, and the second residual current value comprises:
determining a residual current compensation value based on an initial insulation resistance value at the input end of the power sourcing equipment, the first input voltage value, the first voltage-to-ground value, and the first residual current value, and determining the insulation resistance value at the input end of the power sourcing equipment based on the residual current compensation value, the second input voltage value, the second voltage-to-ground value, and the second residual current value.

22. The method according to claim 21, wherein when the first input end is a positive input end of the power sourcing equipment, the residual current compensation value is;
when the first input end is a negative input end of the power sourcing equipment, the residual current compensation value is follows: $I_{RCD\_com} = (2V_1 + V_{n1})/(2K_0) - I_{RCD\_1}$, wherein $I_{RCD\_com}$ is the residual current compensation value, $V_1$ is the first voltage-to-ground value, $V_{in1}$ is the first input voltage value, $K_0$ is the initial insulation resistance value, and $I_{RCD\_1}$ is the first residual current value.

23. The method according to claim 21, wherein when the first input end is the positive input end of the power sourcing equipment, an insulation resistance value at the input end of the power sourcing equipment is;
when the first input end is a negative input end of the power sourcing equipment, the insulation resistance value at the input end of the power sourcing equipment is as follows: $K = (2V_2 + V_{in2})/[2(I_{ROD\_2} + I_{RCD\_com})]$, wherein K is the insulation resistance value, $V_2$ is the second voltage-to-ground value, $V_{in2}$ is the second input voltage value, $I_{RCD\_2}$ is the second residual current value, and $I_{RCD\_com}$ is the residual current compensation value.

24. The method according to claims 17 to 23, wherein the power sourcing equipment further comprises a positive direct current bus and a negative direct current bus, the direct current power supply comprises at least two direct current power supplies, and the input ends of the power sourcing equipment comprise at least two pairs of input ends, wherein

each pair of input ends of the at least two pairs of input ends are correspondingly coupled to two output ends of each of the at least two direct current power supplies;
a positive input end of each pair of input ends is coupled to the positive direct current bus, and a negative input end of each pair of input ends is coupled to the negative direct current bus; and
the input voltage of the power sourcing equipment comprises a voltage of each pair of input ends.

Direct current
power supply

Power sourcing equipment

$R_{S+}$

$R_{S-}$

$V_{IN}$

+

−

+

V

−

$V_{S+\_PE}$

V

−

+

$V_{S-\_PE}$

RCD

Voltage detection
circuit

FIG. 1

Direct
current
power
supply 11

Voltage detection unit 101

Controller 103

Residual current detection unit 102

Power sourcing equipment 10

FIG. 2

FIG. 3a

EP 4 297 212 A1

FIG. 3b

FIG. 4a

FIG. 4b

FIG. 5a

FIG. 5b

FIG. 5c

Power sourcing equipment 50

Controller 503

Voltage detection unit 502

Positive direct current bus 504

Residual current detection unit 501

RCD

Negative direct current bus 505

$V_{BUS+\_PE}$

Boost unit 506

Boost unit 1

Boost unit n

Voltage detection unit 502

$V_{S1}$

$V_{Sn}$

in1+

in1−

inn+

inn−

$V_{S1+\_PE}$

$V_{S1-\_PE}$

$V_{Sn+\_PE}$

$V_{Sn-\_PE}$

$R_{S1+}$

$R_{S1-}$

$R_{Sn+}$

$R_{Sn-}$

Direct current power supply 51

$V_{IN1}$

$V_{INn}$

FIG. 6a

FIG. 6b

FIG. 6c

FIG. 7a

FIG. 7b

**EP 4 297 212 A1**

## INTERNATIONAL SEARCH REPORT

| International application No. |
|---|
| **PCT/CN2021/083383** |

**A.   CLASSIFICATION OF SUBJECT MATTER**

H02H 3/00(2006.01)i

According to International Patent Classification (IPC) or to both national classification and IPC

**B.   FIELDS SEARCHED**

Minimum documentation searched (classification system followed by classification symbols)

H02H; H02J

Documentation searched other than minimum documentation to the extent that such documents are included in the fields searched

Electronic data base consulted during the international search (name of data base and, where practicable, search terms used)

CNABS, CNTXT, CNKI, DWPI, SIPOABS, IEEE: 绝缘, 电阻, 阻抗, 检测, 漏电流, 残余电流, 剩余电流, insulation, isolation, resistance, impedance, detect, leakage, residual, current

**C.   DOCUMENTS CONSIDERED TO BE RELEVANT**

| Category* | Citation of document, with indication, where appropriate, of the relevant passages | Relevant to claim No. |
|---|---|---|
| Y | CN 105337519 A (SUNGROW POWER SUPPLY CO., LTD.) 17 February 2016 (2016-02-17)<br>  description, paragraphs 46-54 and figures 1-9 | 1-4,9,11-13,15-19,24 |
| Y | CN 107968627 A (ZHUHAI GREE ELECTRIC APPLIANCES INC.) 27 April 2018 (2018-04-27)<br>  description, paragraphs 88-93 and figures 2-4 | 1-4,9,11-13,15-19,24 |
| A | CN 210806733 U (ZHUHAI GREE ELECTRIC APPLIANCES INC.) 19 June 2020 (2020-06-19)<br>  entire document | 1-24 |
| A | CN 109245026 A (BYD CO., LTD.) 18 January 2019 (2019-01-18)<br>  entire document | 1-24 |
| A | EP 2632010 B1 (ATREUS ENTPR LTD.) 25 February 2015 (2015-02-25)<br>  entire document | 1-24 |

☐ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **09 September 2021** | **26 September 2021** |

| Name and mailing address of the ISA/CN | Authorized officer |
|---|---|
| **China National Intellectual Property Administration (ISA/ CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

## INTERNATIONAL SEARCH REPORT
### Information on patent family members

International application No.

**PCT/CN2021/083383**

| Patent document cited in search report | | | Publication date (day/month/year) | Patent family member(s) | | | Publication date (day/month/year) |
|---|---|---|---|---|---|---|---|
| CN | 105337519 | A | 17 February 2016 | EP | 3171503 | B1 | 06 June 2018 |
| | | | | CN | 105337519 | B | 01 May 2018 |
| | | | | US | 2017141569 | A1 | 18 May 2017 |
| | | | | US | 9906022 | B2 | 27 February 2018 |
| | | | | JP | 6268617 | B2 | 31 January 2018 |
| | | | | AU | 2016204594 | B1 | 11 May 2017 |
| | | | | JP | 2017099252 | A | 01 June 2017 |
| | | | | EP | 3171503 | A1 | 24 May 2017 |
| CN | 107968627 | A | 27 April 2018 | None | | | |
| CN | 210806733 | U | 19 June 2020 | CN | 110829392 | A | 21 February 2020 |
| CN | 109245026 | A | 18 January 2019 | CN | 109245026 | B | 04 February 2020 |
| EP | 2632010 | B1 | 25 February 2015 | US | 9244110 | B2 | 26 January 2016 |
| | | | | EP | 2632010 | A1 | 28 August 2013 |
| | | | | US | 2013221975 | A1 | 29 August 2013 |

Form PCT/ISA/210 (patent family annex) (January 2015)